(19) Europäisches Patentamt
European Patent Office
Office européen des brevets

(11) EP 3 330 096 A1

(12) EUROPEAN PATENT APPLICATION
published in accordance with Art. 153(4) EPC

(43) Date of publication:
06.06.2018 Bulletin 2018/23

(21) Application number: 16830367.5

(22) Date of filing: 15.07.2016

(51) Int Cl.:
*B41N 1/14* (2006.01) *C08K 9/04* (2006.01)
*C08L 55/00* (2006.01) *G03F 7/00* (2006.01)
*G03F 7/004* (2006.01) *G03F 7/028* (2006.01)
*G03F 7/035* (2006.01) *G03F 7/32* (2006.01)

(86) International application number:
PCT/JP2016/071067

(87) International publication number:
WO 2017/018262 (02.02.2017 Gazette 2017/05)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 30.07.2015 JP 2015151209

(71) Applicant: FUJIFILM Corporation
Tokyo 106-8620 (JP)

(72) Inventors:
- INASAKI, Takeshi
Haibara-gun
Shizuoka 421-0396 (JP)
- IDEI, Hiroaki
Haibara-gun
Shizuoka 421-0396 (JP)

(74) Representative: Hoffmann Eitle
Patent- und Rechtsanwälte PartmbB
Arabellastraße 30
81925 München (DE)

# (54) PLANOGRAPHIC PRINTING PLATE ORIGINAL, PLANOGRAPHIC PRINTING PLATE MANUFACTURING METHOD, AND ORGANIC-INORGANIC HYBRID PARTICLES

(57) Provided are a planographic printing plate precursor which includes a hydrophilic support and an image recording layer containing an organic-inorganic hybrid particle (A) and an infrared-ray absorbent (B) on the hydrophilic support, in which the organic-inorganic hybrid particle (A) is an organic-inorganic hybrid particle in which an inorganic particle (a) containing a hydroxyl group and an organic component (b) are linked to each other through a linking group (c) having a urethane bond or a urea bond; a method of preparing a planographic printing plate using the planographic printing plate precursor; a planographic printing plate precursor which is capable of achieving both of printing durability and developability at high levels by using an organic-inorganic hybrid particle in which an inorganic particle (a) containing a hydroxyl group and an organic component (b) are linked to each other through a linking group (c) having a urethane bond or a urea bond, and the organic component (b) is linked to at least two inorganic particles (a) and the inorganic particle (a) is linked to at least two organic components (b) so that the organic components and the inorganic particles form a network structure; a method of preparing a planographic printing plate using the planographic printing plate precursor; and the organic-inorganic hybrid particle used for the planographic printing plate precursor and the method of preparing a planographic printing plate.



Printed by Jouve, 75001 PARIS (FR)

## Description

## BACKGROUND OF THE INVENTION

1. Field of the Invention

The present invention relates to a planographic printing plate precursor which is capable of so-called direct plate-making using various lasers from digital signals of a computer and the like; a method of preparing a planographic printing plate using the planographic printing plate precursor; and an organic-inorganic hybrid particle used for the planographic printing plate precursor and the method of preparing a planographic printing plate.

2. Description of the Related Art

As a solid-state laser, a semiconductor laser, and a gas laser which emit ultraviolet light, visible light, and infrared light respectively having a wavelength of 300 nm to 1200 nm, small-sized and high-output lasers can be easily obtained and are extremely useful as recording light sources during direct plate-making from digital data of a computer and the like. Various researches on recording materials sensitive to various laser beams have been conducted. Particularly in a case where a material that is capable of performing recording using an infrared laser having a photosensitive wavelength of 760 nm or greater is used, there is an advantage that handleability in a light room becomes excellent. For example, a radical polymerization type negative recording material described in JP2010-102322A is exemplified as such a material.

In a planographic printing plate precursor of the related art (hereinafter, also referred to as a PS plate), a step of dissolving and removing a non-image area (development treatment) after exposure is indispensable. Consequently, a post-treatment step of washing a printing plate which has been subjected to a development treatment with water, treating the plate with a rinse liquid containing a surfactant, or treating the plate with a desensitizing liquid containing gum arabic or a starch derivative has also been required. The fact that these additional wet treatments are indispensable has become a major problem of a conventional PS plate which has to be examined. In a wet treatment in which the second half (development treatment) of the plate-making step is complicated even in a case where the first half (image forming treatment) thereof is simplified by the above-described digital treatment, effects of the simplification are insufficient.

Particularly in recent years, consideration of the global environment has become a major issue in the entire industry. From the consideration of the environment, a treatment using a developer having a pH value close to a neutral range or reducing the amount of waste liquid is considered as a task. Further, it is desired that a wet post-treatment is simplified or changed to a dry treatment.

From this viewpoint, as a method of eliminating a treatment step, a so-called on-press development method of mounting a printing plate precursor after exposure on a cylinder of a printing press and supplying dampening water and ink while rotating the cylinder to remove a non-image area of the printing plate precursor is exemplified. In other words, this method is a system in which the printing plate precursor is exposed and mounted on the printing press as it is, and the development treatment is completed during a typical printing process.

In order to satisfy the requirements of the on-press development, a planographic printing plate precursor in which an image recording layer obtained by dispersing thermoplastic hydrophobic polymer fine particles in a hydrophilic binder polymer is provided on a hydrophilic support has been proposed. During this plate-making, the on-press development can be performed by combining (fusion welding) thermoplastic hydrophobic polymer fine particles using heat generated by photothermal conversion after exposure to an infrared laser, to form an image, then attaching a plate onto a cylinder of a printing press, and supplying at least one of dampening water or ink. This planographic printing plate precursor also has handleability in a light room because the photosensitive region is an infrared region.

However, an image formed by combining (fusion welding) thermoplastic hydrophobic polymer fine particles has a problem of insufficient strength and printing durability as a printing plate.

Further, a planographic printing plate precursor which includes microcapsules respectively containing a polymerizable compound, in place of thermoplastic fine particles, has been proposed (for example, see JP2012-206495A). A plate precursor according to such a proposal has an advantage that a polymer image formed by a reaction of a polymerizable compound has excellent strength than that of an image formed by fusion welding of fine particles.

In addition, since a polymerizable compound has high reactivity, a method of isolating a polymerizable compound using a microcapsule has been frequently proposed. Further, it has been proposed to use a thermally decomposable polymer for a shell of a microcapsule.

## SUMMARY OF THE INVENTION

However, particularly in an image cured by a material which is capable of performing recording using an infrared laser with a photosensitive wavelength of 750 nm or greater, further improvement of printing durability has been required.

Typically, according to a method of improving printing durability by improving the strength of an image recording layer, it is difficult to achieve both of printing durability and developability because the developability tends to be degraded. Particularly, since the developability tends to be degraded in a case of on-press development compared to a system of performing development using an alkali developer, it is extremely difficult to satisfy printing durability and developability at high levels.

The present invention has been made in consideration of the above-described circumstances, and an object thereof is to provide a planographic printing plate precursor which is capable of achieving printing durability and developability at high levels; a method of preparing a planographic printing plate using the planographic printing plate precursor; and an organic-inorganic hybrid particle used for the planographic printing plate precursor and the method of preparing a planographic printing plate.

The present invention has the following configuration and the above-described problems are solved by the following configuration of the present invention.

[1] A planographic printing plate precursor comprising: a hydrophilic support; and an image recording layer which contains an organic-inorganic hybrid particle (A) and an infrared-ray absorbent (B) on the hydrophilic support, in which the organic-inorganic hybrid particle (A) is an organic-inorganic hybrid particle in which an inorganic particle (a) containing a hydroxyl group and an organic component (b) are linked to each other through a linking group (c) having a urethane bond or a urea bond.

[2] The planographic printing plate precursor according to [1], in which the organic-inorganic hybrid particle (A) is a particle in which the organic component (b) is linked to only one of the inorganic particle (a).

[3] The planographic printing plate precursor according to [1], in which the organic-inorganic hybrid particle (A) is a particle in which the organic component (b) is linked to at least two of the inorganic particles (a) and the inorganic particle (a) is linked to at least two of the organic components (b) so that the organic components (b) and the inorganic particles form a network structure.

[4] The planographic printing plate precursor according to [3], in which the organic component (b) is a reaction product between polyfunctional isocyanate (d) and a compound having an active hydrogen atom (e).

[5] The planographic printing plate precursor according to [4], in which the polyfunctional isocyanate (d) is formed from an adduct of polyfunctional isocyanate and a compound having at least two active hydrogen atoms.

[6] The planographic printing plate precursor according to any one of [1] to [5], in which the organic component (b) has a repeating unit represented by Formula (1).

$$(1) \quad \left( X-R_1 \right)_{n_1}$$

In Formula (1), X represents an oxygen atom, a sulfur atom, -CO-, or -COO-, $R_1$ represents alkylene having 2 to 10 carbon atoms, and $n_1$ represents an integer of 1 to 90.

[7] The planographic printing plate precursor according to any one of [1] to [6], in which the organic-inorganic hybrid particle (A) contains a radical polymerizable group.

[8] The planographic printing plate precursor according to any one of [1] to [7], in which the inorganic particle (a) is at least one particle selected from the group consisting of silica, alumina, titania, zirconia, magnesium oxide, zinc oxide, talc, clay, wollastonite, xonotlite, aluminum hydroxide, and magnesium hydroxide.

[9] The planographic printing plate precursor according to any one of [1] to [8], in which a particle diameter of the inorganic particle (a) is in a range of 0.005 to 5 μm.

[10] The planographic printing plate precursor according to any one of [1] to [9], in which a particle diameter of the organic-inorganic hybrid particle (A) is in a range of 0.01 to 20 μm.

[11] The planographic printing plate precursor according to any one of [1] to [10], in which the image recording layer further contains a radical polymerizable compound (C) and a radical polymerization initiator (D).

[12] The planographic printing plate precursor according to any one of [1] to [11], in which an unexposed portion in the image recording layer is removed by a developer having a pH of 2 to 12 after exposure.

[13] The planographic printing plate precursor according to any one of [1] to [11], in which an unexposed portion in

the image recording layer is removed by at least one of printing ink or dampening water on a printing press after exposure.

[14] A method of preparing a planographic printing plate, comprising: exposing the planographic printing plate precursor according to any one of [1] to [12]; and removing an unexposed portion using a developer having a pH of 2 to 12.

[15] A method of preparing a planographic printing plate, comprising: exposing the planographic printing plate precursor according to any one of [1] to [11] and [13]; and removing an unexposed portion using at least one of printing ink or dampening water on a printing press.

[16] An organic-inorganic hybrid particle comprising: an inorganic particle (a) containing a hydroxyl group and an organic component (b) which are linked to each other through a linking group (c) having a urethane bond or a urea bond, in which the organic component (b) is linked to at least two of the inorganic particles (a) and the inorganic particle (a) is linked to at least two of the organic components (b) so that the organic components and the inorganic particles form a network structure.

[17] The organic-inorganic hybrid particle according to [16], in which the organic component (b) is a reaction product between polyfunctional isocyanate (d) and a compound having an active hydrogen atom (e).

[18] The organic-inorganic hybrid particle according to [16] or [17], in which the organic component has a repeating unit represented by Formula (1).

$$(1)\quad \left( X-R_1 \right)_{n_1}$$

In Formula (1), X represents an oxygen atom, a sulfur atom, -CO-, or -COO-, $R_1$ represents alkylene having 2 to 10 carbon atoms, and $n_1$ represents an integer of 1 to 90.

[19] The organic-inorganic hybrid particle according to any one of [16] to [18], further comprising: a radical polymerizable group.

[20] The organic-inorganic hybrid particle according to any one of [16] to [19], in which a particle diameter of the organic-inorganic hybrid particle is in a range of 0.01 to 20 $\mu$m.

According to the present invention, it is possible to provide a planographic printing plate precursor which is capable of achieving both of printing durability and developability at high levels; a method of preparing a planographic printing plate using the planographic printing plate precursor; and an organic-inorganic hybrid particle used for the planographic printing plate precursor and the method of preparing a planographic printing plate.

## DESCRIPTION OF THE PREFERRED EMBODIMENTS

Hereinafter, the contents of the present invention will be described in detail. The description of constituent elements below is made based on representative embodiments of the present invention in some cases, but the present invention is not limited to such embodiments. Further, in the present specification, the numerical ranges shown using "to" indicate ranges including the numerical values described before and after "to" as the lower limit values and the upper limit values.

In the present specification, in a case where substitution or unsubstitution is not noted in regard to the notation of a group in a compound represented by a general formula, and the group may further include a substituent, the group includes not only an unsubstituted group but also a substituent unless otherwise specified. For example, in a general formula, the description "R represents an alkyl group, an aryl group, or a heterocyclic group" means "R represents an unsubstituted alkyl group, a substituted alkyl group, an unsubstituted aryl group, a substituted aryl group, an unsubstituted heterocyclic group, or a substituted heterocyclic group". In the present specification, for example, the concept of (meth)acrylic acid ester includes both of methacrylic acid ester and acrylic acid ester.

Moreover, the "particle diameter" indicates an average particle diameter of primary particles unless otherwise noted. In the present invention, the particle diameter of particles can be measured according to a light scattering method.

[Planographic printing plate precursor]

A planographic printing plate precursor of the present invention includes a hydrophilic support; and an image recording layer which contains an organic-inorganic hybrid particle (A) and an infrared-ray absorbent (B), in which the organic-inorganic hybrid particle (A) is an organic-inorganic hybrid particle in which an inorganic particle (a) containing

a hydroxyl group and an organic component (b) are linked to each other through a linking group (c) having a urethane bond or a urea bond.

The planographic printing plate precursor of the present invention may be provided with an undercoat layer between the support and the image recording layer or a protective layer on the image recording layer as necessary.

[Organic-inorganic hybrid particle (A)]

As described above, the organic-inorganic hybrid particle contained in the image recording layer is an organic-inorganic hybrid particle in which an inorganic particle (a) containing a hydroxyl group and an organic component (b) are linked to each other through a linking group (c) having a urethane bond or a urea bond.

In the organic-inorganic hybrid particle, the linking group having a urethane bond or a urea bond is typically linked to an inorganic particle in the form of being replaced with a hydrogen atom in a hydroxyl group included in the inorganic particle.

According to the planographic printing plate precursor which includes an image recording layer containing the organic-inorganic hybrid particle, both of printing durability and developability can be achieved at high levels.

The action mechanism of obtaining such excellent properties is not necessarily clear, but is considered as follows.

That is, first, it is considered that the printing durability of an image area is improved since the hardness of inorganic particles in organic-inorganic hybrid particles is high. Further, it is considered that excellent printing durability can be obtained by the inorganic particle being linked to the organic component through a linking group having a urethane bond or a urea bond having a high strength. In addition, inorganic particles are fixed in organic-inorganic hybrid particles so that aggregation of the inorganic particles is unlikely to occur. It is considered that sufficient printing durability can be exhibited without adding a large amount of inorganic particles which are likely to cause degradation of developability because the inorganic particles tend to be uniformly present due to an image area. In other words, it is considered that the printing durability and the developability can be achieved at high levels.

It is preferable that the inorganic particles (a) containing a hydroxyl group are at least one particle selected from the group consisting of silica, alumina, titania, zirconia, magnesium oxide, zinc oxide, talc, clay, wollastonite, xonotlite, aluminum hydroxide, and magnesium hydroxide. Among these, silica or zirconia is preferable and silica is more preferable.

The particle diameter of the inorganic particles is preferably in a range of 0.005 to 5 μm, more preferably in a range of 0.01 to 2 μm, and still more preferably in a range of 0.01 to 1 μm.

Examples of the organic component (b) include a non-aromatic hydrocarbon (linear, branched, or cyclic), an aromatic hydrocarbon, an aromatic heterocycle, a non-aromatic heterocycle, and a component corresponding to a combination of at least two of these.

The non-aromatic hydrocarbon (linear, branched, or cyclic), the aromatic hydrocarbon, the aromatic heterocycle, and the non-aromatic heterocycle may include a substituent. Here, the expression "include a substituent" means that an arbitrary atom (typically a hydrogen atom or a carbon atom) constituting an organic component is substituted with a substituent. Examples of the substituent include a halogen atom, an alkyl group (the alkyl group may be linear or branched and the number of carbon atoms is preferably in a range of 1 to 12), a cycloalkyl group (any of a monocycle, a polycycle, and a spiro ring may be used and the number of carbon atoms is preferably in a range of 3 to 20), an aryl group (the number of carbon atoms is preferably in a range of 6 to 14), a hydroxy group, a cyano group, an alkoxy group, an ester bond, an amide bond, a urethane bond, a urea bond, a ureide group, an ether bond, a thioether bond, a sulfoneamide bond, a sulfonic acid ester bond, and a group formed by combining two or more selected from bonds and groups of these.

(Method of preparing organic-inorganic hybrid particles (A))

Examples of the method of preparing organic-inorganic hybrid particles include a method of reacting a compound in which a reactive group which can react with a hydroxyl group included in an inorganic particle and an organic component are bonded through a linking group having a urethane bond or a urea bond with the inorganic particle containing a hydroxyl group; and a method of reacting a compound containing an organic component and an isocyanate group with an inorganic particle containing a hydroxyl group.

Examples of the reactive group which can react with a hydroxyl group included in the inorganic particle include an alkyloxysilyl group, a chlorosilyl group, a bromosilyl group, an iodosilyl group, and a group formed by substituting a hydrogen atom in an acid group with a chlorine atom.

According to a preferred embodiment, the organic-inorganic hybrid particle is a particle in which an organic component is linked to only one inorganic particle.

The organic-inorganic hybrid particle in this form can be prepared based on the following reaction schemes (A-1) and (A-2). Further, n in the reaction scheme represents a repetition number of an alkyleneoxy structure.

(A-1)

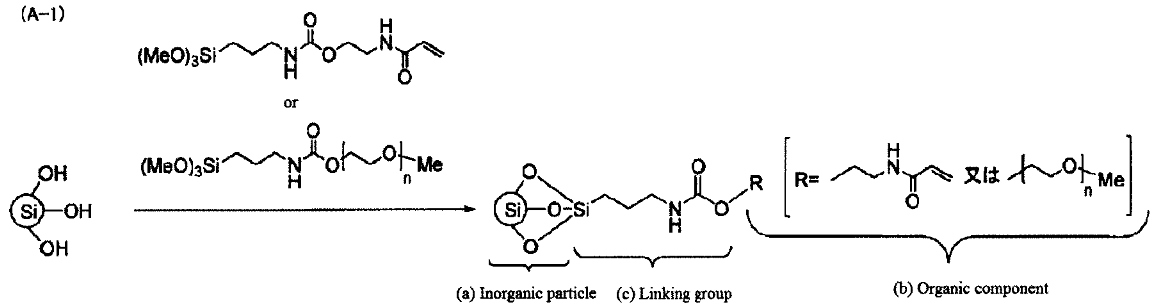


(A-2)

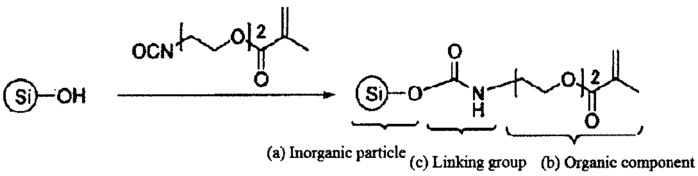


In addition, the organic-inorganic hybrid particle may be in the form of a microgel suitably obtained based on a known interfacial polymerization reaction. That is, the microgel in the present invention is a fine particle to which an inorganic particle is fixed through a linking group having a urethane bond or a urea bond in a microgel.

In this form, first, it is preferable to prepare a material for preparing a microgel in which an inorganic particle having a hydroxyl group and an organic component are bonded to each other through a linking group having a urethane bond or a urea bond by reacting a compound which contains a reactive group that can react with a hydroxyl group included in an inorganic particle and an amino group with the inorganic particle containing a hydroxyl group and further reacting polyfunctional isocyanate with the reactant. Thereafter, an organic-inorganic hybrid particle can be suitably obtained as the form of a microgel by using a material for preparing a microgel.

Here, it is preferable that the material for preparing a microgel contains a reactive group for forming a microgel in the organic component, and an isocyanate group may be suitably exemplified as such a reactive group.

In the interfacial polymerization reaction, a surfactant may be used by being added to an oil phase or a water phase, but it is easier for a surfactant to be added to a water phase because the solubility in an organic solvent is low. The amount of surfactant to be added is in a range of 0.1% to 5% by mass and particularly preferably in a range of 0.5% to 2% by mass with respect to the mass of the oil phase. As the surfactant typically used for emulsification dispersion, a surfactant containing a hydrophobic group with a relatively long chain is considered to be excellent, and surfactants described in "Surfactant Handbook" (Ichiro Nishi et al., published by Sangyo Tosho Publishing Co., Ltd. (1980)) and alkali metal salts such as alkylsulfonic acid and alkylbenzenesulfonic acid can be used.

In the present invention, a compound such as a formalin condensate of an aromatic sulfonate or a formalin condensate of an aromatic carboxylate can be used as a surfactant (emulsification assistant). Specifically, a compound represented by the following formula is exemplified. The details of this compound are described in JP1994-297856A (JP-H06-297856A).

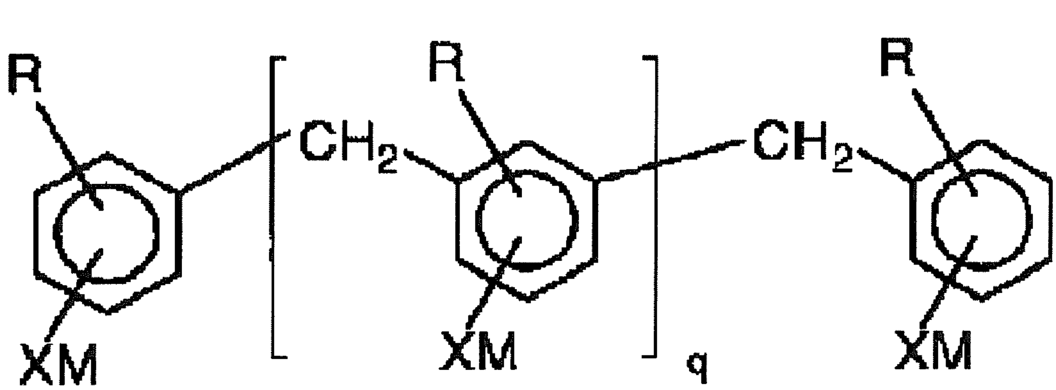

In the formula, R represents an alkyl group having 1 to 4 carbon atoms, X represents $SO_3^-$ or $COO^-$, M represents $Na^+$ or $K^+$, and q represents an integer of 1 to 20.

Further, an alkyl glucoside-based compound can be used as a surfactant. Specifically, a compound represented

by the following formula is exemplified.

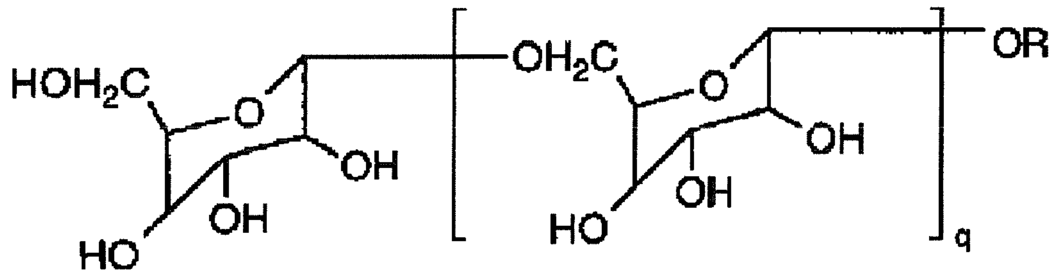

In the formula, R represents an alkyl group having 4 to 18 carbon atoms, and q represents an integer of 0 to 2.

The surfactant may be used alone or in combination of two or more kinds thereof.

For example, the organic-inorganic hybrid particle in the form of a microgel can be prepared based on the following reaction scheme (A-3). Further, n in the following reaction scheme means that n number of structures in parentheses are bonded to a silica particle.

(A-3)

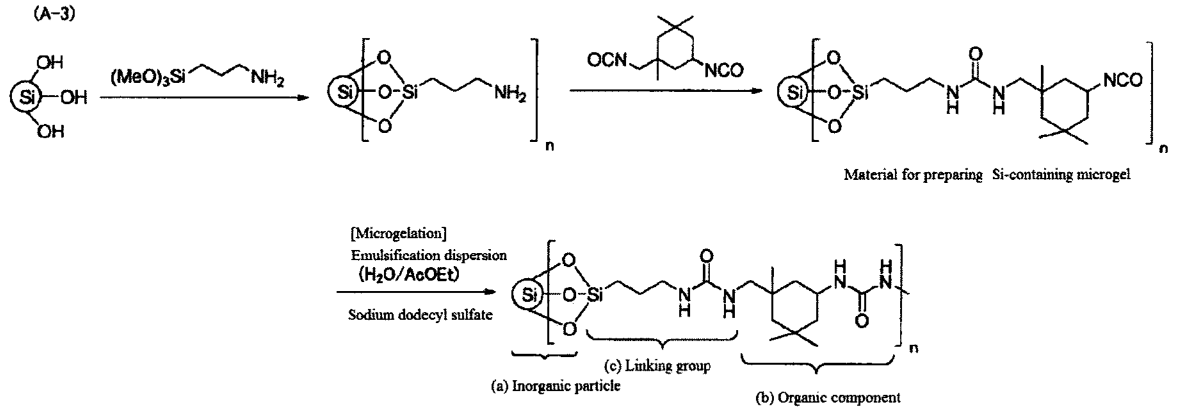


According to a preferred embodiment, it is preferable that the organic-inorganic hybrid particle is a particle in which the organic component is linked to at least two inorganic particles and the inorganic particle is linked to at least two organic components so that the organic components and the inorganic particles form a network structure. With this configuration, the printing durability can be further improved without deteriorating the developability. In order to prepare such an organic-inorganic hybrid particle, it is preferable that the organic component is a reaction product between polyfunctional isocyanate and a compound having active hydrogen atoms. Further, it is preferable that the polyfunctional isocyanate is formed from an adduct of polyfunctional isocyanate and a compound having at least two active hydrogen atoms. Even in this form, the organic-inorganic hybrid particle is in the form of a microgel and can be prepared in conformity with a known method of forming a microcapsule of the related art.

The method of forming a microcapsule is described in detail in "Microcapsules" (Asaji Kondo, NIKKAN KOGYO SHIMBUN, LTD. (1970)) and "Microcapsules" (Tamotsu Kondo et al., SANKYO SHUPPAN Co., Ltd. (1977)).

In the present invention, first, a material for preparing a microgel containing inorganic particles is prepared by reacting a compound, in which a reactive group that can react with a hydroxyl group included in an inorganic particle and an organic component are bonded to each other through a linking group having a urethane bond or a urea bond, with the inorganic particle. Here, it is preferable that the material for preparing a microgel contains a reactive group for forming a microgel in the organic component, and an isocyanate group may be suitably exemplified as such a reactive group.

Next, a microgel can be formed by adding the material for preparing a microgel, which contains inorganic particles, and a polyfunctional isocyanate compound to an organic solvent, emulsifying the organic phase solution in a water-soluble polymer aqueous solution, adding a catalyst that promotes a polymerization reaction to a water phase or increasing the temperature of an emulsified liquid to polymerize the polyfunctional isocyanate compound with the compound (water or the like) having active hydrogen atoms. Further, a microgel (microcapsule) including a constituent component of an image recording layer can be obtained by adding the constituent component of the image recording layer to the organic phase solution. As the constituent component of the image recording layer which is included in a microgel, a radical polymerizable compound is particularly preferable.

Examples of the polyfunctional isocyanate compound (compound containing two or more isocyanate groups in a molecule) include known compounds, for example, diisocyanate such as xylene diisocyanate and a hydrogenated product thereof, hexamethylene diisocyanate, tolylene diisocyanate and a hydrogenated product thereof, and isophorone diisocyanate. Further, a trimer of these (burette or isocyanurate), a polyfunctionalized compound as an adduct with a polyol such as trimethylolpropane or the like, and a formalin condensate of benzene isocyanate, which have the above-described compounds as main raw materials, can also be used. Among these, xylene diisocyanate, tolylene diisocyanate, and isophorone diisocyanate are particularly preferable. These compounds are described in "Polyurethane Resin Handbook" (edited by Keiji Iwata, published by NIKKAN KOGYO SHIMBUN, LTD. (1987)).

During microgelation, water is typically used as the compound having active hydrogen atoms that react with a polyfunctional isocyanate compound for forming a wall of a microgel. Further, a polyol can be used as the compound having active hydrogen atoms. A polyol is used by being added to an oil phase serving as a core or a water phase containing a water-soluble polymer serving as a dispersion medium. Specific examples thereof include propylene glycol, glycerin, and trimethylolpropane. In addition, an amine compound such as diethylenetriamine or tetraethylenepentamine may be used in place of or in combination with a polyol. These compounds are also described in "Polyurethane Resin Handbook" described above.

Examples of the water-soluble polymer for dispersing an oil phase of a microgel in a water phase include polyvinyl alcohol and a modified product thereof, polyacrylic acid amide and a derivative thereof, an ethylene-vinyl acetate copolymer, a styrene-maleic anhydride copolymer, an ethylene-maleic anhydride copolymer, an isobutylene-maleic anhydride copolymer, polyvinylpyrrolidone, an ethylene-acrylic acid copolymer, a vinyl acetate-acrylic acid copolymer, carboxymethyl cellulose, methyl cellulose, casein, gelatin, a starch derivative, gum arabic, and sodium alginate. A water-soluble polymer which does not react with an isocyanate compound or is extremely difficult to react with an isocyanate compound is preferable. For example, it is necessary to eliminate reactivity in advance from a polymer containing a reactive amino group in a molecular chain such as gelatin.

In the microgelation, examples of the surfactant to be used and the amount of the surfactant to be added are the same as those described above.

For example, the organic-inorganic hybrid particle which is in the form of a microgel and in which the organic component is linked to at least two inorganic particles and the inorganic particle is linked to at least two organic components so that the organic components and the inorganic particles form a network structure can be prepared based on the following reaction schemes (A-4) to (A-7). Further, n in the following reaction scheme means that n number of structures in parentheses are bonded to a silica particle, m represents a repetition number of the structure shown in parentheses, and the symbol "*" represents a bond with respect to an organic component to be bonded to another "*".

(A-4)

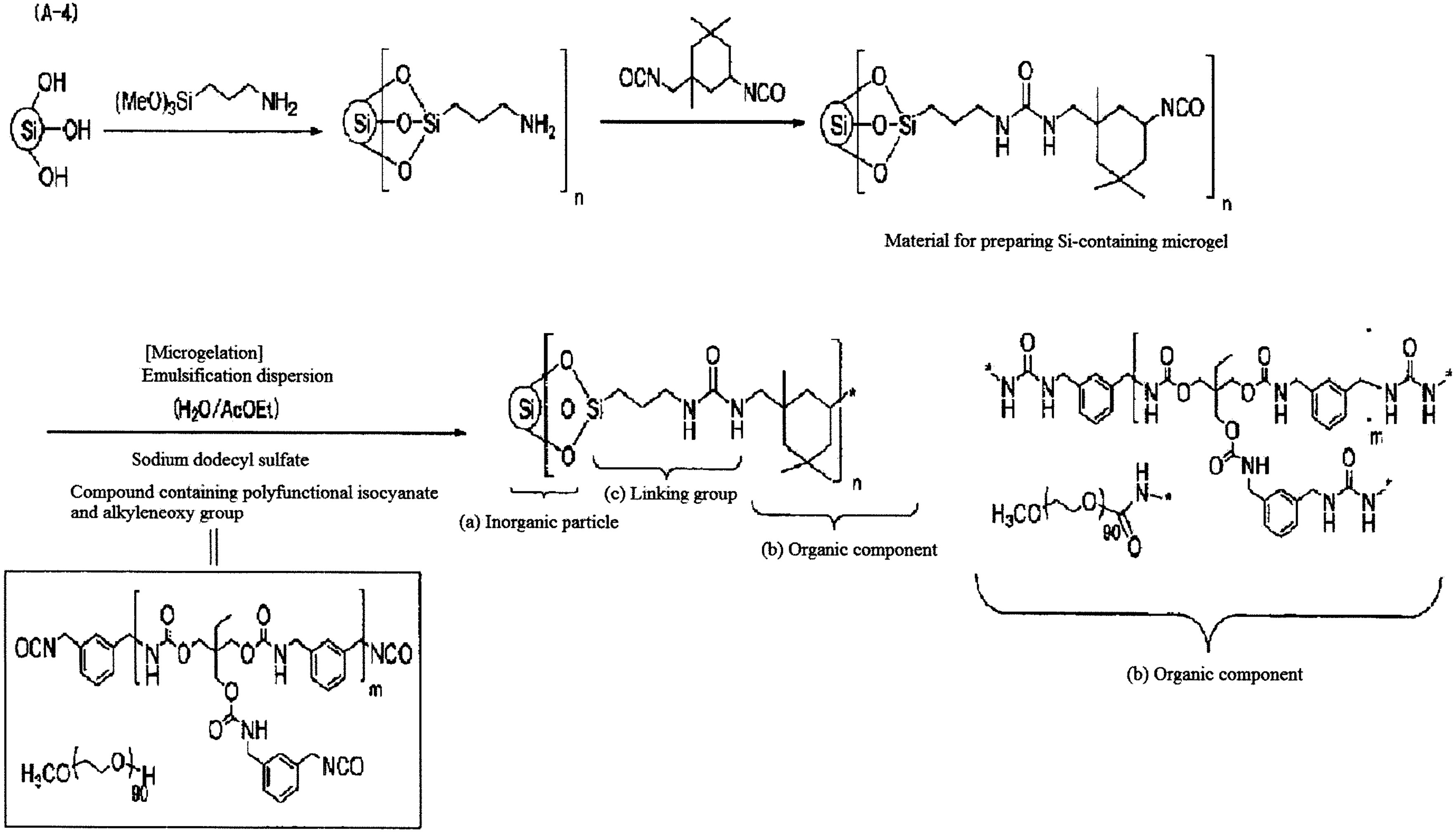
Material for preparing Si-containing microgel
[Microgelation]
Emulsification dispersion
(H2O/AcOEt)
Sodium dodecyl sulfate
Compound containing polyfunctional isocyanate and alkyleneoxy group
(a) Inorganic particle
(c) Linking group
(b) Organic component
(b) Organic component

(A-5)

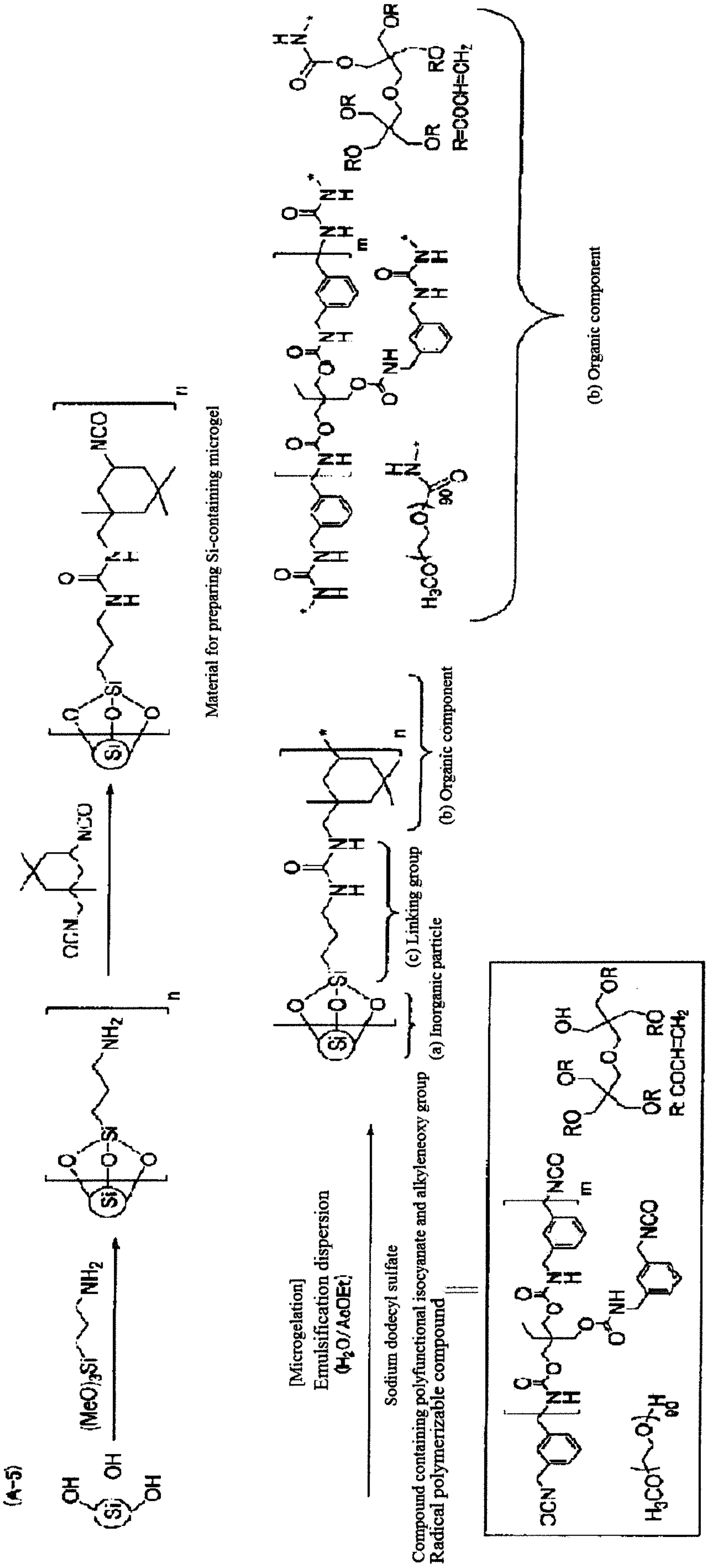

Material for preparing Si-containing microgel
[Microgelation]
Emulsification dispersion
($H_2O$/AcOEt)
Sodium dodecyl sulfate
Compound containing polyfunctional isocyanate and alkyleneoxy group
Radical polymerizable compound
(a) Inorganic particle
(c) Linking group
(b) Organic component
(b) Organic component

(A-6)

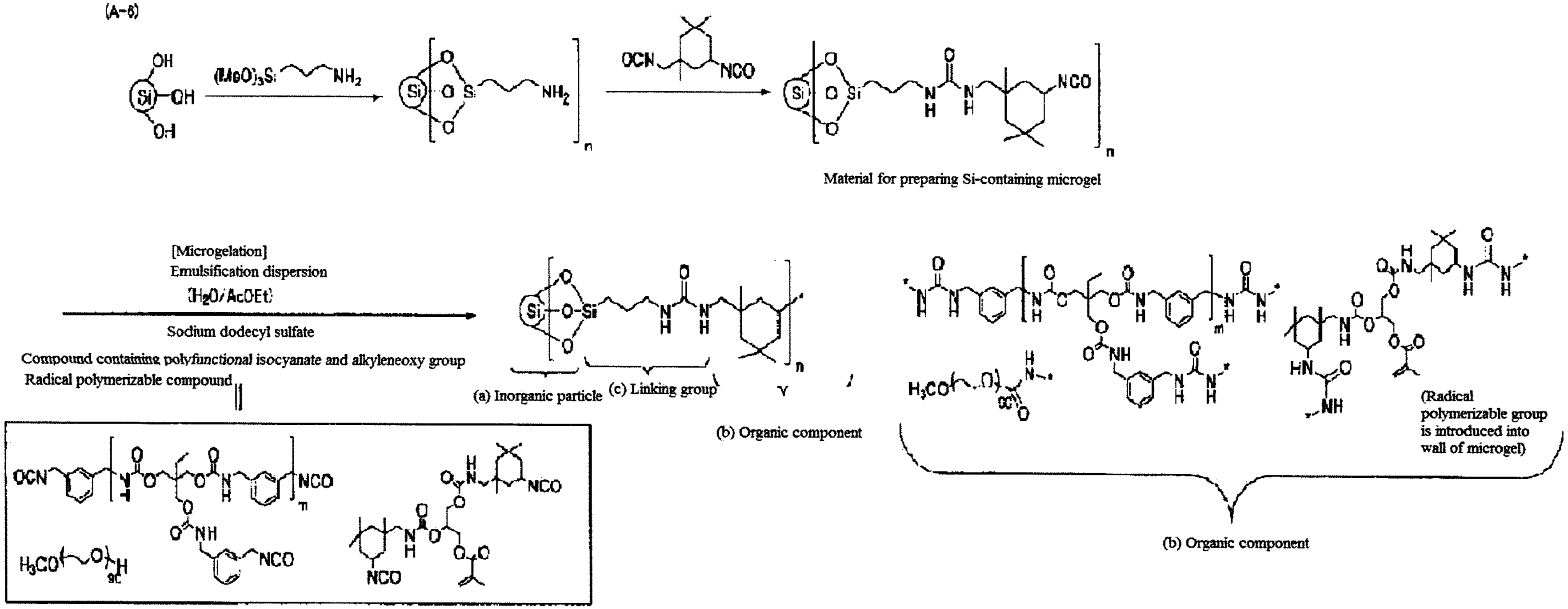
Material for preparing Si-containing microgel
[Microgelation]
Emulsification dispersion
(H2O/AcOEt)
Sodium dodecyl sulfate
Compound containing polyfunctional isocyanate and alkyleneoxy group
Radical polymerizable compound
(a) Inorganic particle
(c) Linking group
(b) Organic component
(Radical polymerizable group is introduced into wall of microgel)
(b) Organic component

(A-7)

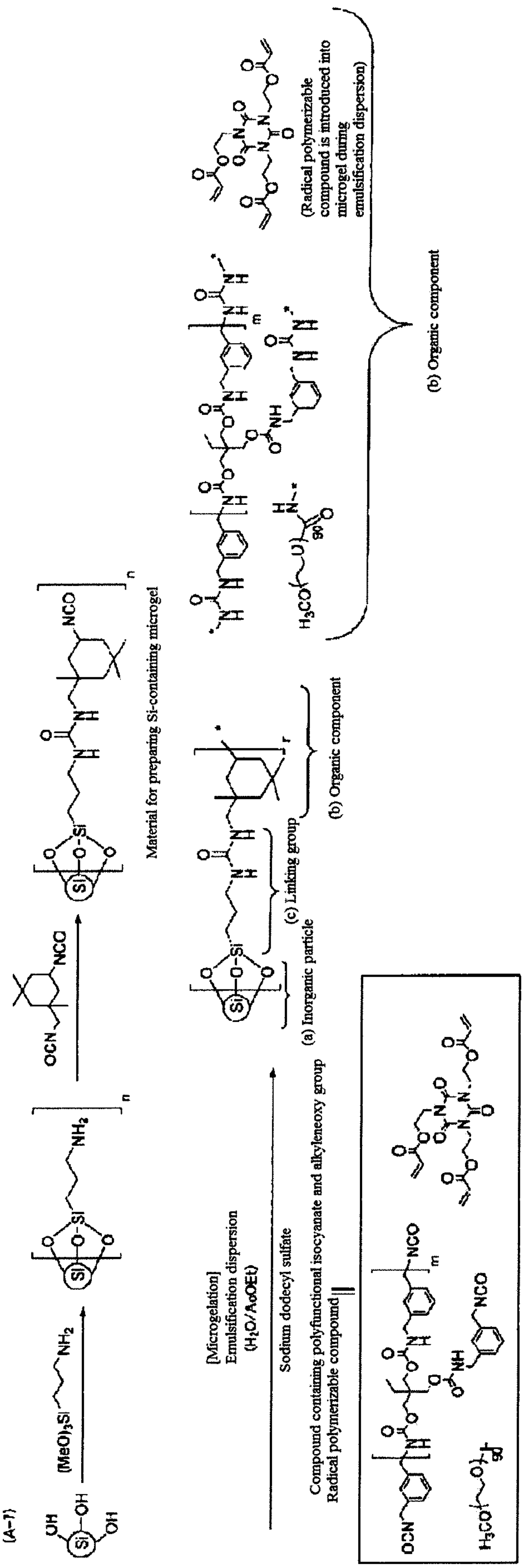
Material for preparing Si-containing microgel
[Microgelation]
Emulsification dispersion
($H_2O$/AcOEt)
Sodium dodecyl sulfate
Compound containing polyfunctional isocyanate and alkyleneoxy group
Radical polymerizable compound
(a) Inorganic particle
(c) Linking group
(b) Organic component
(b) Organic component
(Radical polymerizable compound is introduced into microgel during emulsification dispersion)

In the organic-inorganic hybrid particle, it is preferable that the organic component has a repeating unit represented by Formula (1).

$$(1)\quad \left(X-R_1\right)_{n_1}$$

In Formula (1), X represents an oxygen atom, a sulfur atom, -CO-, or -COO-. $R_1$ represents alkylene having 2 to 10 carbon atoms. $n_1$ represents an integer of 1 to 90.

In a case where the organic component has a repeating unit represented by Formula (1) in the organic-inorganic hybrid particle, the particle strength is degraded due to a decrease in glass transition temperature of the organic-inorganic hybrid particle and the affinity for ink is improved at the same time. In this manner, on-press developability is improved and the on-press developability becomes easy to proceed even in an extremely low exposure region of a non-image area. In addition, the polymerization efficiency of a radical polymerizable compound is improved due to a decrease in glass transition temperature of a non-image area so that the image strength is improved and excellent printing durability can easily be achieved.

Examples of the method of introducing a repeating unit represented by Formula (1) into the organic component of the organic-inorganic hybrid particle include a method of employing a compound which has a repeating unit represented by Formula (1) in an organic component from among examples of the "compound in which a reactive group that can react with a hydroxyl group included in an inorganic particle and an organic component are bonded to each other through a linking group having a urethane bond or a urea bond" and the "compound which contains an organic component and an isocyanate group"; a method of employing a material having a repeating unit represented by Formula (1) in an organic component from among examples of the material for preparing a microgel; and a method of allowing the compound which contains a group that can react with the "reactive group for forming a microgel" included in the material for preparing a microgel and a repeating unit represented by Formula (1) to coexist with the material for preparing a microgel during preparation of a microgel.

The above-described reaction schemes (A-1), (A-2), and (A-4) to (A-7) are examples in which the organic component in the organic-inorganic hybrid particle has a repeating unit represented by Formula (1).

Further, from the viewpoints of image forming sensitivity and printing durability, it is preferable that the organic-inorganic hybrid particle contains a radical polymerizable group.

Examples of the form in which the organic-inorganic hybrid particle contains a radical polymerizable group include a form in which a radical polymerizable group is bonded to the organic component in the organic-inorganic hybrid particle as in the reaction schemes (A-1), (A-2), (A-5), and (A-6) described above and a form in which a radical polymerizable compound is introduced into a microgel as a microcapsule as in the reaction scheme (A-7) described above.

Examples of the radical polymerizable group include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$, and $-(CH_2CH_2O)_2-X$ (in the formula, $R^1$ to $R^3$ each independently represent a hydrogen atom, a halogen atom, or an alkyl group having 1 to 20 carbon atoms, an aryl group, an alkoxy group, or an aryloxy group, $R^1$ and $R^2$ or $R^3$ may be bonded to each other to form a ring, n represents an integer of 1 to 10, and X represents a dicyclopentadienyl residue), but the examples are not limited to these.

Examples of the method of introducing a radical polymerizable group into the organic-inorganic hybrid particle include a method of employing a compound which has a radical polymerizable group in an organic component from among examples of the "compound in which a reactive group that can react with a hydroxyl group included in an inorganic particle and an organic component are bonded to each other through a linking group having a urethane bond or a urea bond" and the "compound which contains an organic component and an isocyanate group"; a method of employing a material having a radical polymerizable group in an organic component from among examples of the material for preparing a microgel; and a method of allowing a radical polymerizable compound (i) which includes a group (for example, a nucleophilic group of a hydroxyl group or the like) that can react with a "reactive group for forming a microgel" included in the material for preparing a microgel or a reactive group (for example, an isocyanate group) that shows a reaction during formation of a microgel and a radical polymerizable group or a radical polymerizable compound (ii) which includes a radical polymerizable group and is different from the radical polymerizable compound (i) to coexist with the material for preparing a microgel during preparation of a microgel.

In the method of allowing the radical polymerizable compound to coexist with the material for preparing a microgel during preparation of a microgel, the form in which the radical polymerizable group is bonded to the organic component in the organic-inorganic hybrid particle as in the reaction schemes (A-5) and (A-6) described above can be

suitably prepared by using the radical polymerizable compound (i) as a polymerizable compound. In addition, the form in which the radical polymerizable compound is introduced into a microgel serving as a microcapsule as in the reaction scheme (A-7) can be suitably prepared by using the radical polymerizable compound (ii).

As the compound which is the radical polymerizable compound (i) and contains a group that can react with the "reactive group for forming a microgel" contained in the material for preparing a microgel, a compound represented by Formula (b) can be suitably exemplified.

$$L^1Lc_mZ_n \qquad (b)$$

In Formula (b), $L^1$ represents a (m + n) valent linking group, m and n each independently represent an integer of 1 to 100, Lc represents a monovalent ethylenic unsaturated group, and Z represents a nucleophilic group.

It is preferable that $L^1$ represents a di- or higher valent aliphatic group, a di- or higher valent aromatic group, a di- or higher valent heterocyclic group, -O-, -S-, -NH-, -N<, -CO--SO-, $-SO_2-$, or a combination of these.

m and n each independently represent preferably an integer of 1 to 50, more preferably an integer of 1 to 20, still more preferably an integer of 1 to 10, and most preferably an integer of 1 to 5. Among these, it is particularly preferable that m represents an integer of 1 to 3 and n represents 1.

Examples of the monovalent ethylenic unsaturated group as Lc include an allyl group, a vinyl group, an acryloyl group, and a methacryloyl group.

Z represents preferably OH, SH, or $NH_2$, more preferably OH or $NH_2$, and most preferably OH.

Hereinafter, examples of the compound represented by Formula (b) will be described, but the examples are not limited to this structure.

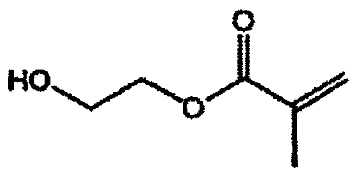

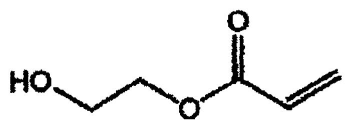

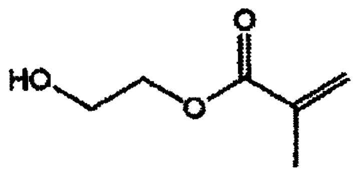

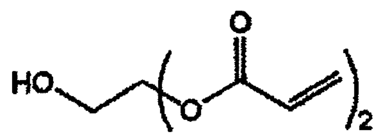

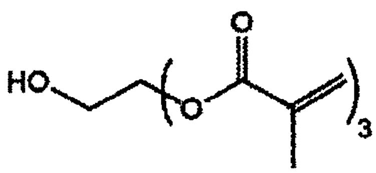

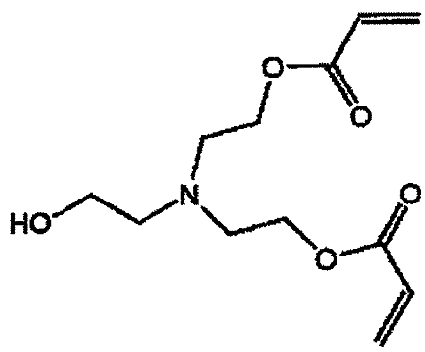

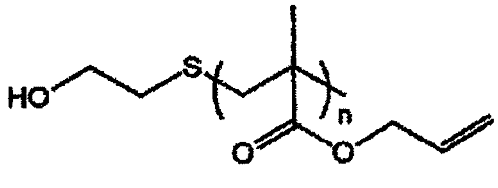

(n=10～50)

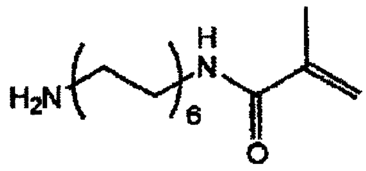

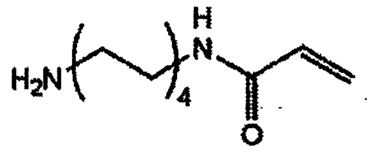

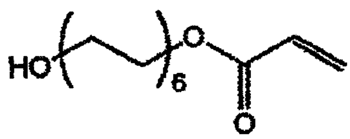

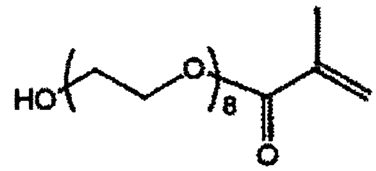

In the method of allowing a radical polymerizable compound to coexist with the material for preparing a microgel during preparation of a microgel, the radical polymerizable compound may be used alone or in combination of two or more kinds thereof.

Further, in the preparation of the organic-inorganic hybrid particle in the form of a microgel, an adduct formed by adding a radical polymerizable compound to polyfunctional isocyanate can be formed by allowing the radical polymerizable compound (i) to coexist with a compound having active hydrogen atoms as necessary. Particularly, in a case where the radical polymerizable compound (i) contains a reactive group (for example, an isocyanate group) that shows a reaction during formation of a microgel, the radical polymerizable compound (i) may be further added to the adduct formed by adding a compound having active hydrogen atoms to polyfunctional isocyanate (the adduct may be modified).

Further, the adduct formed by adding the radical polymerizable compound (i) to polyfunctional isocyanate and the adduct formed by adding a compound having active hydrogen atoms to polyfunctional isocyanate may be used in combination.

[Organic-inorganic hybrid particle having hydrophilic polymer in side chain]

From the viewpoint of developability, an organic-inorganic hybrid particle having a hydrophilic polymer functioning as a protective colloid on the surface thereof as a side chain is particularly preferable as an aspect of the organic-inorganic hybrid particle.

[Method of introducing hydrophilic polymer into organic-inorganic hybrid particle]

The material for preparing a microgel and polyfunctional isocyanate are dissolved in a water-immiscible solvent, the solution is emulsified and dispersed in an aqueous solution containing a hydrophilic polymer having one or more active hydrogen groups which can react with an isocyanate group in one terminal, and the solvent is removed from oil droplets of the emulsification dispersion liquid for production. Alternatively, the material for preparing a microgel, polyfunctional isocyanate, and a hydrophilic polymer having one or more active hydrogen groups in one terminal are allowed to react with one another, the resultant is dissolved in a water-immiscible solution, this solution is emulsified and dispersed in an aqueous solution, and the solvent is removed from oil droplets of the emulsification dispersion liquid for production.

[Hydrophilic polymer having one or more active hydrogen groups in one terminal]

A hydrophilic polymer having one or more active hydrogen groups which can react with an isocyanate group in one terminal will be described below. Examples of the active hydrogen group which can react with an isocyanate group include a hydroxy group, an amino group, a mercapto group, and a carboxy group. Among these, a hydroxy group and an amino group are particularly preferable. The hydrophilic polymer having such an active hydrogen group is not particularly limited, and examples thereof include a compound which has a polyoxyalkylene chain containing active hydrogen groups in one terminal.

The mass average molar mass (Mw) of the hydrophilic polymer is preferably in a range of 300 to 500,000 and more preferably in a range of 500 to 100,000. In a case where the Mw thereof is in a range of 300 to 500,000, the hydrophilic polymer sufficiently functions as a protective colloid, the dispersion stability of polymer fine particles can be ensured, and the hydrophilicity of the surface can also be sufficiently obtained.

Specific examples of the hydrophilic polymer include polyethylene oxide and an ethylene oxide-propylene oxide copolymer, as the compound having a polyoxyalkylene chain. These polymers can be synthesized by performing ring-opening polymerization on a cyclic compound such as ethylene oxide or propylene oxide using an alcohol, an alkoxide,

a carboxylic acid, or a carboxylate as a polymerization-initiating terminal and converting the polymerization-initiating terminal into a hydroxy group or an amino group which is an active hydrogen group through a known reaction (for example, a hydrolysis reaction or a reduction reaction) of the related art. Further, a polyether having an active hydrogen group in one terminal can also be used. Among these, a monoether product (examples of the monoether include monomethyl ether and monoethyl ether) of polyethylene oxide and a monoester product (examples of the monoester include monoacetic acid ester and mono(meth)acrylic acid ester) of polyethylene oxide are more preferable.

Among these, a polyether derivative containing a terminal amino group or a terminal hydroxy group represented by Formula (c) is preferable.

$$R-O-\left(L-O\right)_n-\left(X\right)_m-A-Y \qquad \text{Formula (c)}$$

In Formula (c), X represents a linking group. Preferred examples of the linking group include -C(=O)- and $SO_2$-. Among these, -C(=O)- is preferable.

In Formula (c), m represents 0 or 1. A represents an arylene group or an alkylene group. Y represents an amino group or a hydroxy group.

The arylene group as A may include a substituent, and an arylene group having 6 to 30 carbon atoms is preferable and an arylene group having 6 to 20 carbon atoms is particularly preferable. As the substituent in a case of being substituted, a halogen atom, an alkyl group, an alkoxy group, an alkoxycarbonyl group, an aryloxycarbonyl group, or a cyano group is preferable; and an alkyl group or an alkoxy group is particularly preferable. Specific examples of such an arylene group include a phenylene group, a biphenylene group, a naphthylene group, a tolylene group, and a (methoxy)phenylene group.

As the alkylene group represented by A, an alkylene group having 1 to 30 carbon atoms is preferable; and an alkylene group having 1 to 20 carbon atoms is particularly preferable. Specific examples of such an alkylene group include a methylene group, an ethylene group, a propylene group, and a tetramethylene group.

In Formula (c), specific examples of the group represented by $-(X)_m$-A-Y include an aminoethyl group, an aminopropyl group, a 4-aminobenzoyl group, a 3-aminobenzoyl group, a 4-aminobenzenesulfonyl group, an aminoacetyl group, an aminoethylsulfonyl group, a hydroxyethyl group, a hydroxypropyl group, a 4-hydroxybenzoyl group, a 3-hydroxybenzoyl group, a 4-hydroxybenzenesulfonyl group, a hydroxyacetyl group, and a hydroxyethylsulfonyl group.

In Formula (c), L represents an alkylene group. The alkylene group represented by L may include a substituent or may be branched. Further, an alkylene group having 2 to 20 carbon atoms is preferable and an alkylene group having 2 to 10 carbon atoms is particularly preferable as the alkylene group. As the substituent in a case of being substitute, an aryl group, an alkenyl group, an alkoxy group, or an acyl group is preferable. Among these, an aryl group is particularly preferable. Specific example of such an alkylene group include an ethylene group, a propylene group, a tetramethylene group, a phenylethylene group, a cyclohexylene group, a vinylethylene group, and a phenoxymethylethylene group. Among these, an ethylene group and a propylene group are particularly preferable and an ethylene group is most preferable.

In the repeating unit $-(L-O)_n$- in Formula (c), L's may be independent from each other in n number of repetitions, but it is particularly preferable that L's are the same as each other. Specific examples of the polyether having such a repeating unit include polyethylene oxide, polypropylene oxide, polytetramethylene oxide, polystyrene oxide, polycyclohexylene oxide, a polyethylene oxide-polypropylene oxide block copolymer, and a polyethylene oxide-polypropylene oxide random copolymer. Among these, polyethylene oxide, polypropylene oxide, and a polyethylene oxide-polypropylene oxide block copolymer are preferable and polyethylene oxide is most preferable.

In Formula (c), R represents an organic group which does not have active hydrogen. R is not particularly limited as long as R represents an organic group which does not have active hydrogen that react with an isocyanate group, and preferred examples of the organic group include an alkyl group, an aryl group, and an acyl group. More preferred examples thereof include an alkyl group, an aryl group, and an acyl group.

As the alkyl group represented by R, an alkyl group having 1 to 30 carbon atoms is preferable and an alkyl group having 1 to 20 carbon atoms is particularly preferable. Specific examples of such an alkyl group include a methyl group, an ethyl group, a butyl group, an isopropyl group, a benzyl group, an allyl group, an oleyl group, and a methoxyethyl group. Among these, a methyl group is most preferable.

As the aryl group represented by R, an aryl group having 6 to 30 carbon atoms is preferable and an aryl group having 6 to 20 carbon atoms is particularly preferable. Specific examples of such an aryl group include a phenyl group, a nonylphenyl group, an octylphenyl group, and a methoxyphenyl group.

The acyl group represented by R may be aliphatic or aromatic, may include a substituent, or may be branched, and an acyl group having 2 to 30 carbon atoms is preferable and an acyl group having 2 to 20 carbon atoms is particularly

preferable. Specific examples of such an acyl group include an acetyl group, a benzoyl group, a (meth)acryloyl group, an oleoyl group, a lauroyl group, a stearoyl group, and a methoxybenzoyl group.

Hereinbefore, among examples of the group represented by R, an alkyl group is preferable.

In Formula (c), n represents an average addition molar number of the polyether group, which is a number of 10 to 120. In addition, a number of 12 to 100 is preferable as the average addition molar number.

Hereinafter, specific examples of the polyether derivative containing a terminal amino group or a terminal hydroxy group represented by Formula (c) will be described, but the present invention is not limited to these.

$R\text{-}O\text{-}(CH_2CHO)_n\text{-}X\text{-}A\text{-}Y$

| No | R | -X-A-Y | n |
|---|---|---|---|
| C-1 | $CH_3$ | $-CH_2-CH_2-OH$ | 90 |
| C-2 | $CH_3$ | $-CH_2-CH_2-OH$ | 23 |
| C-3 | $n\text{-}C_{18}H_{37}$ | $-CH_2-CH_2-OH$ | 30 |
| C-4 | 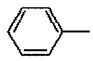 | $-CH_2-CH_2-OH$ | 30 |
| C-5 | $CH_3$ | 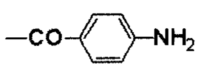 | 98 |
| C-6 | $CH_3$ | 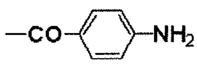 | 45 |
| C-7 | $n\text{-}C_{18}H_{37}$ | 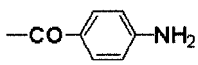 | 98 |
| C-8 | $CH_3$ | $-CO-CH_2-CH_2-NH_2$ | 98 |
| C-9 | $CH_3$ | $-SO_2-CH_2-CH_2-NH_2$ | 98 |
| C-10 | $CH_3$ | $-CH_2-CH_2-NH_2$ | 98 |

$H_3C\text{-}O\text{-}(L\text{-}O)_n\ \text{-}CH_2CH_2\text{-}OH$

| No | -(L-O)n- | n |
|---|---|---|
| C-11 | 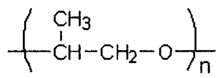 | 60 |
| C-12 | 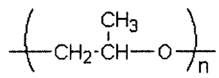 | 60 |
| C-13 | 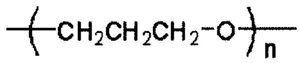 | 60 |
| C-14 | 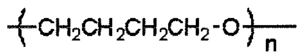 | 23 |
| C-15 | 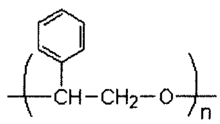 | 23 |
| C-16 | 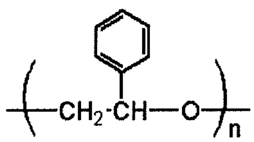 | 23 |

[Particle diameter and content of organic-inorganic hybrid particle]

The particle diameter of the organic-inorganic hybrid particles is preferable in a range of 0.01 to 20 μm, more preferably in a range of 0.05 to 5 μm, and still more preferably in a range of 0.1 to 1 μm.

The content of the organic-inorganic hybrid particles is preferably in a range of 5% to 90% by mass, more preferably in a range of 10% to 80% by mass, and still more preferably in a range of 20% to 60% by mass with respect to the total solid content of the image recording layer.

Infrared-ray absorbent (B)

The image recording layer contains an infrared-ray absorbent.

It is preferable that the infrared-ray absorbent is a sensitizing coloring agent having the maximum absorption in a wavelength range of 750 to 1400 nm.

As the infrared-ray absorbent, a dye or a pigment is preferably used.

As the dye, commercially available dyes and known dyes described in the literatures such as "Dye Handbook" (edited by The Society of Synthetic Organic Chemistry, Japan, published in 1970) can be used. Specific examples thereof include dyes such as an azo dye, a metal complex salt azo dye, a pyrazolone azo dye, a naphthoquinone dye, an anthraquinone dye, a phthalocyanine dye, a carbonium dye, a quinone imine dye, a methine dye, a cyanine dye, a squarylium coloring agent, a pyrylium salt, and a metal thiolate complex.

Among the above-described dyes, a cyanine coloring agent, a squarylium coloring agent, a pyrylium salt, a nickel thiolate complex, and an indolenine cyanine coloring agent are particularly preferable. Further, a cyanine coloring agent or an indolenine cyanine coloring agent is preferable and a cyanine coloring agent represented by Formula (a) is exemplified as a particularly preferred example.

Formula (a)

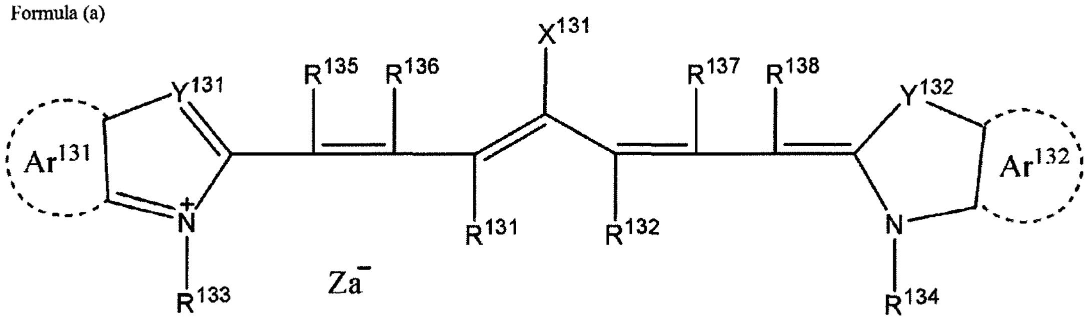

In Formula (a), $X^{131}$ represents a hydrogen atom, a halogen atom, $-NPh_2$, $-X^{132}-L^{131}$, or a group represented by the following formula. Further, Ph represents a phenyl group.

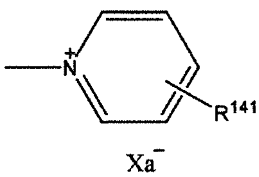

Here, $X^{132}$ represents an oxygen atom, a nitrogen atom, or a sulfur atom, $L^{131}$ represents a hydrocarbon group having 1 to 12 carbon atoms, an aryl group having heteroatoms (for example, N, S, O, a halogen atom, and Se), or a hydrocarbon group which has heteroatoms and 1 to 12 carbon atoms. $X_a^-$ has the same definition as that for $Z_a^-$ described below. $R^{141}$ represents a substituent selected from a hydrogen atom, an alkyl group, an aryl group, a substituted or unsubstituted amino group, and a halogen atom.

$R^{131}$ and $R^{132}$ each independently represent a hydrocarbon group having 1 to 12 carbon atoms. From the viewpoint of preservation stability of an image recording layer coating solution, it is preferable that $R^{131}$ and $R^{132}$ represent a hydrocarbon group having two or more carbon atoms. $R^{131}$ and $R^{132}$ may be linked to each other to form a ring. Further, during formation of a ring, it is particularly preferable to form a 5- or 6-membered ring.

$Ar^{131}$ and $Ar^{132}$ may be the same as or different from each other and each represent an aryl group which may have a substituent. Preferred examples of the aryl group include a benzene ring group and a naphthalene ring group. In addition, preferred examples of a substituent include a hydrocarbon group having 12 or less carbon atoms, a halogen

atom, and an alkoxy group having 12 or less carbon atoms. $Y^{131}$ and $Y^{132}$ may be the same as or different from each other and each represent a sulfur atom or a dialkylmethylene group having 12 or less carbon atoms. $R^{133}$ and $R^{134}$ may be the same as or different from each other and each represent a hydrocarbon group having 20 or less carbon atoms which may have a substituent. Preferred examples of the substituent include an alkoxy group having 12 or less carbon atoms, a carboxyl group, and a sulfo group. $R^{135}$, $R^{136}$, $R^{137}$, and $R^{138}$ may be the same as or different from each other and each represent a hydrogen atom or a hydrocarbon group having 12 or less carbon atoms. From the viewpoint of availability of a raw material, it is preferable that $R^{135}$, $R^{136}$, $R^{137}$, and $R^{138}$ represent a hydrogen atom. In addition, $Z_a^-$ represents a counter anion. Here, the cyanine coloring agent represented by Formula (a) has an anionic substituent in the structure thereof, and $Z_a^-$ is not necessary in a case where neutralization of the charge is not necessary. From the viewpoint of preservation stability of the image recording layer coating solution, it is preferable that $Z_a^-$ represents a halide ion, a perchlorate ion, a tetrafluoroborate ion, a hexafluorophosphate ion, or a sulfonate ion and particularly preferable that $Z_a^-$ represents a perchlorate ion, a hexafluorophosphate ion, or an arylsulfonate ion.

Specific examples of the cyanine coloring agent represented by Formula (a) include compounds described in paragraphs [0017] to [0019] of JP2001-133969A and compounds described in paragraphs [0016] to [0021] of JP2002-023360A and paragraphs [0012] to [0037] of JP2002-040638A. Preferred examples thereof include compounds described in paragraphs [0034] to [0041] of JP2002-278057A and paragraphs [0080] to [0086] of JP2008-195018A and particularly preferred examples thereof include compounds described in paragraphs [0035] to [0043] of JP2007-90850A.

Further, compounds described in paragraphs [0008] and [0009] of JP1993-5005A (JP-H05-5005A) and compounds described in paragraphs [0022] to [0025] of JP2001-222101A can be preferably used.

Further, the above-described infrared absorbing dyes may be used alone or in combination of two or more kinds thereof, and infrared-ray absorbents other than the infrared absorbing dyes such as pigments may be used in combination. As the pigments, compounds described in paragraphs [0072] to [0076] of JP2008-195018A are preferable.

The content of the infrared-ray absorbent is preferably in a range of 0.05 to 30 parts by mass, more preferably in a range of 0.1 to 20 parts by mass, and particularly preferably in a range of 0.2 to 10 parts by mass with respect to 100 parts by mass of the total solid content of the image recording layer.

Radical polymerizable compound (C)

It is preferable that the image recording layer further contains a radical polymerizable compound.

It is preferable that the radical polymerizable compound is an addition polymerizable compound having at least one ethylenic unsaturated double bond and more preferable that the radical polymerizable compound is selected from compounds having at least one and preferably two or more terminal ethylenic unsaturated bonds. These have chemical forms such as a monomer, a pre-polymer, that is, a dimer, a trimer, an oligomer, and a mixture of these. Examples of the monomer include unsaturated carboxylic acid (such as acrylic acid, methacrylic acid, itaconic acid, crotonic acid, isocrotonic acid, or maleic acid), esters, and amides thereof. Among these, esters of unsaturated carboxylic acid and a polyhydric alcohol compound and amides of unsaturated carboxylic acid and a polyvalent amine compound are preferably used. Further, addition reactants with unsaturated carboxylic acid ester having a nucleophilic substituent such as a hydroxyl group, an amino group, or a mercapto group or amides and monofunctional or polyfunctional isocyanates or epoxies; and dehydration condensation reactants with monofunctional or polyfunctional carboxylic acid are suitably used. Moreover, addition reactants with unsaturated carboxylic acid esters having an electrophilic substituent such as an isocyanate group or an epoxy group or amides and monofunctional or polyfunctional alcohols, amines, or thiols; and substitution reactants with unsaturated carboxylic acid esters having a releasable substituent such as a halogen group or a tosyloxy group or amides and monofunctional or polyfunctional alcohols, amines, or thiols are also suitably used. Further, compound groups in which the above-described unsaturated carboxylic acid is replaced with unsaturated phosphonic acid, styrene, vinyl ether, and the like can also be used. These are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, and JP1998-333321A(JP-H10-333321A).

Specific examples of monomers of esters of a polyhydric alcohol compound and unsaturated carboxylic acid include acrylic acid ester such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, or a polyester acrylate oligomer. Examples of the methacrylic acid ester include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane, and bis-[p-(methacryloxyethoxy)phenyl]dimethylmethane. Specific examples of monomers of amides of a polyvalent amine compound and unsaturated carboxylic acid include methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, and xylylene bismethacrylamide.

Moreover, a urethane-based addition polymerizable compound produced by using an addition reaction of isocyanate and a hydroxyl group is also suitable, and specific examples thereof include a vinyl urethane compound which is formed by adding a vinyl monomer containing a hydroxyl group represented by the following Formula (P) to a polyisocyanate compound that has two or more isocyanate groups in one molecule described in JP1973-41708B (JP-S48-41708B) and contains two or more polymerizable vinyl groups in one molecule.

$$CH_2=C(R^{104})COOCH_2CH(R^{105})OH \qquad (P)$$

(Here, $R^{104}$ and $R^{105}$ represent H or $CH_3$.)

In addition, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also preferable.

Among the examples described above, from the viewpoint that the balance between hydrophilicity associated with on-press developability and polymerization ability associated with printing durability is excellent, isocyanuric acid ethylene oxide-modified acrylates such as tris(acryloyloxyethyl) isocyanurate and bis(acryloyloxyethyl)hydroxyethyl isocyanurate are particularly preferable in a case of a planographic printing plate precursor to which on-press development is applied.

The details of the structures of these radical polymerizable compounds, whether to be used alone or in combination, and the usage method such as the addition amount can be arbitrarily set according to the final performance design of the planographic printing plate precursor. The content of the above-described radical polymerizable compound is preferably in a range of 5% to 75% by mass, more preferably in a range of 25% to 70% by mass, and particularly preferably in a range of 30% to 60% by mass with respect to the total solid content of the image recording layer.

Radical polymerization initiator (D)

It is preferable that the image recording layer further contains a radical polymerization initiator (hereinafter, also referred to as an initiator compound).

As the initiator compound, compounds known to those skilled in the art can be used without limitation, and specific examples thereof include a trihalomethyl compound, a carbonyl compound, an organic peroxide, an azo compound, an azide compound, a metallocene compound, a hexaarylbiimidazole compound, an organoboron compound, a disulfone compound, an oxime ester compound, an onium salt, and an iron arene complex. Among these, at least one selected from the group consisting of a hexaarylbiimidazole compound, an onium salt, a trihalomethyl compound, and a metallocene compound is preferable and a hexaarylbiimidazole compound and an onium salt are particularly preferable. The polymerization initiator can be used in combination of two or more kinds thereof.

Examples of the hexaarylbiimidazole compound include lophine dimers described in EP24629B, EP107792B, and US4410621A, such as 2,2-bis(o-chlorophenyl)-4,4',5,5'-tetraphenylbiimidazole, 2,2'-bis(o-bromophenyl)-4,4'5,5'-tetraphenylbiimidazole, 2,2'-bis(o,p-dichlorophenyl)-4,4'5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluoromethylphenyl)-4,4',5,5'-tetraphenylbiimidazole. It is particularly preferable that the hexaarylbiimidazole compound is used in combination with a sensitizing coloring agent having the maximum absorption in a wavelength range of 300 to 450 nm.

Examples of the onium salt compound include onium salts such as diazonium salts described in S. I. Schlesinger, Photogr. Sci. Eng., 18, 387 (1974), T. S. Bal et al, Polymer, 21, 423 (1980) and JP1993-158230A (JP-H05-158230A), ammonium salts described in US4069055A and JP1992-365049A (JP-H04-365049A), phosphonium salts described in US4069055A and US4069056A, iodonium salts described in EP104143B, US2008/0311520A, JP1990-150848A (JP-H02-150848A), JP2008-195018A, and J. V. Crivello et al, Macromolecules, 10(6), 1307 (1977), sulfonium salts described in EP370693B, EP233567B, EP297443B, EP297442B, US4933377A, US4760013A, US4734444A, US2833827A, GE2904626B, GE3604580B, and GE3604581B, selenonium salts described in J. V. Crivello et al, J. Polymer Sci., Polymer Chem. Ed., 17, 1047 (1979), arsonium salts described in C. S. Wen et al, Teh, Proc. Conf. Rad. Curing ASIA, p478 Tokyo, Oct (1988), and azinium salts described in JP2008-195018A.

Among these, iodonium salts, sulfonium salts, and azinium salts are preferable. Hereinafter, specific examples of these compounds will be described, but the present invention is not limited to these.

As the iodonium salts, diphenyliodonium salts are preferable, electron-donating groups such as diphenyl iodonium salts substituted with an alkyl group or an alkoxyl group are particularly preferable, and asymmetric diphenyl

iodonium salts are still more preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyliodonium=hexafluorophosphate, 4-hexyloxyphenyl-2,4-diethoxyphenyliodonium=tetrafluoroborate, 4-octyloxyphenyl-2,4,6-trimethoxyphenyliodonium=1-perfluorobutanesulfonate, 4-octyloxyphenyl-2,4,6-trimethoxyphenyliodonium=hexafluorophosphate, and bis(4-t-butylphenyl)iodonium=tetraphenylborate.

Examples of the sulfonium salts include triphenylsulfonium=hexafluorophosphate, triphenylsulfonium=benzoylformate, bis(4-chlorophenyl)phenylsulfonium=benzoylformate, bis(4-chlorophenyl)-4-methylphenylsulfonium=tetrafluoroborate, tris(4-chlorophenyl)sulfonium=3,5-bis(methoxycarbonyl)benzenesulfonate, and tris(4-chlorophenyl)sulfonium=hexafluorophosphate.

Examples of the azinium salts include 1-cyclohexylmethyloxypyridinium=hexafluorophosphate, 1-cyclohexyloxy-4-phenylpyridinium=hexafluorophosphate, 1-ethoxy-4-phenylpyridinium=hexafluorophosphate, 1-(2-ethylhexyloxy)-4-phenylpyridinium=hexafluorophosphate, 4-chloro-1-cyclohexylmethyloxypyridinium=hexafluorophosphate, 1-ethoxy-4-cyanopyridinium=hexafluorophosphate, 3,4-dichloro-1-(2-ethylhexyloxy)pyridinium=hexafluorophosphate, 1-benzyloxy-4-phenylpyridinium=hexafluorophosphate, 1-phenethyloxy-4-phenylpyridinium=hexafluorophosphate, 1-(2-ethylhexyloxy)-4-phenylpyridinium=p-to luenephosphate, 1-(2-ethylhexyloxy)-4-phenylpyridinium=perfluorobutanesulfonate, 1-(2-ethylhexyloxy)-4-phenylpyridinium=bromide, and 1-(2-ethylhexyloxy)-4-phenylpyridinium=tetrafluoroborate.

It is particularly preferable that the onium salts are used in combination with an infrared-ray absorbent having the maximum absorption in a wavelength range of 750 to 1400 nm.

In addition, polymerization initiators described in paragraphs [0071] to [0129] of JP2007-206217A can be preferably used.

The radical polymerization initiator is suitably used alone or in combination of two or more kinds thereof.

The content of the radical polymerization initiator in the image recording layer is preferably in a range of 0.01% to 20% by mass, more preferably in a range of 0.1% to 15% by mass, and still more preferably in a range of 1.0% to 10% by mass with respect to the total solid content of the image recording layer.

Binder (E)

It is preferable that the image recording layer contains a binder. A binder which is capable of allowing the image recording layer component to be carried and supported on a support and can be removed by at least one of a developer, printing ink, or dampening water is preferable as the binder. As the binder include a (meth)acrylic polymer, a polyurethane resin, a polyvinyl alcohol resin, a polyvinyl butyral resin, a polyvinyl formal resin, a polyamide resin, a polyester resin, or an epoxy resin is used. Among these, a (meth)acrylic polymer, a polyurethane resin, and a polyvinyl butyral resin are particularly preferable, and a (meth)acrylic polymer, a polyurethane resin, and a polyvinyl butyral resin are more preferable.

In the present invention, the "(meth)acrylic polymer" indicates a copolymer having a (meth)acrylic acid derivative, such as (meth)acrylic acid, (meth)acrylic acid ester (alkyl ester, aryl ester, allyl ester, or the like), (meth)acrylamide, or a (meth)acrylamide derivative, as a polymerization component. The "polyurethane resin" indicates a polymer to be generated by a condensation reaction between a compound containing two or more isocyanate groups and a compound containing two or more hydroxyl groups. The "polyvinyl butyral resin" indicates a polymer to be synthesized by reacting (acetalization reaction) butyl aldehyde with polyvinyl alcohol obtained by saponifying a part or the entire of polyvinyl acetate under acidic conditions and a polymer, into which a phosphoric acid group or the like is introduced according to a method of reacting a compound containing a hydroxy group and an acid group which remain, is also included in the polyvinyl butyral resin.

As one preferred example of the (meth)acrylic polymer, a copolymer having a repeating unit that contains an acid group is exemplified. Examples of the acid group include a carboxylic acid group, a sulfonic acid group, a phosphonic acid group, a phosphoric acid group, and a sulfonamide group. Among these, a carboxylic acid group is particularly preferable. As the repeating unit that contains an acid group, a repeating unit derived from (meth)acrylic acid or a repeating unit represented by Formula (I) is preferably used.

Formula (I)

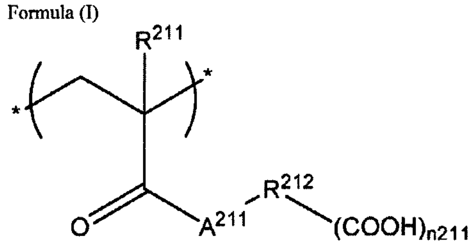

In Formula (I), $R^{211}$ represents a hydrogen atom or a methyl group, and $R^{212}$ represents a single bond or a ($n_{211}$ + 1) valent linking group. $A^{211}$ represents an oxygen atom or $-NR^{213}-$, and $R^{213}$ represents a hydrogen atom or a monovalent hydrocarbon group having 1 to 10 carbon atoms. $n_{211}$ represents an integer of 1 to 5.

Since the linking group as $R^{212}$ in Formula (I) is formed from hydrogen atoms, carbon atoms, oxygen atom, nitrogen atoms, sulfur atoms, and halogen atoms, the number of atoms is preferably in a range of 1 to 80. Specific examples thereof include an alkylene group, a substituted alkylene group, an arylene group, and a substituted arylene group. In addition, a plurality of these divalent groups may form a structure by being linked to one another through any of an amide bond, an ether bond, a urethane bond, a urea bond, and an ester bond. $R^{212}$ represents preferably a structure in which a plurality of single bonds, alkylene groups, substituted alkylene groups, alkylene groups and/or substituted alkylene groups are linked to one another through any of an amide bond, an ether bond, a urethane bond, a urea bond, and an ester bond, more preferably a structure in which a plurality of single bonds, alkylene groups having 1 to 5 carbon atoms, substituted alkylene groups having 1 to 5 carbon atoms, alkylene groups having 1 to 5 carbon atoms, and/or substituted alkylene groups having 1 to 5 carbon atoms are linked to one another through any of an amide bond, an ether bond, a urethane bond, a urea bond, and an ester bond, and particularly preferably a structure in which a plurality of single bonds, alkylene groups having 1 to 3 carbon atoms, substituted alkylene groups having 1 to 3 carbon atoms, alkylene groups having 1 to 3 carbon atoms, and/or substituted alkylene groups having 1 to 3 carbon atoms are linked to one another through at least any of an amide bond, an ether bond, a urethane bond, a urea bond, or an ester bond.

Examples of the substituent which may be contained in a linking group as $R^{212}$ include a monovalent non-metallic atomic group excluding an hydrogen atom, and specific examples thereof include a halogen atom (such as -F, -Br, -Cl, or -I), a hydroxyl group, a cyano group, an alkoxy group, an aryloxy group, a mercapto group, an alkylthio group, an arylthio group, an alkylcarbonyl group, an arylcarbonyl group, a carboxyl group and a conjugated base group thereof, an alkoxycarbonyl group, an aryloxycarbonyl group, a carbamoyl group, an aryl group, an alkenyl group, and an alkynyl group.

$R^{213}$ represents preferably a hydrogen atom or a hydrocarbon group having 1 to 5 carbon atoms, more preferably a hydrogen atom or a hydrocarbon group having 1 to 3 carbon atoms, and particularly preferably a hydrogen atom or a methyl group.

$n_{211}$ represents preferably an integer of 1 to 3, more preferably 1 or 2, and particularly preferably 1.

From the viewpoint of the developability, the proportion (% by mole) of the polymerization component containing a carboxylic acid group in the entire polymerization component of the (meth)acrylic polymer is preferably in a range of 1% to 70%. From the viewpoint of achieving both of developability and printing durability, the proportion thereof is more preferably in a range of 1% to 50% and particularly preferably in a range of 1% to 30%.

It is preferable that the (meth)acrylic polymer used in the present invention further includes a cross-linkable group. Here, the cross-linkable group indicates a group that allows the binder to be cross-linked during a radical polymerization reaction occurring in the image recording layer at the time of exposing the planographic printing plate precursor. The cross-linkable group is not particularly limited as long as the group has such a function, and examples the functional group in which an addition polymerization reaction may occur include an ethylenic unsaturated binding group, an amino group, and an epoxy group. Further, the functional group may be a functional group which can be a radical by irradiation with light, and examples of such a cross-linkable group include a thiol group and a halogen group. Among these, an ethylenic unsaturated binding group is preferable. Preferred examples of the ethylenic unsaturated binding group include a styryl group, a (meth)acryloyl group, and an allyl group.

In the binder, for example, a free radical (growth radical in the process of polymerization of a polymerization initiating radical or a polymerizable compound) is added to the cross-linkable functional group thereof so that addition polymerization is carried out directly between polymers or through a polymerization chain of a polymerizable compound, and cross-linking occurs between polymer molecules so that curing is promoted. Alternatively, atoms (hydrogen atom on carbon atoms adjacent to the functional cross-linking group) in the polymer are pulled out by free radicals so that polymer radicals are generated, and cross-linking occurs between polymer molecules so that curing is promoted by the polymer radicals being bonded to each other.

The content (content of radically polymerizable unsaturated double bond by iodine titration) of the cross-linkable group in the (meth)acrylic polymer is preferably in a range of 0.01 to 10.0 mmol, more preferably in a range of 0.05 to

9.0 mmol, and particularly preferably in a range of 0.1 to 8.0 mmol per 1 g of the binder.

The (meth)acrylic polymer used in the present invention may have a polymerization unit of alkyl (meth)acrylate or aralkyl ester, a polymerization unit of (meth)acrylamide or a derivative thereof, a polymerization unit of α-hydroxymethyl acrylate, or a polymerization unit of a styrene derivative, in addition to a polymerization unit of the acid group and a polymerization unit having a cross-linkable group. As the alkyl group of (meth)acrylic acid alkyl ester, an alkyl group having 1 to 5 carbon atoms or an alkyl group having 2 to 8 carbon atoms and the above-described substituent is preferable and a methyl group is more preferable. Examples of the (meth)acrylic acid aralkyl ester include benzyl (meth)acrylate. Examples of the (meth)acrylamide derivative include N-isopropylacrylamide, N-phenylmethacrylamide, N-(4-methoxycarbonylphenyl)methacrylamide, N,N-dimethylacrylamide, and morpholinoacrylamide. Examples of the α-hydroxymethyl acrylate include ethyl α-hydroxymethyl acrylate and cyclohexyl α-hydroxymethyl acrylate. Examples of the styrene derivative include styrene and 4-tert butylstyrene.

Further, in a case of the planographic printing plate precursor to which on-press development is applied, it is preferable that the binder contains a hydrophilic group. The hydrophilic group contributes to imparting on-press developability to the image recording layer. Particularly, the printing durability and on-press developability can be achieved by allowing the cross-linkable group and the hydrophilic group to coexist.

Examples of the hydrophilic group which may be contained in the binder include a hydroxy group, a carboxyl group, an alkylene oxide structure, an amino group, an ammonium group, an amide group, a sulfo group, and a phosphoric acid group. Among these, an alkylene oxide structure having 1 to 9 alkylene oxide units respectively having 2 or 3 carbon atoms is preferable. The hydrophilic group is imparted to the binder by, for example, copolymerizing monomers containing a hydrophilic group.

Preferred examples of the polyurethane resin include polyurethane resins described in paragraphs [0099] to [0210] of JP2007-187836A, paragraphs [0019] to [0100] of JP2008-276155A, paragraphs [0018] to [0107] of JP2005-250438A, and paragraphs [0021] to [0083] of JP2005-250158A.

Preferred examples of the polyvinyl butyral resin include polyvinyl butyral resins described in paragraphs [0006] to [0013] of JP2001-75279A.

A part of an acid group in the binder may be neutralized in a basic compound. Examples of the basic compound include a compound containing basic nitrogen, an alkali metal hydroxide, and an alkali metal quaternary ammonium salt.

The mass average molecular weight of the binder is preferably 5000 or greater and more preferably in a range of 10000 to 300000; and the number average molecular weight of the binder is preferably 1000 or greater and more preferably in a range of 2000 to 250000. The polydispersity (mass average molecular weight/number average molecular weight) of the binder is preferably in a range of 1.1 to 10.

The binder may be used alone or in mixture of two or more kinds thereof.

From the viewpoints of excellent strength of an image area and image formability, the content of the binder is preferably in a range of 5% to 75% by mass, more preferably in a range of 10% to 70% by mass, and still more preferably in a range of 10% to 60% by mass with respect to the total solid content of the image recording layer.

Further, the total content of the radical polymerizable compound and the binder is preferably 90% by mass or less with respect to the total solid content of the image recording layer. In a case where the total content thereof exceeds 90% by mass, this may cause degradation of sensitivity and degradation of developability in some cases. The total content thereof is more preferably in a range of 35% to 80% by mass.

Low-molecular-weight hydrophilic compound (F)

In order to improve the on-press developability without degrading the printing durability, the image recording layer may contain a low-molecular-weight hydrophilic compound.

As the low-molecular-weight hydrophilic compound, examples of a water-soluble organic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

In the present invention, among these, it is preferable that the image recording layer contains at least one selected from the group consisting of polyols, organic sulfates, organic sulfonates, and betaines.

Specific examples of the compound of an organic sulfonate include an alkyl sulfonate such as sodium n-butyl sulfonate, sodium n-hexyl sulfonate, sodium 2-ethylhexyl sulfonate, sodium cyclohexyl sulfonate, or sodium n-octyl sulfonate; an alkyl sulfonate containing an ethylene oxide chain such as sodium 5,8,11-trioxapentadecane-1-sulfonate,

sodium 5,8,11-trioxaheptadecane-1-sulfonate, sodium 13-ethyl-5,8,11-trioxaheptadecane-1-sulfonate, or sodium 5,8,11,14-tetraoxatetradecosane-1-sulfonate; an aryl sulfonate such as sodium benzene sulfonate, sodium p-toluene sulfonate, sodium p-hydroxybenzene sulfonate, sodium p-styrene sulfonate, sodium isophthalic acid dimethyl-5-sulfonate, sodium 1-naphthyl sulfonate, sodium 4-hydroxynaphthyl sulfonate, disodium 1,5-naphthalene disulfonate, trisodium 1,3,6-naphthalene trisulfonate; and compounds described in paragraphs [0026] to [0031] of JP2007-276454A and paragraphs [0020] to [0047] of JP2009-154525A. The salt may be a potassium salt or a lithium salt.

Examples of the organic sulfate include an alkyl, an alkenyl, an alkynyl, an aryl of polyethylene oxide and a sulfate of heterocyclic monoether. The number of ethylene oxide units is preferably in a range of 1 to 4. As a salt, a sodium salt, a potassium salt, or a lithium salt is preferable. Specific examples of these include compounds described in paragraphs [0034] to [0038] of JP2007-276454.

As betaines, compounds having 1 to 5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the low-molecular-weight hydrophilic compound has a small structure of a hydrophobic portion and almost does not have a surfactant action, hydrophobicity or coated-film hardness of an image area is not degraded by dampening water permeating into an image recording layer exposed portion (image area) and ink receptivity or printing durability of the image recording layer can be maintained satisfactorily.

The content of the low-molecular-weight hydrophilic compounds in the image recording layer is preferably in a range of 0.5% to 20% by mass, more preferably in a range of 1% to 15% by mass, and still more preferably in a range of 2% to 10% by mass with respect to the total solid content of the image recording layer. In a case where the content thereof is in the above-described range, excellent on-press developability and printing durability can be obtained. The low-molecular-weight hydrophilic compounds may be used alone or in combination of two or more kinds thereof.

Sensitizing agent (G)

In order to improve the impressing property, it is preferable that the image recording layer contains a sensitizing agent such as a phosphonium compound, a nitrogen-containing low-molecular-weight compound, or an ammonium group-containing polymer. Particularly, in a case where a protective layer contains an inorganic layered compound, the sensitizing agent functions as a surface coating agent of the inorganic layered compound and prevents a degradation in impressing properties due to the inorganic layered compound during the printing.

Preferred examples of the phosphonium compound include phosphonium compounds described in JP2006-297907A and JP2007-50660A. Specific examples thereof include tetrabutyl phosphonium iodide, butyl triphenyl phosphonium bromide, tetraphenyl phosphonium bromide, 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate.

Examples of the nitrogen-containing low-molecular-weight compound include amine salts, and quaternary ammonium salts. Further, examples thereof include imidazolinium salts, benzimidazolinium salts, pyridinium salts, and quinolinium salts. Among these, quaternary ammonium salts and pyridinium salts are preferable. Specific examples thereof include tetramethyl ammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, and compounds described in paragraphs [0021] to [0037] of JP2008-284858A and paragraphs [0030] to [0057] of JP2009-90645A.

The ammonium group-containing polymer is not particularly limited as long as the polymer contains an ammonium group in the structure thereof, but a polymer that contains, as a copolymerization component, 5% to 80% by mole of (meth)acrylate having an ammonium group in the side chain is preferable. Specific examples thereof include polymers described in paragraphs [0089] to [0105] of JP2009-208458A.

The reduced specific viscosity (unit: ml/g) of the ammonium salts-containing polymer which is acquired by the following measurement method is preferably in a range of 5 to 120, more preferably in a range of 10 to 110, and particularly preferably in a range of 15 to 100. In a case where the reduced specific viscosity is converted into the mass average molecular weight, the value thereof is preferably in a range of 10000 to 150000, more preferably in a range of 17000 to 140000, and particularly preferably in a range of 20000 to 130000.

«Method of measuring reduced specific viscosity»

3.33 g (1 g as a solid content) of a 30% polymer solution is weighed using a 20 ml of measuring flask and is diluted with N-methylpyrrolidone. This solution is allowed to stand in a constant-temperature tank at 30°C for 30 minutes

and put into an Ubbelohde reduced viscosity tube (viscometer constant: 0.010 cSt/s), and then the time for the solution to fall down at 30°C is measured. Further, the measurement is performed two times using the same sample and the average value thereof is calculated. Similarly, also in a case of the blank (only N-methylpyrrolidone), the measurement is performed and the reduced specific viscosity (ml/g) is calculated from the following equation.

$$\text{Reduced specific viscosity (ml/g)} = \frac{\dfrac{\text{Time for sample solution to fall down (sec) - time for blank to fall down (sec)}}{\text{Time for blank to fall down (sec)}}}{\dfrac{3.33\ (g) \times \dfrac{30}{100}}{20\ (ml)}}$$

Hereinafter, specific examples of the ammonium group-containing polymer will be described.

(1) A 2-(trimethylammonio)ethylmethacrylate=p-toluenesulfonate/3,6-dioxaheptylmethacrylate copolymer (molar ratio of 10/90, mass average molecular weight of 45000);
(2) A 2-(trimethylammonio)ethylmethacrylate=hexafluorophosphate/3,6-dioxaheptylmethacrylate copolymer (molar ratio of 20/80, mass average molecular weight of 60000),
(3) A 2-(ethyldimethylammonio)ethylmethacrylate=p-toluenesulfonate/hexylmethacrylate copolymer (molar ratio of 30/70, mass average molecular weight of 45000);
(4) A 2-(trimethylammonio)ethylmethacrylate=hexafluorophosphate/2-ethylhexylmethacrylate copolymer (molar ratio of 20/80, mass average molecular weight of 60000);
(5) A 2-(trimethylammonio)ethylmethacrylate=methylsulfate/hexylmethacrylate copolymer (molar ratio of 40/60, mass average molecular weight of 70000);
(6) A 2-(butyldimethylammonio)ethylmethacrylate=hexafluorophosphate/3,6-dioxaheptylmethacryla te copolymer (molar ratio of 25/75, mass average molecular weight of 65000);
(7) A 2-(butyldimethylammonio)ethylacrylate=hexafluorophosphate/3,6-dioxaheptylmethacrylate copolymer (molar ratio of 20/80, mass average molecular weight of 65000);
(8) A 2-(butyldimethylammonio)ethylmethacrylate=13-ethyl-5,8,11-trioxa-1-heptadecanesulfonate/3 ,6-dioxaheptylmethacrylate copolymer (molar ratio of 20/80, mass average molecular weight of 75000); and
(9) A 2-(butyldimethylammonio)ethylmethacrylate=hexafluorophosphate/3,6-dioxaheptylmethacryla te/2-hydroxy-3-methacryloxypropylmethacrylate copolymer (molar ratio of 15/80:5, mass average molecular weight of 65000)

The content of the sensitizing agent is preferably in a range of 0.01% to 30.0% by mass, more preferably in a range of 0.1% to 15.0% by mass, and still more preferably in a range of 1% to 5% by mass with respect to the total solid content of the image recording layer.

Hydrophobic precursor (H)

In order to improve the on-press developability, the image recording layer may contain a hydrophobic precursor. The hydrophobic precursor indicates a fine particle which is capable of making the image recording layer hydrophobic in a case of being heated. It is preferable that the fine particle is at least one selected from a hydrophobic thermoplastic polymer fine particle, a thermally reactive polymer fine particle, a polymer fine particle containing a polymerizable group, a microcapsule including a hydrophobic compound, and a microgel (cross-linked polymer fine particle). Among these, a polymer fine particle containing a polymerizable group and a microgel are preferable.

Preferred examples of the hydrophobic thermoplastic polymer fine particles include hydrophobic thermoplastic polymer fine particles described in Research Disclosure No. 333003 on January, 1992, JP1997-123387A (JP-H09-123387A), JP1997-131850A (JP-H09-131850A), JP1997-171249A (JP-H09-171249A), JP1997-171250A (JP-H09-171250A), and EP931647B.

Specific examples of a polymer constituting hydrophobic thermoplastic polymer fine particles include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures of these. Among these, polystyrene, styrene, a copolymer containing acrylonitrile, and polymethylmethacrylate are more preferable.

The average particle diameter of the hydrophobic thermoplastic polymer fine particles used in the present

invention is preferably in a range of 0.01 to 2.0 μm.

Examples of the thermally reactive polymer fine particles used in the present invention include polymer fine particles having a thermally reactive group. The thermally reactive polymer fine particles are cross-linked by a thermal reaction and have hydrophobic regions formed by a change in functional groups during the cross-linking.

As the thermally reactive group in polymer fine particles having a thermally reactive group used in the present invention, a functional group that performs any reaction may be used as long as a chemical bond is formed, but a polymerizable group is preferable. Preferred examples of the polymerizable group include an ethylenic unsaturated group that performs a radical polymerization reaction (such as an acryloyl group, a methacryloyl group, a vinyl group, or an allyl group); a cationic polymerizable group (such as a vinyl group, a vinyloxy group, an epoxy group, or an oxetanyl group); an isocyanate group that performs an addition reaction or a block body thereof, an epoxy group, a vinyloxy group, and a functional group having active hydrogen atoms as the reaction partners of these (such as an amino group, a hydroxy group, or a carboxy group); a carboxy group that performs a condensation reaction and a hydroxy group or an amino group as a reaction partner thereof; and an acid anhydride that performs a ring opening addition reaction and an amino group or a hydroxy group as a reaction partner thereof.

The microcapsule used in the present invention is a microcapsule which includes a part or the entire constituent component of the image recording layer as described in JP2001-277740A and JP2001-277742A. Further, the constituent component of the image recording layer may also be contained in a portion other than the microcapsule. Moreover, a preferred aspect of the image recording layer containing the microcapsule is an embodiment in which hydrophobic constituent components are included in a microcapsule and hydrophilic constituent components are contained in a portion other than the microcapsule.

The microgel used in the present invention may contain a part of the constituent components of the image recording layer in at least one of the surface or the inside thereof. From the viewpoints of image forming sensitivity and printing durability, a reactive microgel having a radical polymerizable group on the surface thereof is particularly preferable.

The constituent components of the image recording layer can be made into microcapsules or microgel particles using a known method.

The average particle diameter of the microcapsules or microgels is preferably in a range of 0.01 to 3.0 μm, more preferably in a range of 0.05 to 2.0 μm, and particularly preferably in a range of 0.10 to 1.0 μm. In a case where the average particle diameter thereof is in the above-described range, excellent resolution and temporal stability are obtained.

The content of the hydrophobic precursor is preferably in a range of 5% to 90% by mass with respect to the total solid content of the image recording layer.

Reducing agent (1)

From the viewpoint of improving the printing durability, the image recording layer may contains a reducing agent. The following five kinds are preferably exemplified as the examples of the reducing agent.

(i) Alkyl or arylate complex: It is considered that a carbon-hetero bond is oxidatively dissociated and an active radical is generated. Specifically, a borate salt compound is preferably used.

As the borate salt compound, organic borates described in JP1987-143044A (JP-S62-143044A), JP1987-150242A (JP-S62-150242A), JP1997-188685A (JP-H09-188685A), JP1997-188686A (JP-H09-188686A), JP1997-188710A (JP-H09-188710A), JP2000-131837A, JP2002-107916A, JP2764769B, JP2002-116539A, and "Rad Tech' 98. Proceeding April 19 to 22, 1998, Chicago" written by Kunz, Martin are preferable.

(ii) N-arylalkylamine compound: It is considered that a C-X bond on carbon adjacent to nitrogen is dissociated due to oxidation and an active radical is generated. As X, a hydrogen atom, a carboxyl group, a trimethylsilyl group, or a benzyl group is preferable. Specific examples thereof include N-phenylglycines (the phenyl group may or may not include a substituent) and N-phenyliminodiacetic acid (the phenyl group may or may not include a substituent) which are described in the following chemical formulae.

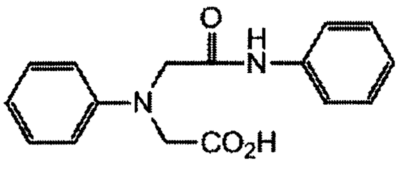
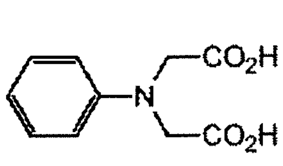
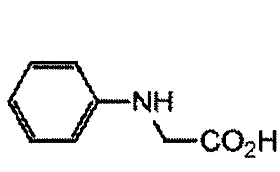

(iii) Sulfur-containing compound: An active radical can be generated from the above-described amines in which nitrogen atoms are substituted with sulfur atoms, through the same action. Examples thereof include phenylthioacetic

acid (the phenyl group may or may not include a substituent).

(iv) Tin compound: An active radical can be generated from the above-described amines in which nitrogen atoms are substituted with tin atoms, through the same action.

(v) Sulfinates: An active radical can be generated through oxidation. Specific examples thereof include sodium arylsulfinate.

The reducing agent may be used alone or in combination of two or more kinds thereof.

The content of the reducing agent is preferably in a range of 0.01% to 30% by mass, more preferably in a range of 0.05% to 25% by mass, and still more preferably in a range of 0.1% to 20% by mass with respect to the total solid content of the image recording layer.

Hereinafter, preferred examples of the reducing agent will be described, but the present invention is not limited to these. Further, in the exemplary compounds, Me represents a methyl group, Et represents an ethyl group, and n-Bu represents an n-butyl group.

(F-1)
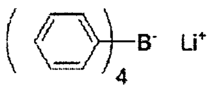
(F-2)
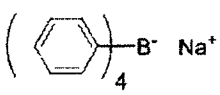
(F-3)
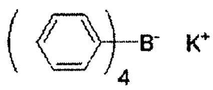
(F-4)
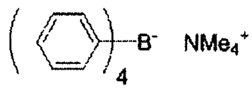

(F-5)
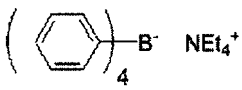
(F-6)
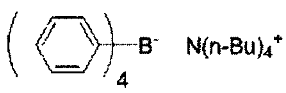
(F-7)
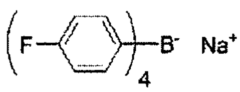
(F-8)
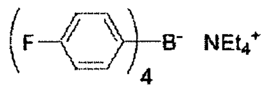

(F-9)
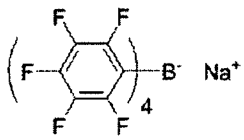
(F-10)
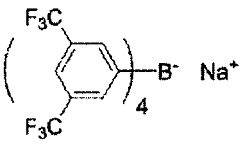
(F-11)
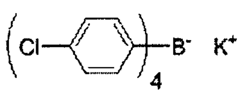
(F-12)
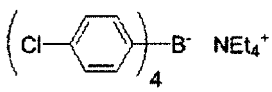

(F-13)
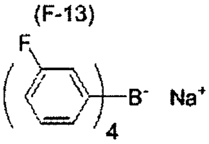
(F-14)
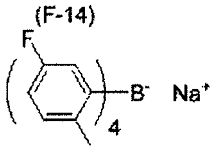
(F-15)
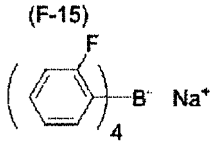
(F-16)
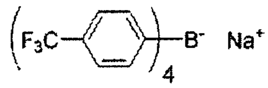

(F-17)
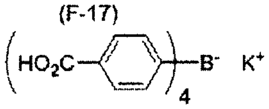
(F-18)
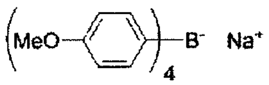
(F-19)
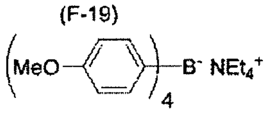
(F-20)
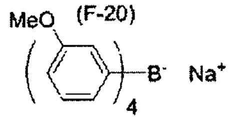

(F-21)
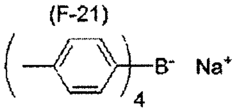
(F-22)
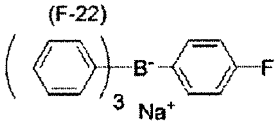
(F-23)
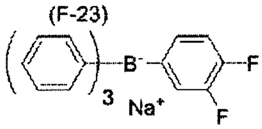
(F-24)
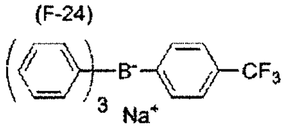

(F-25)
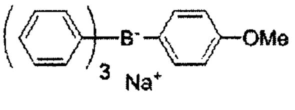
(F-26)
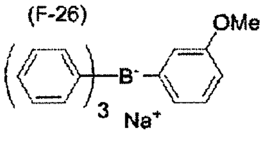
(F-27)
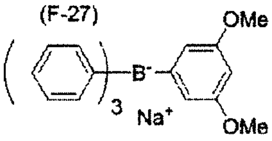

(F-28)

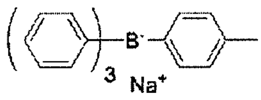

(F-29)

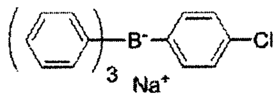

Other image recording layer components (J)

It is preferable that the image recording layer contains a chain transfer agent. The chain transfer agent is defined, for example, in Polymer Dictionary Third Edition (edited by The Society of Polymer Science, Japan, 2005), pp. 683 and 684. For example, a compound group having SH, PH, SiH, and GeH in a molecule is used as the chain transfer agent. With these, radicals are generated by donating hydrogen to low active radicals or radicals can be generated by deprotonation after oxidation. Further, particularly, thiol compounds (such as 2-mercaptobenzimidazoles, 2-mercaptobenzthiazoles, 2-mercaptobenzoxazoles, 3-mercaptotriazoles, and 5-mercaptotetrazoles) can be preferably used for the image recording layer.
The content of the chain transfer agent is preferably in a range of 0.01 to 20 parts by mass, more preferably in a range of 1 to 10 parts by mass, and particularly preferably in a range of 1 to 5 parts by mass with respect to 100 parts by mass of the total solid content of the image recording layer.
The image recording layer may further contain various additives as necessary. Examples of the additives include a surfactant for promoting developability and improving the coated surface state; a hydrophilic polymer for improving developability and improving dispersion stability of microcapsules; a colorant or a print-out agent for visually recognizing an image area and a non-image area; a polymerization inhibitor for preventing unnecessary thermal polymerization of a polymerizable compound during production or storage of the image recording layer; a hydrophobic low-molecular-weight compound such as a higher fatty derivative for preventing polymerization inhibition due to oxygen; inorganic fine particles and organic fine particles for improving cured film hardness of an image area; a co-sensitizer for improving sensitivity; and a plasticizer for improving plasticity. As these compounds, known compounds described in paragraphs [0161] to [0215] of JP2007-206217A, paragraph [0067] of JP2005-509192A, and paragraphs [0023] to [0026] and [0059] to [0066] of JP2004-310000A can be used. As the surfactant, the following surfactants which may be added to a developer can also be used.

(Formation of image recording layer)

The method of forming the image recording layer of the planographic printing plate precursor of the present invention is not particularly limited, and a known method can be used for formation. The image recording layer is formed by dispersing or dissolving necessary each of the image recording layer components in a solvent to prepare a coating solution and applying the solution. Examples of the solvent to be used include methyl ethyl ketone, ethylene glycol monomethyl ether, 1-methoxy-2-propanol, 2-methoxyethyl acetate, 1-methoxy-2-propyl acetate, and $\gamma$-butyl lactone, but the present invention is not limited to these. The solvent may be used alone or in combination. The concentration of solid contents in the coating solution is preferably in a range of 1% to 50% by mass.
The coating amount (solid content) of the image recording layer is preferably in a range of 0.3 to 3.0 $g/m^2$. Various methods can be used as the coating method. Examples thereof include bar coater coating, spin coating, spray coating, curtain coating, dip coating, air knife coating, blade coating, and roll coating. The organic-inorganic hybrid particles (A) can be contained in the image recording layer by preparing an aqueous dispersion liquid of the organic-inorganic hybrid particles (A) and mixing a solution containing other components with the organic-inorganic hybrid particles (A).

[Support]

The support used in the planographic printing plate precursor of the present invention is not particularly limited as long as the support is a plate-like hydrophilic support which is dimensionally stable. An aluminum plate is particularly preferable as the support. It is preferable that a surface treatment such as a surface roughening treatment or anodizing treatment is performed before using an aluminum plate. The surface roughening treatment is preformed on the surface of the aluminum plate according to various methods, and examples thereof include a mechanical surface roughening treatment, an electrochemical surface roughening treatment (a surface roughening treatment of electrochemically dissolving the surface), and a chemical surface roughening treatment (a surface roughening treatment of selectively and chemically dissolving the surface). Methods described in paragraphs [0241] to [0245] of JP2007-206217A can be preferably used for these treatments.
The center line average roughness of the support is preferably in a range of 0.10 to 1.2 $\mu$m. In a case where

the center line average roughness thereof is in this range, excellent adhesiveness to the image recording layer, excellent printing durability, and excellent stain resistance can be obtained.

Further, the color density of the support is preferably in a range of 0.15 to 0.65 in terms of reflection density value. In a case where the color density thereof is in this range, excellent image formability resulting from prevention of halation at the time of image exposure and excellent plate inspectability after development can be obtained.

The thickness of the support is preferably in a range of 0.1 to 0.6 mm, more preferably in a range of 0.15 to 0.4 mm, and still more preferably in a range of 0.2 to 0.3 mm.

<Hydrophilic treatment>

In the planographic printing plate precursor of the present invention, a hydrophilic treatment is suitably performed on the surface of the support in order to improve the hydrophilicity of the non-image area region and prevent printing stain.

Examples of the method for the hydrophilic treatment to be performed on the surface of the support include an alkali metal silicate treatment of performing an immersion treatment or an electrolytic treatment on the support in an aqueous solution such as sodium silicate; a method of treating the surface with potassium fluorozirconate, and a method of treating the surface with polyvinylphosphoric acid. In addition, a method of performing an immersion treatment on the surface in a polyvinylphosphonic acid aqueous solution is preferably used.

[Other layers arbitrarily provided between support and image recording layer]

In the planographic printing plate precursor of the present invention, an undercoat layer is suitably provided between the support and the image recording layer in order to improve the hydrophilicity of the non-image area region and prevent printing stain.

<Undercoat layer>

In a case where the planographic printing plate precursor of the present invention includes an undercoat layer, preferred examples of the compound used for the undercoat layer include a silane coupling agent having an ethylenic double bond reaction group, which can be added and polymerized, described in JP1998-282679A (JP-H10-282679A); and a phosphorous compound having an ethylenic double bond reaction group described in JP1990-304441A (JP-H02-304441A). Particularly preferred examples thereof include compounds containing a polymerizable group such as a methacryl group or an allyl group; and a support adsorptive group such as a sulfonic acid group, a phosphoric acid group, or phosphoric acid ester. In addition to these polymerizable groups and support adsorptive groups, compounds containing a hydrophilicity imparting group such as an ethylene oxide group can be exemplified as the suitable compound.

The undercoat layer can be provided according to a method of coating the support with a solution obtained by dissolving the above-described compound in water, an organic solvent such as methanol, ethanol, or methyl ethyl ketone, or a mixed solvent of these and drying the support; or a method of immersing the support in a solution obtained by dissolving the above-described compound in water, an organic solvent such as methanol, ethanol, or methyl ethyl ketone, or a mixed solvent of these to adsorb the compound, washing the support with water, and drying the support. According to the former method, the support can be coated with a solution containing the compound at a concentration of 0.005% to 10% by mass using various methods.

For example, any method of bar coater coating, spin coating, spray coating, and curtain coating may be used. According to the latter method, the concentration of the solution is in a range of 0.01% to 20% by mass and preferably in a range of 0.05% to 5% by mass; the immersion temperature is in a range of 20°C to 90°C and preferably in a range of 25°C to 50°C, and the immersion time is in a range of 0.1 seconds to 20 minutes and preferably in a range of 2 seconds to 1 minute.

The coating amount (solid content) of the undercoat layer is preferably in a range of 0.1 to 100 $mg/m^2$ and more preferably in a range of 1 to 30 $mg/m^2$.

[Protective layer]

In the planographic printing plate precursor of the present invention, it is preferable that a protective layer (oxygen blocking layer) is provided on the image recording layer in order to block diffusion penetration of oxygen that disturbs a polymerization reaction during exposure. As the material of the protective layer, any of a water-soluble polymer and a water-insoluble polymer can be appropriately selected and used, and two or more kinds thereof can be used in combination as necessary. Specific examples thereof include polyvinyl alcohol, modified polyvinyl alcohol, polyvinylpyrrolidone, a water-soluble cellulose derivative, and poly(meth)acrylonitrile. Among these, a water-soluble polymerizable compound having relatively excellent crystallinity is preferably used. Specifically, in a case where polyvinyl alcohol is

used as a main component, this leads to excellent results particularly for basic characteristics such as oxygen blocking properties and development removability.

Since polyvinyl alcohol used for the protective layer has necessary oxygen blocking properties and water solubility, a part of the polyvinyl alcohol may be substituted with an ester, an ether, or an acetal as long as the polyvinyl alcohol contains a necessary unsubstituted vinyl alcohol unit. Further, similarly, a part thereof may contain other copolymerization components. The polyvinyl alcohol can be obtained by hydrolyzing polyvinyl acetate. Specific examples of the polyvinyl alcohol include those in which the degree of hydrolysis is in a range of 69.0% to 100% by mole and the number of polymerization repeating units is in a range of 300 to 2400. Specific examples thereof include PVA-102 PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706, and L-8 (all manufactured by KURARAY CO., LTD.). The polyvinyl alcohol can be used alone or in combination of two or more kinds thereof. The content of the polyvinyl alcohol in the protective layer is preferably in a range of 20% to 95% by mass and more preferably in a range of 30% to 90% by mass.

Further, the modified polyvinyl alcohol can also be preferably used. Particularly, acid-modified polyvinyl alcohol containing a carboxylic acid group or a sulfonic acid group is preferably used. Specifically, polyvinyl alcohol described in JP2005-250216A and JP2006-259137A is suitably exemplified.

In a case where polyvinyl alcohol is mixed with other materials and used, from the viewpoints of oxygen blocking properties and development removability, modified polyvinyl alcohol, polyvinylpyrrolidone, or a modified product thereof is preferable as the component to be mixed. The content thereof in the protective layer is in a range of 3.5% to 80% by mass, preferably in a range of 10% to 60% by mass, and still more preferably in a range of 15% to 30% by mass.

The flexibility can be imparted to the protective layer by adding several mass percent of glycerin, dipropylene glycol, or the like to the above-described polymer. Further, several mass percent of an anionic surfactant such as sodium alkyl sulfate or sodium alkyl sulfonate; an amphoteric surfactant such as alkylaminocarboxylate or alkylaminodicarboxylate; or a non-ionic surfactant such as polyoxyethylene alkyl phenyl ether can be added to the above-described polymer.

For the purpose of improving oxygen blocking properties or surface protection properties of the image recording layer, it is also preferable that the protective layer contains an inorganic layered compound. Among examples of the inorganic layered compound, a fluorine-based swellable synthetic mica which is a synthetic inorganic layered compound is particularly preferable. Specifically, inorganic layered compounds described in JP2005-119273A are suitably exemplified.

The coating amount of the protective layer is preferably in a range of 0.05 to 10 $g/m^2$, more preferably in a range of 0.1 to 5 $g/m^2$ in a case where the protective layer contains an inorganic layered compound, and still more preferably in a range of 0.5 to 5 $g/m^2$ in a case where the protective layer does not contain an inorganic layered compound.

[Back coat layer]

The planographic printing plate precursor of the present invention may be provided with a back coat layer on the rear surface of the support as necessary. As the back coat layer, a coating layer formed of a metal oxide obtained by hydrolyzing and polycondensing an organic polymerizable compound described in JP1993-45885A (JP-H05-45885A) and an organic metal compound or an inorganic metal compound described in JP1994-35174A (JP-H06-35174A) is suitably exemplified. Among these, from the viewpoints of inexpensive raw materials and easily obtaining the raw materials, it is preferable to use an alkoxy compound of silicon such as $Si(OCH_3)_4$, $Si(OC_2H_5)_4$, $Si(OC_3H_7)_4$, or $Si(OC_4H_9)_4$.

[Organic-inorganic hybrid particles]

The present invention relates to an organic-inorganic hybrid particle in which an inorganic particle (a) containing a hydroxyl group and an organic component (b) are linked to each other through a linking group (c) having a urethane bond or a urea bond, and the organic component (b) is linked to at least two inorganic particles (a) and the inorganic particle (a) is linked to at least two organic components (b) so that the organic components (b) and the inorganic particles (a) form a network structure.

The detailed description of the organic-inorganic hybrid particle is as described above. In the organic-inorganic hybrid particle of the present invention, it is preferable that the organic component (b) is a reaction product between polyfunctional isocyanate (d) and a compound having active hydrogen atoms (e). Further, it is preferable that the organic component (b) has a repeating unit represented by formula (1). Further, it is preferable that the organic-inorganic hybrid particle of the present invention further contains a radical polymerizable group. In addition, the particle diameter of the organic-inorganic hybrid particle of the present invention is in a range of 0.01 to 20 μm.

[Method of producing planographic printing plate]

A planographic printing plate can be produced by image-exposing the planographic printing plate precursor of the present invention and performing a development treatment.
A method of preparing a planographic printing plate according to a first preferred embodiment of the present invention is a method of preparing a planographic printing plate in which the planographic printing plate precursor of the present invention is exposed and an unexposed portion is removed using a developer having a pH of 2 to 12.
A method of preparing a planographic printing plate according to a second preferred embodiment of the present invention is a method of preparing a planographic printing plate in which the planographic printing plate precursor of the present invention is exposed and an unexposed portion is removed using at least one of printing ink or dampening water on a printing press.
Hereinafter, preferred aspects of each step in the method of preparing the planographic printing plate of the present invention will be sequentially described.

<Exposing step>

The method of preparing the planographic printing plate of the present invention includes an exposing step of exposing the planographic printing plate precursor of the present invention. It is preferable that the planographic printing plate precursor of the present invention is image-exposed by laser exposure through a transparent original picture having a line image, a halftone image, and the like or by laser beam scanning using digital data.
The wavelength of a light source is preferably in a range of 750 to 1400 nm. As the light source having a wavelength of 750 to 1400 nm, a solid-state laser or a semiconductor laser that radiates infrared rays is suitable. The output of the infrared laser is preferably 100 mW or greater, the exposure time per one pixel is preferably less than 20 microseconds, and the irradiation energy quantity is preferably in a range of 10 to 300 $mJ/cm^2$. For the purpose of reducing the exposure time, it is preferable to use a multi-beam laser device. The exposure mechanism may be any of an internal drum system, an external drum system, and a flat bed system.
The image exposure can be performed using a plate setter according to a conventional method. In a case of the on-press development, the planographic printing plate precursor is mounted on the printing press, and image exposure may be performed on the printing press.

<Developing step>

The development treatment can be performed according to a method (1) (developer treatment system) of removing an unexposed portion using a developer having a pH of 2 to 14 (preferably in a range of 2 to 12) or a method (2) (on-press development system) of removing an unexposed portion using at least one of printing ink or dampening water on the printing press.

(Developer treatment system)

In the developer treatment system, the image-exposed planographic printing plate precursor is treated by a developer having a pH of 2 to 14 and an unexposed portion is removed, thereby preparing a planographic printing plate.
In the development treatment using a high alkaline developer (pH of 12 or greater), the protective layer is removed by performing a pre-water washing step, alkali development is performed, an alkali is removed by washing the precursor with water in a post-water washing step, and the precursor is subjected to a gum liquid treatment and dried in a drying step, thereby preparing a planographic printing plate.
According to the first preferred aspect of the present invention, a developer having a pH of 2 to 12 is used. That is, according to this aspect, the image recording layer is formed by the unexposed portion being removed by the developer having a pH of 2 to 12. According to this aspect, it is preferable that the developer contains a surfactant or a water-soluble polymerizable compound. With this configuration, development and the gum liquid treatment can be performed at the same time. Therefore, the post-water washing step is not particularly required, the development and the gum liquid treatment can be performed using one liquid.
Further, the pre-water washing step is not particularly required so that the protective layer can be removed simultaneously with the development and the gum liquid treatment. According to the method of preparing the planographic printing plate of the present invention, it is preferable that the excess developer is removed using a squeeze roller after the development and the gum treatment and then the drying is performed.
The developer treatment can be performed on the planographic printing plate precursor of the present invention under a temperature condition of 0°C to 60°C and preferably 15°C to 40°C according to a conventional method such as a method of immersing the planographic printing plate precursor which has been subjected to an exposure treatment

in a developer and rubbing the precursor with a brush; or a method of spraying a developer to the precursor using a spray and rubbing the precursor with a brush.

The development treatment using a developer can be suitably performed using an automatic development treatment device provided with supply means for supplying the developer and a rubbing member. As the rubbing member, an automatic development treatment device using a rotary brush roll is particularly preferable. Further, it is preferable that the automatic development treatment device includes means for removing the excess developer such as a squeeze roller; and drying means such as a hot air device, on the rear side of the development treatment means. In addition, the automatic development treatment device may further include pre-heating means for performing a heat treatment on the image-exposed planographic printing plate precursor, in front of the development treatment means.

The developer used for the developer treatment of the present invention contains an aqueous solution having a pH of 2 to 14 or a surfactant. As the developer, an aqueous solution having water as a main component (containing 60% by mass or greater of water) is preferable; and an aqueous solution containing a surfactant (an anionic surfactant, a non-ionic surfactant, a cationic surfactant, or an amphoteric surfactant) or an aqueous solution containing a water-soluble polymerizable compound is particularly preferable. In addition, an aqueous solution containing both of a surfactant and a water-soluble polymerizable compound is also preferable. The pH of the developer is more preferably in a range of 2 to 12, still more preferably in a range of 3.5 to 12, particularly preferably in a range of 6 to 12, and most preferably in a range of 6.5 to 10.5.

The anionic surfactant used for the developer in the present invention is not particularly limited, and examples thereof include fatty acid salts, abietic acid salts, hydroxy alkanes sulfonic acid salts, alkane sulfonic acid salts, dialkyl sulfosuccinic acid salts, linear alkyl benzene sulfonic acid salts, branched alkyl benzene sulfonic acid salts, alkyl naphthalene sulfonic acid salts, alkyl diphenyl ether (di)sulfonic acid salts, alkyl phenoxy polyoxyethylene alkyl sulfonic acid salts, polyoxyethylene alkyl sulfophenyl ether salts, N-alkyl-N-oleyltaurine sodium salts, disodium N-alkyl sulfosuccinic acid monoamide disodium salts, petroleum sulfonates, sulfated castor oil, sulfated beef tallow oil, sulfuric acid ester salts of fatty acid alkyl ester, alkyl sulfuric acid ester salts, polyoxyethylene alkyl ether sulfuric acid ester salts, fatty acid monoglyceride sulfuric acid ester salts, polyoxyethylene alkyl phenyl ether sulfuric acid ester salts, polyoxyethylene styryl phenyl ether sulfuric acid ester salts, alkyl phosphoric acid ester salts, polyoxyethylene alkyl ether phosphoric acid ester salts, polyoxyethylene alkyl phenyl ether phosphoric acid ester salts, partially saponification products of a styrene-maleic anhydride copolymer, partially saponification products of an olefin-maleic anhydride copolymer, and naphthalene sulfonate formalin condensates. Among these, alkyl benzene sulfonates, alkyl naphthalene sulfonates, and alkyl diphenyl ether (di)sulfonates are particularly preferably used.

The cationic surfactant used for the developer in the present invention is not particularly limited, and conventionally known surfactants can be used. Examples of the known cationic surfactants include alkylamine salts, quaternary ammonium salts, alkyl imidazolinium salts, polyoxyethylene alkylamine salts, and polyethylene polyamine derivatives.

The non-ionic surfactant used for the developer in the present invention is not particularly limited, and examples thereof include a polyethylene glycol type higher alcohol ethylene oxide adduct, an alkyl phenol ethylene oxide adduct, an alkyl naphthol ethylene oxide adduct, a phenol ethylene oxide adduct, a naphthol ethylene oxide adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of fat and oil, a polypropylene glycol ethylene oxide adduct, a dimethylsiloxane-ethylene oxide block copolymer, a dimethylsiloxane-(propylene oxide-ethylene oxide) block copolymer, a fatty acid ester of polyhydric alcohol type glycerol, a fatty acid ester of pentaerythritol, a fatty acid ester of sorbitol and sorbitan, a fatty acid ester of sucrose, alkyl ether of polyhydric alcohol, and fatty acid amides of alkaneamines. Among these, those having an aromatic ring and an ethylene oxide chain are preferable and an alkyl-substituted or unsubstituted phenol ethylene oxide adduct or an alkyl-substituted or unsubstituted naphthol ethylene oxide adduct is more preferable.

The amphoteric surfactant used for the developer in the present invention is not particularly limited, and examples thereof include an amine oxide-based surfactant such as alkyl dimethylamine oxide, a betaine-based surfactant such as alkyl betaine, and an amino acid-based surfactant such as sodium alkylamino fatty acid. Among these, particularly, alkyl dimethylamine oxide which may have a substituent, alkyl carboxy betaine which may have a substituent, and alkyl sulfobetaine which may have a substituent are preferably used. Specifically, compounds represented by Formula (2) in paragraph [0256] of JP2008-203359A, compounds represented by Formulae (I), (II), an (VI) in paragraph [0028] of JP2008-276166A, and compounds described in paragraphs [0022] to [0029] of JP2009-47927A can be used.

Two or more of the above-described surfactants may be used in the developer. The content of the surfactant contained in the developer is preferably in a range of 0.01% to 20% by mass and more preferably in a range of 0.1% to 10% by mass.

Examples of the water-soluble polymerizable compound used for the developer in the present invention include soy polysaccharides, modified starch, gum arabic, dextrin, fiber derivatives (such as carboxymethyl cellulose, carboxyethyl cellulose, and methyl cellulose) and modified products thereof, pullulan, polyvinyl alcohol and a derivative thereof, polyvinylpyrrolidone, a polyacrylamide and acrylamide copolymer, a vinyl methyl ether-maleic anhydride copolymer, a

vinyl acetate-maleic anhydride copolymer, a styrene-maleic anhydride copolymer, polyvinylsulfonic acid and a salt thereof, and polystyrenesulfonic acid and a salt thereof.

Known soy saccharides can be used as the above-described soy saccharides, and commercially available products thereof include SOYAFIBE (product name, manufactured by FUJI OIL CO., LTD.) and various grades of products can be used. Products which can be preferably used are those in which the viscosity of a 10 mass% aqueous solution is in a range of 10 to 100 mPa/sec.

Known modified starch can be used as the above-described modified starch, and the modified starch can be produced according to a method of decomposing starch such as corn, potato, tapioca, rice, or wheat in a range of 5 to 30 glucose residues per molecule with an acid or an oxygen and adding oxypropylene to an alkali.

The water-soluble polymerizable compound can be used in combination of two or more kinds thereof in the developer. The content of the water-soluble polymerizable compound in the developer is preferably in a range of 0.1% to 20% by mass and more preferably in a range of 0.5% to 10% by mass.

The developer used in the present invention may contain a pH buffer. Any buffer can be used for the developer of the present invention without limitation as long as the buffer exhibits a buffering action at a pH of 2 to 14. In the present invention, weak alkaline buffers are preferably used, and examples thereof include a carbonate ion and a bicarbonate ion (a); a borate ion (b); a water-soluble amine compound and an ion of the amine compound (c); and a combination of these. That is, for example, a combination of the carbonate ion and the bicarbonate ion (a), the borate ion (b), or a combination of the water-soluble amine compound and the ion of the amine compound (c) are capable of exhibiting the pH buffering action in the developer, suppressing a fluctuation in pH even in a case where the developer is used for a long time, and thus suppressing degradation of developability due to the fluctuation in pH and generation of development gas. According to the method of producing the planographic printing plate of the present invention, a combination of a carbon ion and a bicarbonate ion is particularly preferable.

In order for a carbonate ion and a bicarbonate ion to exist in the developer, a carbonate and a bicarbonate may be added to the developer and the pH of the developer is adjusted after a carbonate or a bicarbonate is added to the developer so as to generate a carbon ion and a bicarbonate ion. The carbonate and the bicarbonate are not particularly limited, but an alkali metal salt is preferable. Examples of the alkali metal include lithium, sodium, and potassium. Among these, sodium is particularly preferable. The alkali metal may be used alone or in combination of two or more kinds thereof.

The total amount of the carbon ion and the bicarbonate ion is preferably in a range of 0.05 to 5 mol/L, more preferably in a range of 0.07 to 2 mol/L, and particularly preferably in a range of 0.1 to 1 mol/L with respect to the amount of the developer.

The developer of the present invention may contain an organic solvent. Examples of the organic solvent which can be contained in the developer include aliphatic hydrocarbons (such as hexane, heptane, ISOPAR E, ISOPAR H, and ISOPAR G (manufactured by Exxon Chemical Co., Ltd.)), aromatic hydrocarbons (such as toluene and xylene), and halogen hydrocarbons (such as methylene dichloride, ethylene dichloride, trichlene, and monochlorobenzene), and polar solvents. Examples of the polar solvents include alcohols (methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethoxy ethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol, and methyl amyl alcohol), ketones (such as acetone, methyl ethyl ketone, ethyl butyl ketone, methyl isobutyl ketone, and cyclohexanone), esters (ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethylene phthalate, and butyl levulinate), and others (such as triethyl phosphate, tricresyl phosphate, N-phenyl ethanolamine, N-phenyl diethanolamine, N-methyl diethanolamine, N-ethyl diethanolamine, 4-(2-hydroxyethyl)morpholine, N,N-dimethylacetamide, N-methylpyrrolidone, and N-ethyl-2-pyrrolidone).

The organic solvent contained in the developer can be used in combination of two or more kinds thereof. In a case where the organic solvent is insoluble in water, the solvent can be made to be solubilized in water using a surfactant and then used. In a case where the developer contains an organic solvent, from the viewpoints of safety and infammability, it is desired that the concentration of the organic solvent is less than 40% by mass.

The developer of the present invention may contain a preservative, a chelate compound, an antifoaming agent, an organic acid, an inorganic acid, and an inorganic salt, in addition to the above-described components. Specifically, compounds described in paragraphs [0266] to [0270] of JP2007-206217A can be preferably used.

The developer of the present invention can be used as a developer and a development replenisher of the exposed planographic printing plate precursor. Further, the developer can be preferably applied to the automatic development treatment device described above. In a case where development is carried out using the automatic development treatment device, since the developer becomes fatigued according to the treatment capacity, the treatment capability may be recovered using a replenisher or a new developer.

<On-press development system>

In the on-press development system, the image-exposed planographic printing plate precursor supplies at least one of printing ink or dampening water on a printing press and an unexposed portion is removed, thereby preparing a planographic printing plate. In other words, according to this aspect, the image recording layer is formed by removing the unexposed portion using at least one of printing ink or dampening water on the printing press after exposure.

According to this aspect, in a case where the planographic printing plate is exposed and then mounted on a printing press without performing any development treatment or the planographic printing plate precursor is mounted on a printing press, exposed on the printing press, and supplies printing ink and dampening water for printing, an uncured image recording layer is dissolved or dispersed and then removed by at least one of the supplied printing ink or dampening water in the unexposed portion at the initial stage of printing, and the hydrophilic surface is exposed to the removed portion. In addition, in the exposed portion, the image recording layer cured due to exposure forms an oily ink receiving portion having a lipophilic surface. In place of printing ink, dampening water may be initially supplied to the plate surface, but it is preferable that printing ink is initially supplied to the plate surface from a viewpoint of preventing contamination of dampening water by the removed image recording layer components. In this manner, the planographic printing plate precursor is subjected to on-press development on the printing press and used as it is for a plurality of sheets of printing.

In the method of producing a planographic printing plate from the planographic printing plate precursor of the present invention, regardless of the development system, the entire surface of the planographic printing plate precursor may be heated before exposure, during exposure, or between exposure and development as necessary. In a case where the entire surface thereof is heated, the image forming reaction in the image recording layer is promoted so that the sensitivity or the printing durability is improved and the sensitivity is stabilized. Further, in a case of the developer treatment system, it is also effective to perform post-heating or exposure of the entire surface with respect to the image which has been subjected to the development treatment for the purpose of improving the image strength or the printing durability. It is preferable that the heating before development is typically performed under a mild temperature condition of 150°C or lower. In a case where the temperature is extremely high, a problem of a non-image area being cured may occur. Extremely strong conditions are used for the heating after development. The temperature is typically in a range of 100°C to 500°C. An image-strengthening action is not sufficiently obtained in a case where the temperature is low, and problems of deterioration of the support and thermal decomposition of the image area may occur in a case where the temperature is extremely high.

Examples

Hereinafter, the features of the present invention will be described in detail with reference to examples. The materials, the amounts to be used, the proportions, the treatment contents, and the treatment procedures can be changed as appropriate within a range not departing from the gist of the present invention. Accordingly, the scope of the present invention should not be limitatively interpreted by the specific examples described below.

In the polymerizable compound, the molecular weight is a mass average molar mass (Mw) in terms of polystyrene according to a GPC method and the ratio of repeating units is a molar percentage unless otherwise specified.

[Synthesis Examples]

(Synthesis Example 1)

As inorganic particles containing a hydroxyl group, methyl ethyl ketone (MEK) dispersed particles (LIGHT STAR LA-OS263BK, particle diameter of 300 nm, manufactured by Nissan Chemical Industries, Ltd.) were used. 20 g of a MEK dispersion liquid (25% by mass) containing silica particles was weighed, and MEK was distilled off under reduced pressure. After 50 g of toluene and 10 mg of 2,2,6,6-tetramethylpiperidine-1-oxyl were added thereto, 4.65 g (30 mmol) of 2-isocyanatoethyl methacrylate was added as a coupling agent for organic modification. Further, 50 mg of bismuth tris(2-ethylhexanoate) (NEOSTANN U-600, manufactured by Nitto Kasei Co., Ltd.) was added thereto, and the solution was stirred at 80°C for 20 hours. The solution was cooled to room temperature, and the silica particles were precipitated by centrifugation to remove the supernatant. A 20 mass% ethyl acetate solution containing organic-inorganic hybrid particles S-1 was obtained by repeating the operation of adding 50 g of ethyl acetate to the solution, stirring the solution, and allowing the silica particles to be precipitated by centrifugation twice and adding 20 g of ethyl acetate to the solution. The particle diameter of the organic-inorganic hybrid particles S-1 was measured using a light scattering method, and the value was 0.32 μm.

(Synthesis Example 2)

A 20 mass% ethyl acetate solution containing organic-inorganic hybrid particles S-2 was obtained in the same manner as in Synthesis Example 1 except that 5.98 g (30 mmol) of 2-isocyanatoethoxyethyl methacrylate was used as a coupling agent. The particle diameter of the organic-inorganic hybrid particles S-2 was measured using a light scattering method, and the value was 0.33 μm.

(Synthesis Example 3 to 8)

Organic-inorganic hybrid particles S-3 to S-8 were synthesized in the same manner as in Synthesis Example 1 except that the type of inorganic particles and the type of coupling agent were changed to those listed in Table 1. The obtained particle diameters of the organic-inorganic hybrid particles are also listed in Table 1.

[Table 1]

| Used inorganic particles | | Particle diameter of used inorganic particles | Used coupling agent | Particle diameter of obtained particles (μm) |
|---|---|---|---|---|
| S-3 | Silica particles (LIGHT STAR LA-OS263BK, manufactured by Nissan Chemical Industries, Ltd.) | 300 nm | 2-Isocyanatoethyl acrylate | 0.32 |
| S-4 | Silica particles (SNOWTEX MP-2040, manufactured by Nissan Chemical Industries, Ltd.) | 170 to 230 nm | 2-Isocyanatoethyl methacrylate | 0.23 |
| S-5 | Zirconia particles (NANOUSE ZR-40BL, manufactured by Nissan Chemical Industries, Ltd.) | 90 nm | 2-Isocyanatoethyl methacrylate | 0.11 |
| S-6 | Silica particles (ORGANOSILICASOL MEK-ST-40, manufactured by Nissan Chemical Industries, Ltd.) | 10 to 15 nm | Hexamethylene diisocyanate | 0.02 |
| S-7 | Silica particles (ORGANOSILICASOL MEK-ST-40, manufactured by Nissan Chemical Industries, Ltd.) | 10 to 15 nm | Diphenylmethane diisocyanate | 0.02 |
| S-8 | Silica particles (ORGANOSILICASOL MEK-ST-L, manufactured by Nissan Chemical Industries, Ltd.) | 40 to 50 nm | Hexamethylene diisocyanate | 0.06 |

(Synthesis Example 9)

As inorganic particles containing a hydroxyl group, methyl ethyl ketone (MEK) dispersed silica particles (LIGHT STAR LA-OS263BK, manufactured by Nissan Chemical Industries, Ltd.) were used. 20 g of a MEK dispersion liquid (25% by mass) containing silica particles was weighed, and MEK was distilled off under reduced pressure. After 50 g of toluene and 10 mg of 2,2,6,6-tetramethylpiperidine-1-oxyl were added thereto, 5.0 g (21.3 mmol) of trimethoxysilylpropyl acrylate and 5.0 g (approximately 1.2 mmol) of the following compound T-1 were added as coupling agents for organic modification. Further, 100 mg of triamylamine was added to the solution, and the solution was refluxed for 12 hours. The solution was cooled to room temperature, and the silica particles were precipitated by centrifugation to remove the supernatant. Silica particles were washed by repeating the operation of adding 50 g of ethyl acetate to the solution, stirring the solution, and allowing the silica particles to be precipitated by centrifugation twice. The silica particles were washed with 50 g of distilled water in the same manner as described above, and 20 g of distilled water was added thereto, thereby obtaining a 20 mass% aqueous solution containing organic-inorganic hybrid particles S-9. The particle diameter of the organic-inorganic hybrid particles S-9 was measured using a light scattering method, and the value was 0.33 μm.

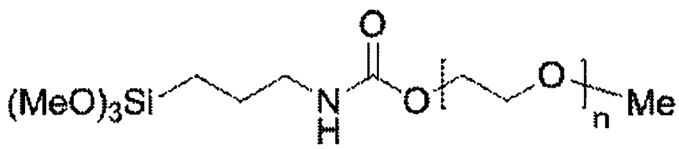

T-1 n = approximately 23

(Synthesis Examples 10 to 15 and Comparative Synthesis Example 1)

Organic-inorganic hybrid particles S-10 to S-15 and R-1 were synthesized in the same manner as in Synthesis Example 9 except that the type of inorganic particles and the type of coupling agent were changed to those listed in Table 2. Further, particles S-14 and S-15 were not prepared using 20 mass% aqueous solutions but prepared using 20 mass% ethyl acetate solutions. The obtained particle diameters of the organic-inorganic hybrid particles are also listed in Table 2.

[Table 2]

| | Used inorganic particles | Particle diameter of used inorganic particles | Used coupling agent | Particle diameter of obtained particles (μm) |
|---|---|---|---|---|
| S-10 | Silica particles (LIGHT STAR LA-OS263BK, manufactured by Nissan Chemical Industries, Ltd.) | 300 nm | 6.7 g of trimethoxysilylpropyl acrylate 3.3 g of T-1 | 0.32 |
| S-11 | Silica particles (LIGHT STAR LA-OS263BK, manufactured by Nissan Chemical Industries, Ltd.) | 300 nm | 3.3 g of trimethoxysilylpropyl acrylate 6.7 g of T-1 | 0.34 |
| S-12 | Silica particles (LIGHT STAR LA-OS263BK, manufactured by Nissan Chemical Industries, Ltd.) | 300 nm | 6.7 g of trimethoxysilylpropyl acrylate 3.3 g of T-2 | 0.35 |
| S-13 | Silica particles (LIGHT STAR LA-OS263BK, manufactured by Nissan Chemical Industries, Ltd.) | 300 nm | 6.7 g of T-3 3.3 g of T-2 | 0.34 |
| S-14 | Silica particles (ORGANOSILICASOL MEK-ST-40, manufactured by Nissan Chemical Industries, Ltd.) | 10 to 15 nm | 5.0 g of trimethoxysilylpropylamine | 0.02 |
| S-15 | Silica particles (ORGANOSILICASOL MEK-ST-L, manufactured by Nissan Chemical Industries, Ltd.) | 40 to 50 nm | 5.0 g of trimethoxysilylpropylamine | 0.06 |
| R-1 | Silica particles (LIGHT STAR LA-OS263BK, manufactured by Nissan Chemical Industries, Ltd.) | 300 nm | 5.0 g of trimethoxysilylpropyl acrylate | 0.31 |

The compound T-1 in the table above is as described above and the compounds T-2 and T-3 are as described below.

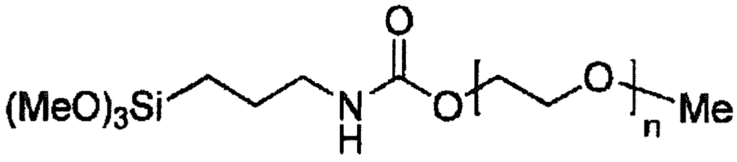

n= approximately 90

T-2

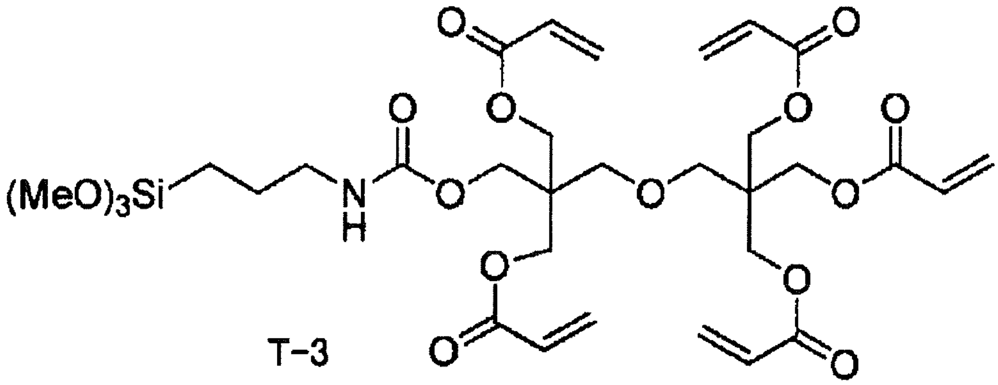

T-3

Structures of linking group components and organic components of organic-inorganic hybrid particles S-1 to S-15 and R-1 are shown below. In the following table, O* represents an oxygen atom derived from a hydroxyl group contained in inorganic particles.

(S-1)

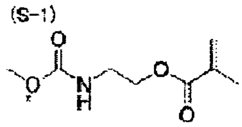

(S-2)

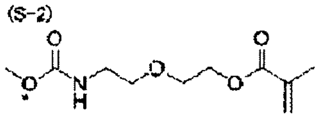

(S-3)

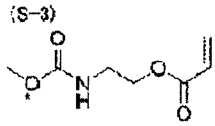

(S-4)

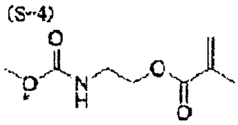

(S-5)

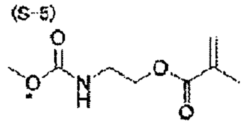

(S-6)

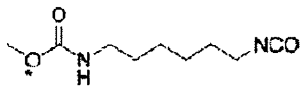

(S-7)

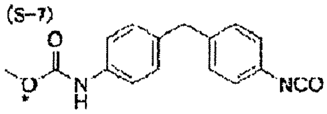

(S-8)

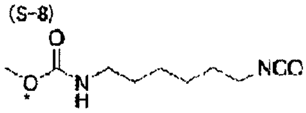

(S-9)~(S-11)

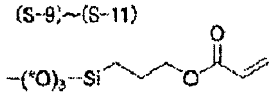

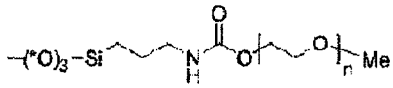

n = approximately 23

(S-12)

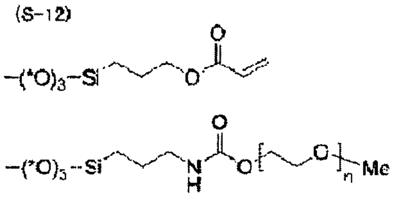

n = approximately 90

(S-13)

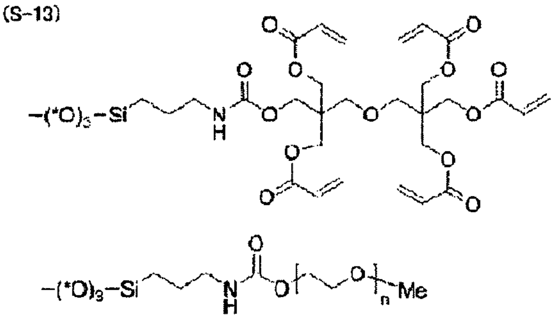

n = approximately 90

(S-14)~(S-15)

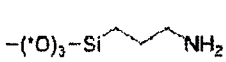

(R-1)

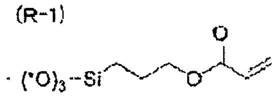

(Synthesis Example 16: synthesis of polyisocyanate adduct NCO-1)

170 mg of bismuth tris(2-ethylhexanoate) (NEOSTANN U-600, manufactured by Nitto Kasei Co., Ltd.) was added to an ethyl acetate (101.25 g) suspension containing 71.13 g (0.32 mol) of isophorone diisocyanate (IPDI) and 30.12 g (0.08 mol) of a compound (the following structure P-1) having at least two active hydrogen atoms, and the solution was stirred. At the time of heat generation being ceased, the reaction temperature was set to 50°C and the solution was stirred for 3 hours. An ethyl acetate solution (50% by mass) containing a polyvalent isocyanate adduct (NCO-1) was obtained by performing the above-described operation.

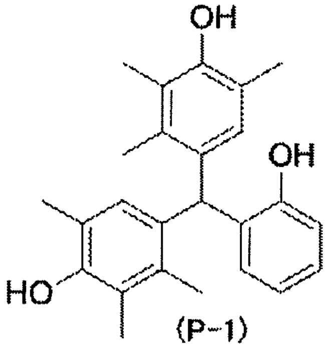

(P-1)

(Synthesis Examples 17 to 33: synthesis of polyvalent isocyanate adducts NCO-2 to NOC-18)

Solutions containing polyvalent isocyanate adducts (NCO-2 to NCO-18) were obtained according to the same method as in Synthesis Example 16 except that the compound P-1 and isophorone diisocyanate were respectively changed to a compound P having at least two active hydrogen atoms and a polyvalent isocyanate compound I, listed in Table 3, in Synthesis Example 16.

[Table 3]

| | Polyvalent isocyanate adduct | Compound P having at least two active hydrogen atoms | Polyvalent isocyanate compound I | P/I (molar ratio) |
|---|---|---|---|---|
| Synthesis Example 17 | NCO-2 | P-2 | IPDI | 1/4 |
| Synthesis Example 18 | NCO-3 | P-3 | IPDI | 1/4 |

(continued)

| | Polyvalent isocyanate adduct | Compound P having at least two active hydrogen atoms | Polyvalent isocyanate compound I | P/I (molar ratio) |
|---|---|---|---|---|
| Synthesis Example 19 | NCO-4 | P-4 | IPDI | 1/4 |
| Synthesis Example 20 | NCO-5 | P-5 | IPDI | 1/4 |
| Synthesis Example 21 | NCO-6 | P-6 | IPDI | 1/4 |
| Synthesis Example 22 | NCO-7 | P-7 | IPDI | 1/4 |
| Synthesis Example 23 | NCO-8 | P-8 | IPDI | 1/4 |
| Synthesis Example 24 | NCO-9 | P-9 | IPDI | 1/4 |
| Synthesis Example 25 | NCO-10 | P-10 | IPDI | 1/4 |
| Synthesis Example 26 | NCO-11 | P-11 | IPDI | 1/4 |
| Synthesis Example 27 | NCO-12 | P-12 | IPDI | 1/4 |
| Synthesis Example 28 | NCO-13 | P-13 | IPDI | 1/4 |
| Synthesis Example 29 | NCO-14 | P-14 | IPDI | 1/4 |
| Synthesis Example 30 | NCO-15 | P-1 | m-Xylylene diisocyanate | 1/4 |
| Synthesis Example 31 | NCO-16 | P-9 | Diphenylmethane diisocyanate | 1/4 |
| Synthesis Example 32 | NCO-17 | P-10 | Hexamethylene diisocyanate | 1/4 |
| Synthesis Example 33 | NCO-18 | P-11 | 1,3-Bis(isocyanatomethyl) cyclohexane | 1/4 |

The compounds P-2 to P-14 in the table above are as follows.

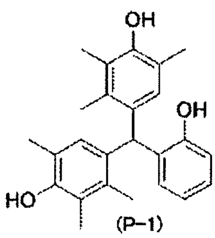
(P-1)

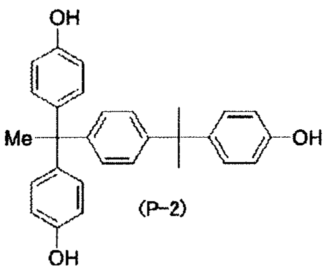
(P-2)

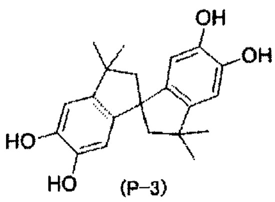
(P-3)

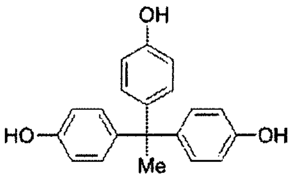

(P-4)

Nippon Nyukazai Co., Ltd.
TMP-60

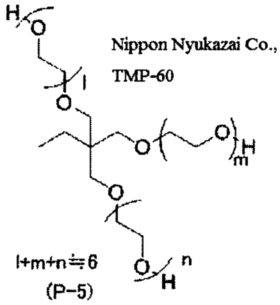

l+m+n≒6

(P-5)

Mitsui Chemicals, Inc.
ACTOCOL IR-96

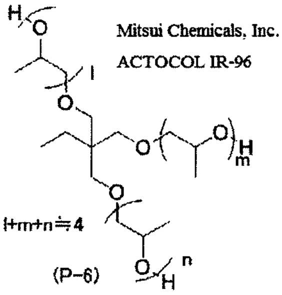

l+m+n≒4

(P-6)

DAICEL CORPORATION
PLACCEL 320

l+m+n≒4

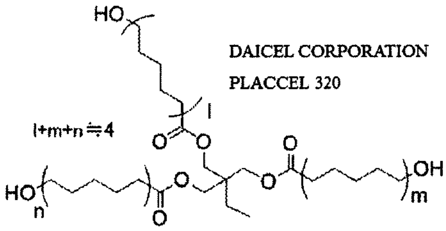

(P-7)

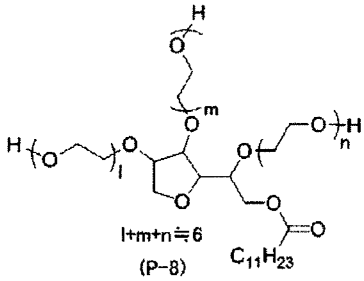

l+m+n≒6

(P-8)

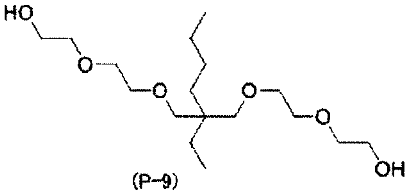

(P-9)

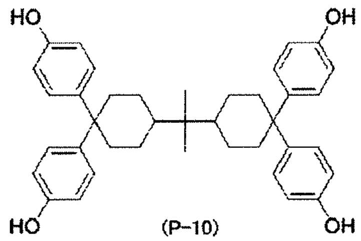

(P-10)

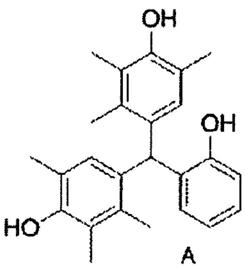

A

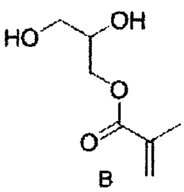

B

A / B = 8 / 2 (Molar ratio)

(P-11)

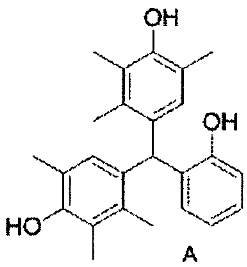

A

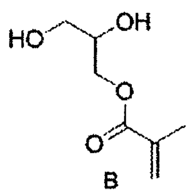

B

A / B = 6 / 4 (Molar ratio)

(P-12)

Nippon Nyukazai Co., Ltd.
TMP-60

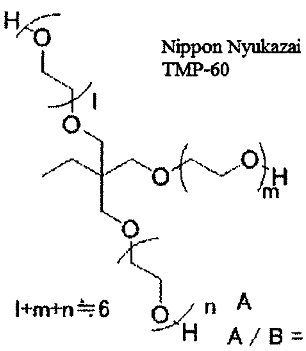

l+m+n≒6

A

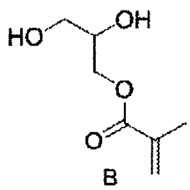

B

A / B = 6 / 4 (Molar ratio)

(P-13)

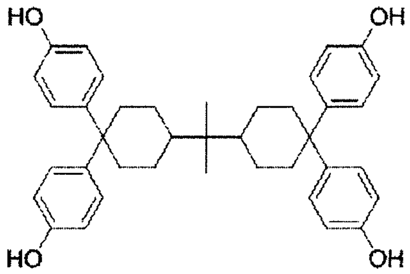

NOF CORPORATION
BLEMMER PP-800

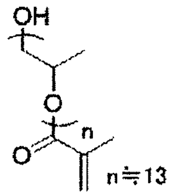

A B
A / B = 6 / 4 (Molar ratio)

(P-14)

(Synthesis Example 34: synthesis of organic-inorganic hybrid particles S-16)

The oil phase components and the water phase components described below were mixed and emulsified at 12000 rpm for 10 minutes using a homogenizer. The obtained emulsified product was stirred at 45°C for 4 hours, 5.20 g of a 10 mass% aqueous solution containing U-CAT SA102 (1,8-diazabicyclo[5.4.0]undeca-7-ene-octylate, manufactured by San-Apro Ltd.) was added thereto, and the solution was stirred at room temperature for 30 minutes and allowed to stand at 45°C for 24 hours. The concentration of solid contents in the organic-inorganic hybrid particle solution obtained in the above-described manner was adjusted to 20% by mass using distilled water, thereby obtaining organic-inorganic hybrid particles S-16. The average particle diameter of the organic-inorganic hybrid particles S-16 was measured using a light scattering method, and the value was 0.28 μm.

(Oil phase components)

| | |
|---|---|
| (Component 1) ethyl acetate | 0.75 g |
| (Component 2) adduct (manufactured byMitsui Chemicals Inc., 50 mass% ethyl acetate solution) obtained by adding trimethylolpropane (6 mol) and xylene diisocyanate (18 mol) and then adding methyl one-terminal polyoxyethylene (1 mol, repetition number of oxyethylene units: 90) | 3.76 g |
| (Component 3) polyvalent isocyanate adduct NCO-1 (in 50 mass% ethyl acetate solution) | 7.5 g |
| (Component 4) organic-inorganic particles S-6 (in 20 mass% ethyl acetate hybrid solution) | 18.75 g |
| (Component 5) 65 mass% solution of SR-399 (dipentaerythritol pentaacrylate ester, manufactured by Sartomer Company, Inc.) in ethyl acetate | 11.54 g |
| (Component 6) 10 mass% of PIONIN A-41C (sulfonate type surfactant, manufactured by Takemoto Oil & Fat Ltd.) in ethyl acetate solution | 4.42 g |

(Water phase component)

Distilled water 46.87 g

(Synthesis Examples 35 to 62 and Comparative Synthesis Examples 2 to 7: synthesis of organic-inorganic hybrid particles S-17 to S-44 and R-2 to R-7)

Organic-inorganic hybrid particles S-17 to S-44 and R-2 to R-7 were obtained in the same manner as in Synthesis Example 34 except that the types of used components 1 and 3 to 5 and the addition amounts were changed to those, listed in Table 4, in Synthesis Example 34.

[Table 4]

| | Particles | Used component 1 | | Used component 3 | | Used component 4 | | Used component 5 | | Particle diameter of obtained particles (μm) |
|---|---|---|---|---|---|---|---|---|---|---|
| Synthesis Example 34 | S-16 | Ethyl acetate | 0.75 g | NCO-1 | 7.5 g | S-6 | 18.75 g | SR-399 | 11.54 g | 0.28 |
| Synthesis Example 35 | S-17 | - | - | NCO-1 | 6.0 g | S-6 | 22.50 g | SR-399 | 11.54 g | 0.32 |
| Synthesis Example 36 | S-18 | Ethyl acetate | 3.00 g | NCO-1 | 9.0 g | S-6 | 15.00 g | SR-399 | 11.54 g | 0.29 |
| Synthesis Example 37 | S-19 | Ethyl acetate | 0.75 g | NCO-1 | 7.5 g | S-7 | 18.75 g | SR-399 | 11.54 g | 0.30 |
| Synthesis Example 38 | S-20 | Ethyl acetate | 0.75 g | NCO-1 | 7.5 g | S-8 | 18.75 g | SR-399 | 11.54 g | 0.35 |
| Synthesis Example 39 | S-21 | Ethyl acetate | 0.75 g | NCO-1 | 7.5 g | S-14 | 18.75 g | SR-399 | 11.54 g | 0.31 |
| Synthesis Example 40 | S-22 | Ethyl acetate | 0.75 g | NCO-1 | 7.5 g | S-15 | 18.75 g | SR-399 | 11.54 g | 0.36 |
| Synthesis Example 41 | S-23 | Ethyl acetate | 0.75 g | NCO-2 | 7.5 g | S-6 | 18.75 g | SR-399 | 11.54 g | 0.28 |
| Synthesis Example 42 | S-24 | Ethyl acetate | 0.75 g | NCO-3 | 7.5 g | S-6 | 18.75 g | SR-399 | 11.54 g | 0.26 |
| Synthesis Example 43 | S-25 | Ethyl acetate | 0.75 g | NCO-4 | 7.5 g | S-6 | 18.75 g | SR-399 | 11.54 g | 0.27 |
| Synthesis Example 44 | S-26 | Ethyl acetate | 0.75 g | NCO-5 | 7.5 g | S-6 | 18.75 g | SR-399 | 11.54 g | 0.30 |
| Synthesis Example 45 | S-27 | Ethyl acetate | 0.75 g | NCO-6 | 7.5 g | S-6 | 18.75 g | SR-399 | 11.54 g | 0.23 |
| Synthesis Example 46 | S-28 | Ethyl acetate | 0.75 g | NCO-7 | 7.5 g | S-6 | 18.75 g | SR-399 | 11.54 g | 0.25 |
| Synthesis Example 47 | S-29 | Ethyl acetate | 0.75 g | NCO-8 | 7.5 g | S-6 | 18.75 g | SR-399 | 11.54 g | 0.28 |

(continued)

| | Particles | Used component 1 | | Used component 3 | | Used component 4 | | Used component 5 | | Particle diameter of obtained particles (μm) |
|---|---|---|---|---|---|---|---|---|---|---|
| Synthesis Example 48 | S-30 | Ethyl acetate | 0.75 g | NCO-9 | 7.5 g | S-6 | 18.75 g | SR-399 | 11.54 g | 0.28 |
| Synthesis Example 49 | S-31 | Ethyl acetate | 0.75 g | NCO-10 | 7.5 g | S-6 | 18.75 g | SR-399 | 11.54 g | 0.29 |
| Synthesis Example 50 | S-32 | Ethyl acetate | 8.25 g | NCO-11 | 7.5 g | S-6 | 18.75 g | - | - | 0.24 |
| Synthesis Example 51 | S-33 | Ethyl acetate | 8.25 g | NCO-12 | 7.5 g | S-6 | 18.75 g | - | - | 0.28 |
| Synthesis Example 52 | S-34 | Ethyl acetate | 8.25 g | NCO-13 | 7.5 g | S-6 | 18.75 g | - | - | 0.31 |
| Synthesis Example 53 | S-35 | Ethyl acetate | 8.25 g | NCO-14 | 7.5 g | S-6 | 18.75 g | - | - | 0.29 |
| Synthesis Example 54 | S-36 | Ethyl acetate | 0.75 g | NCO-15 | 7.5 g | S-6 | 18.75 g | SR-399 | 11.54 g | 0.28 |
| Synthesis Example 55 | S-37 | Ethyl acetate | 0.75 g | NCO-16 | 7.5 g | S-7 | 18.75 g | SR-399 | 11.54 g | 0.28 |
| Synthesis Example 56 | S-38 | Ethyl acetate | 0.75 g | NCO-17 | 7.5 g | S-6 | 18.75 g | SR-399 | 11.54 g | 0.26 |
| Synthesis Example 57 | S-39 | Ethyl acetate | 8.25 g | NCO-18 | 7.5 g | S-6 | 18.75 g | - | - | 0.29 |
| Synthesis Example 58 | S-40 | Ethyl acetate | 4.79 g | NCO-1 | 7.5 g | S-6 | 18.75 g | Compound T-4 described below | 7.50 g | 0.30 |
| Synthesis Example 59 | S-41 | Ethyl acetate | 4.79 g | NCO-1 | 7.5 g | S-6 | 18.75 g | Compound T-5 described below | 7.50 g | 0.29 |
| Synthesis Example 60 | S-42 | Ethyl acetate | 4.79 g | NCO-1 | 7.5 g | S-6 | 18.75 g | Compound T-6 described below | 7.50 g | 0.26 |
| Synthesis Example 61 | S-43 | Ethyl acetate | 4.50 g | IPDI | 3.75 g | S-6 | 18.75 g | SR-399 | 11.54 g | 0.28 |

(continued)

| | Particles | Used component 1 | | Used component 3 | | Used component 4 | | Used component 5 | | Particle diameter of obtained particles (μm) |
|---|---|---|---|---|---|---|---|---|---|---|
| Synthesis Example 62 | S-44 | Ethyl acetate | 4.50 g | Compound T-7 described below | 3.75 g | S-6 | 18.75 g | SR-399 | 11.54 g | 0.27 |
| Comparative Synthesis Example 2 | R-2 | Ethyl acetate | 12.00 g | NCO-1 | 15.0 g | - | - | SR-399 | 11.54 g | 0.28 |
| Comparative Synthesis Example 3 | R-3 | Ethyl acetate | 12.00 g | NCO-2 | 15.0 g | - | - | SR-399 | 11.54 g | 0.29 |
| Comparative Synthesis Example 4 | R-4 | Ethyl acetate | 12.00 g | NCO-5 | 15.0 g | - | - | SR-399 | 11.54 g | 0.30 |
| Comparative Synthesis Example 5 | R-5 | Ethyl acetate | 12.00 g | NCO-7 | 15.0 g | - | - | SR-399 | 11.54 g | 0.27 |
| Comparative Synthesis Example 6 | R-6 | Ethyl acetate | 12.00 g | NCO-8 | 15.0 g | - | - | SR-399 | 11.54 g | 0.26 |
| Comparative Synthesis Example 7 | R-7 | Ethyl acetate | 12.00 g | NCO-9 | 15.0 g | - | - | SR-399 | 11.54 g | 0.28 |

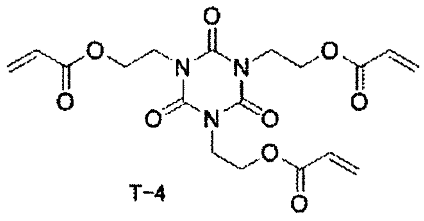

T-4

(NK ESTER A-9300, manufactured by Shin-Nakamura Chemical Co., Ltd.)

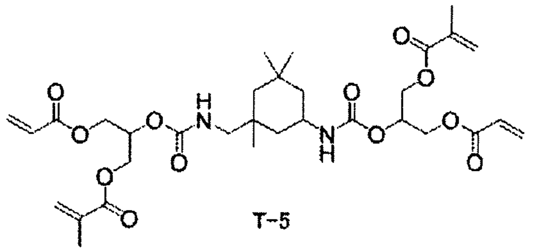

T-5

(UA-306I, manufactured by KYOEISHA CHEMICAL Co., Ltd.)

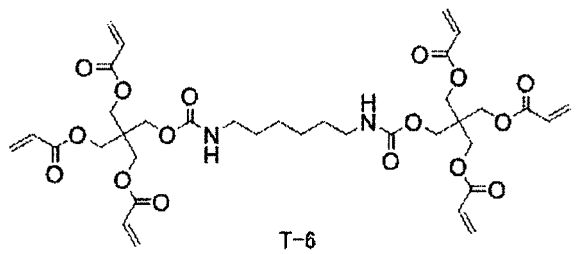

T-6

(UA-306H, manufactured by KYOEISHA CHEMICAL Co., Ltd.)

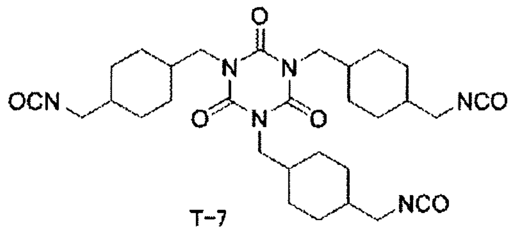

T-7

[Examples 1 to 78 and Comparative Examples 1 to 17]

1. Method A of preparing on-press development type planographic printing plate precursor (Examples 1 to 52 and Comparative Examples 1 to 9)

<Preparation of support>

In order to remove rolling oil on a surface of an aluminum plate (Material JIS A 1050) having a thickness of 0.3 mm, a degreasing treatment was performed using a 10 mass% sodium aluminate aqueous solution at 50°C for 30 seconds, the aluminum surface was grains using three bundle nylon brushes having a diameter of 0.3 mm and a pumice water suspension (specific gravity of 1.1 g/cm$^3$) having a median diameter of 25 μm and then sufficiently washed with water. This aluminum plate was immersed in a 25 mass% sodium hydroxide aqueous solution at 45°C for 9 seconds, etched, washed with water, and further immersed in a 20 mass% nitric acid aqueous solution at 60°C for 20 seconds, and then washed with water. The etching amount of the grained surface at this time was approximately 3 g/m$^2$.

Next, an electrochemical roughening treatment was continuously performed using an AC voltage of 60 Hz. As the electrolytic solution, a 1 mass% nitric acid aqueous solution (including 0.5% by mass of aluminum ions) was used at a liquid temperature of 50°C. Using a trapezoidal rectangular waveform having a time TP, until the current value reached a peak from zero, of 0.8 msec and the duty ratio of 1:1 as an AC power source waveform, the electrochemical surface-roughening treatment was performed using a carbon electrode as a counter electrode. As an auxiliary anode, ferrite was used. The current density was 30 A/dm$^2$ as the peak current value, and 5% of the current flowing from the power source was separated to an auxiliary anode. The electric quantity in the nitric acid electrolysis was 175 C/dm$^2$ when the aluminum plate was an anode. Thereafter, washing with water using a spray was performed.

Next, an electrochemical roughening treatment was performed according to the same method as the method for nitric acid electrolysis under the condition of an electric quantity of 50 C/dm$^2$ when an aluminum plate is an anode in a 0.5 mass% hydrochloric acid aqueous solution (including 0.5% by mass of aluminum ions) and an electrolytic solution at a liquid temperature of 50°C. Subsequently, washing with water using a spray was performed.

Next, 2.5 g/m$^2$ of a DC anodized film was provided on this aluminum plate at a current density of 15 A/dm$^2$ using a 15 mass% nitric acid aqueous solution (including 0.5% by mass of aluminum ions), washed with water, and then dried, thereby preparing a support A.

Thereafter, in order to ensure hydrophilicity of the non-image area, a silicate treatment was performed on the support A at 60°C for 10 seconds using a 2.5 mass% No. 3 sodium silicate aqueous solution, and then the support was washed with water, thereby obtaining a support B. The adhesion amount of Si was 10 mg/m$^2$. The center line average roughness (Ra) of the support which was measured using a needle having a diameter of 2 μm was 0.51 μm.

<Formation of undercoat layer>

Next, the support B was coated with a coating solution (1) for an undercoat layer such that the drying coating amount thereof was set to 20 $mg/m^2$, thereby preparing a support having an undercoat layer.

<Coating solution (1) for undercoat layer>

- Compound (1) for undercoat layer having structure shown below: 0.18 g
- Hydroxyethyl iminodiacetic acid: 0.10 g
- Methanol: 55.24 g
- Water: 6.15 g

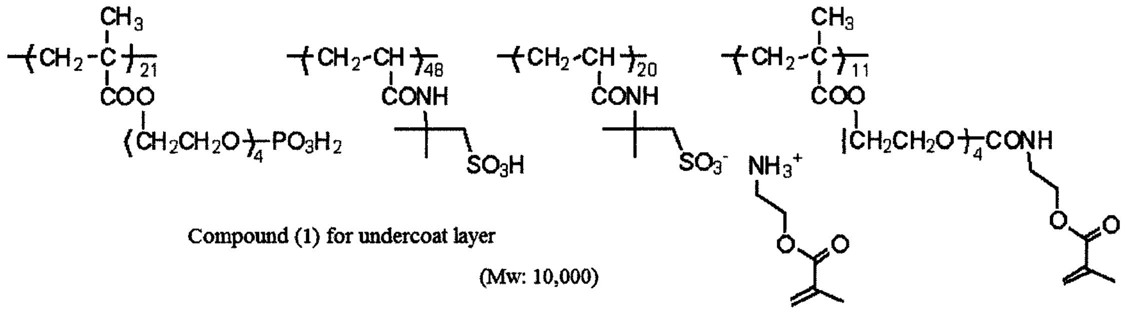

Compound (1) for undercoat layer

(Mw: 10,000)

<Formation of image recording layer>

The undercoat layer formed in the above-described manner was bar-coated with the following image recording layer coating solution (1) and dried in an oven at 100°C for 60 seconds, thereby forming an image recording layer having a drying coating amount of 1.0 $g/m^2$.

The image recording layer coating solution (1) was prepared by mixing the following photosensitive liquid and particle dispersion liquid immediately before coating and stirring the solution.

<Photosensitive liquid>

- Binder polymer (1) [the following structure] 0.240 g
- Polymerization initiator (1) 0.245 g
- Cyanine coloring agent represented by Formula (X-1) 0.023 g
- Borate compound 0.010 g
  TPB [the following structure] (in case of addition)
- Polymerizable monomer 0.192 g
  Using any of the following monomers (M-1) to (M-4)
- Low-molecular-weight hydrophilic compound 0.062 g
  Tris(2-hydroxyeth yl)isocyanurate
- Low-molecular-weight hydrophilic compound (1) [the following structure] 0.050 g
- Sensitizing agent 0.055 g
  Phosphonium compound (1) [the following structure]
- Sensitizing agent 0.018 g
  Benzyl-dimethyl-octylammonium-$PF_6$ salt
- Sensitizing agent 0.035 g
  Ammonium group-containing polymer
  [the following structure, reduced specific viscosity of 44 ml/g]
- Fluorine-based surfactant (1) [the following structure] 0.008 g
- 2-butanone 1.091 g
- 1-methoxy-2-propanol 8.609 g

<Particle dispersion liquid>

- Organic-inorganic hybrid particles S of the present invention or comparative particles R 1.980 g
- Distilled water 2.425 g

The structures of the binder polymer (1) used for the photosensitive liquid, the sensitizer represented by Formula (X-1), the fluorine-based surfactant (1), the low-molecular-weight hydrophilic compound (1), the phosphonium compound (1), the ammonium group-containing polymer, the polymerization initiator (1), the polymerizable monomers (M-1) to (M-4), and TPB are as follows.

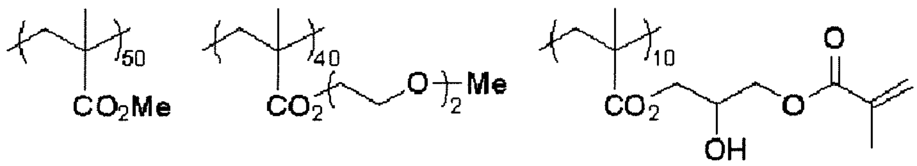

(Mw 70, 000)

Binder polymer (1)

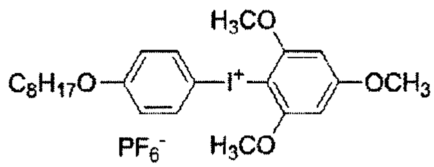

Polymerization initiator (1)

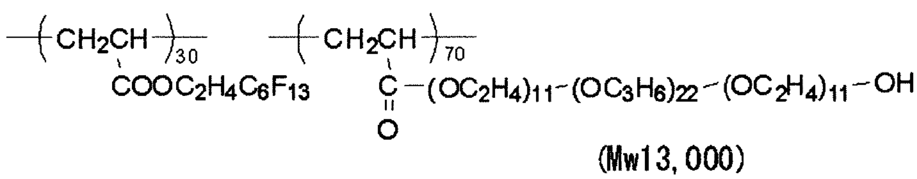

(Mw13, 000)

Fluorine-based surfactant (1)

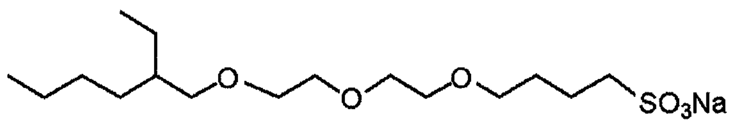

Low-molecular-weight hydrophilic compound (1)

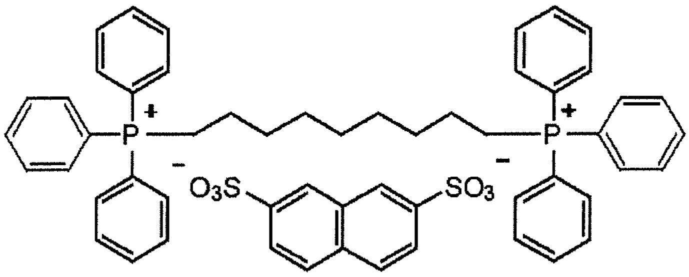

Phosphonium compound (1)

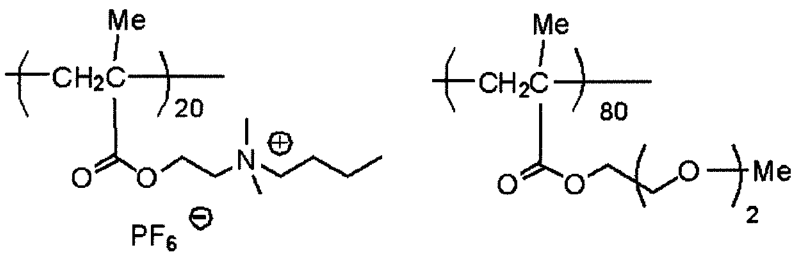

Ammonium group-containing polymer

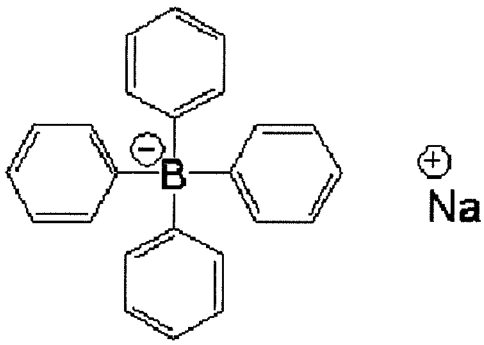

TPB

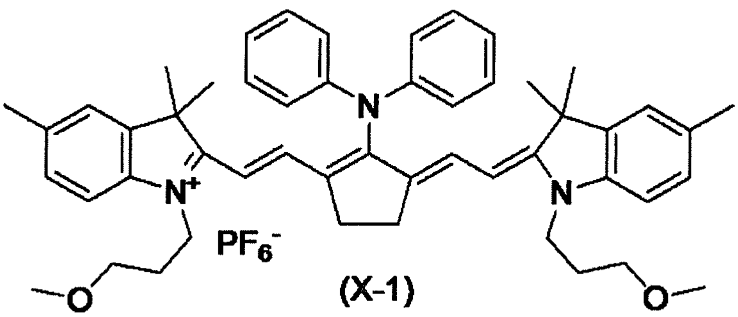

(X-1)

(Polymerizable monomer)

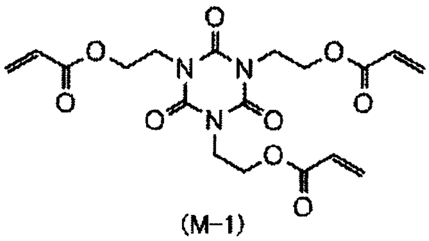

(M-1)

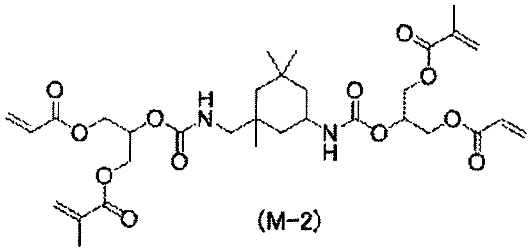

(M-2)

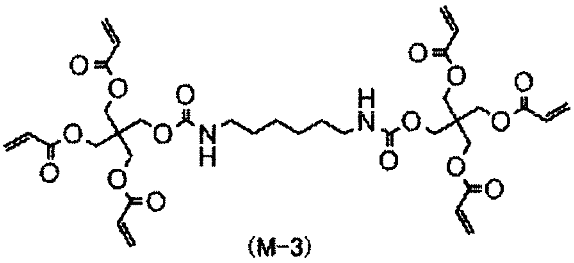

(M-3)

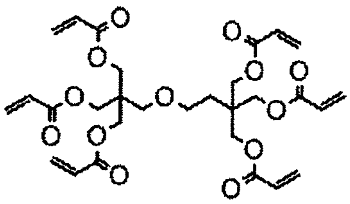

(M-4)

M-1: NK ESTER A-9300 (manufactured by Shin-Nakamura Chemical Co., Ltd.)
M-2: UA-306I (manufactured by KYOEISHA CHEMICALS Co., Ltd.)
M-3: UA-306H (manufactured by KYOEISHA CHEMICALS Co., Ltd.)
M-4: A-DPH (manufactured by Shin-Nakamura Chemical Co., Ltd.)

<Formation of protective layer>

The image recording layer was bar-coated with the following protective layer coating solution with the following composition and dried in an oven at 120°C for 60 seconds to form a protective layer having a drying coating amount of 0.15 g/$m^2$, thereby preparing planographic printing plate precursors of Examples 1 to 52 and Comparative Examples 1 to 9.

<Protective layer coating solution>

- Inorganic layered compound dispersion liquid (1) 1.5 g
- 6 mass% aqueous solution containing polyvinyl alcohol (CKS50, manufactured by Nippon Synthetic Chemical Industry Co., Ltd., sulfonic acid-modified, saponification degree: 99% by mole or greater, degree of polymerization: 300) 0.55 g
- 6 mass% aqueous solution containing polyvinyl alcohol (PVA-405, manufactured by KURARAY CO., LTD., saponification degree: 81.5% by mole, degree of polymerization: 500) 0.03 g
- Polyoxyethylene lauryl ether (surfactant, EMALEX 710, manufactured by Nihon Emulsion Co., Ltd., 1 mass% aqueous solution) 0.86 g
- Ion exchange water 6.0 g

A method of preparing the inorganic layered compound dispersion liquid (1) used for the protective layer coating solution is described below.

<Preparation of inorganic layered compound dispersion liquid (1)>

6.4 g of synthetic mica (SOMASIF ME-100, manufactured by CO-OP CHEMICAL CO., LTD.) was added to 193.6 g of ion exchange water and dispersed therein such that the average particle diameter (laser scattering method) was set to 3 μm using a homogenizer. The aspect ratio of the obtained dispersed particles was 100 or greater.

2. Method B of preparing on-press development type planographic printing plate precursors (Examples 53 to 78 and Comparative Examples 10 to 17)

Similar to the on-press development type planographic printing plate precursor A, an undercoat layer was formed on the support, the undercoat layer was bar-coated with the following image recording layer coating solution (2) with the following composition and dried in an oven at 70°C for 60 seconds to form an image recording layer having a drying coating amount of 0.6 g/$m^2$, thereby preparing planographic printing plate precursors, each of which did not have a protective layer, of Examples 53 to 78 and Comparative Examples 10 to 17.

<Image recording layer coating solution (2)>

- Cyanine coloring agent represented by Formula (X-1) 0.020 g
- Polymerization initiator (1) 0.245 g
- Borate compound 0.010 g
  TPB [the following structure] (in case of addition)
- Organic-inorganic hybrid particles S of the present invention or comparative particles R 11.0 g
- Polymerizable monomer 1.50 g
  Using any of the following monomers (M-1) to (M-4)
- Mercapto-3-triazole 0.2 g
- Byk336 (manufactured by BYK Chemie GmbH) 0.4 g
  Klucel M (manufactured by Hercules, Inc.) 4.8 g
  ELVACITE 4026 (manufactured by Ineos Acrylics Ltd.) 2.5 g
- n-Propanol 55.0 g
- 2-Butanone 17.0 g

3. Evaluation of planographic printing plate precursors

The on-press developability, impressing properties, and printing durability of the obtained planographic printing plate precursors were evaluated in the following manners.

(1) On-press developability

The planographic printing plate precursors were exposed in Luxel PLATESETTER T-6000III (manufactured by Fujifilm Corporation) equipped with an infrared semiconductor laser under conditions of external surface drum rotation speed of 1000 rpm, a laser output of 70%, and a resolution of 2,400 dpi. The exposed image had a solid image and a 50% halftone dot chart of an FM screen having dots with a diameter of 20 μm.

A printing press LITHRONE26 (manufactured by KOMORI Corporation) was attached to the plate cylinder without performing the development treatment on each of the exposed planographic printing plate precursors. Dampening water and ink were supplied using a standard automatic printing start method for LITHRONE26 using dampening water, in which the volume ratio of Ecolity-2 (manufactured by Fujifilm Corporation) to tap water was 2:98, and Values-G (N) black ink (manufactured by DIC Corporation), printing was performed on 100 sheets of Tokubishi Art (76.5 kg) paper at a printing speed of 10000 sheets per hour.

The on-press development applied to the non-image area of the image recording layer on the printing press was completed, and the number of sheets of printing paper required until the ink was not transferred to the non-image area any more was evaluated as the on-press developability. The on-press developability was excellent as the number of sheets of printing paper decreased.

(2) On-press developability over time

The on-press developability was evaluated in the same manner as described above after the planographic printing plate precursors were stored at 60°C for 3 days.

(3) Evaluation of development scum attachment

The printing press was stopped after the evaluation of on-press developability and before the evaluation of printing durability, the 100-th printed material, the ink distributing roller, the blanket, and the plate were observed whether

development scum (solid development removed material) was attached thereonto using a microscope (VHX-100, zoom lens VH-Z150, manufactured by Keyence Corporation) at a magnification of 500 times. The results were evaluated based on the following indication. The results are listed in Tables 5 to 8.

<Indication for evaluation of development scum attachment

A: Attached development scum was not found at all.
B: Development scum having a thickness of several tens of micrometers or less was slightly attached, which is in an acceptable level.
C: Development scum having a thickness of 50 μm or greater was attached, which is in an unacceptable level.
D: Development scum having a thickness of 100 μm or greater was attached and the development scum was easily confirmed with naked eye, which is poor.

(4) Printing durability

Since the photosensitive layer was gradually worn out as the number of printed sheets increased, the ink density on the printed material decreased. The timing at which the value obtained by measuring the halftone dot area ratio of 50% halftone dots of the FM screen in the printed material using a gretag densitometer was smaller than the measured value of the 100-th printed sheet by 5% was regarded as completion of printing, and the number of print copies until the printing was completed was confirmed. The relative printing durability obtained by scoring the timing at which the number of print copies until the printing was completed was 50000 as 100 points was evaluated. As the number of points increases, this indicates that the printing durability is excellent. The evaluation results are listed in Tables 5 to 8.

$$\text{Relative printing durability} = (\text{number of print copies of target precursor})/50{,}000 \times 100\ (\text{points})$$

[Table 5]

| | Method of preparing planographic printing plate precursor | Organic-inorganic hybrid particles S of the present invention or comparative particles R | Borate compound | Polymerizable monomer | On-press developability (number of sheets of paper) | On-press developability (60°C, after 3 days) (number of sheets of paper) | Development scum | Printing durability (number of points) |
|---|---|---|---|---|---|---|---|---|
| Example 1 | A | S-1 | TPB | M-1 | 40 | 45 | A | 75 |
| Example 2 | A | S-2 | TPB | M-1 | 35 | 40 | A | 76 |
| Example 3 | A | S-3 | TPB | M-1 | 35 | 40 | A | 77 |
| Example 4 | A | S-4 | TPB | M-1 | 35 | 40 | A | 79 |
| Example 5 | A | S-5 | TPB | M-1 | 40 | 45 | A | 78 |
| Example 6 | A | S-9 | TPB | M-1 | 35 | 40 | A | 78 |
| Example 7 | A | S-10 | TPB | M-1 | 35 | 40 | A | 80 |
| Example 8 | A | S-11 | TPB | M-1 | 30 | 35 | A | 75 |
| Example 9 | A | S-12 | TPB | M-1 | 30 | 35 | A | 78 |
| Example 10 | A | S-13 | TPB | M-1 | 30 | 35 | A | 81 |
| Example 11 | A | S-16 | TPB | M-1 | 35 | 35 | A | 82 |
| Example 12 | A | S-16 | TPB | M-2 | 35 | 35 | A | 86 |
| Example 13 | A | S-16 | TPB | M-3 | 35 | 35 | A | 85 |
| Example 14 | A | S-16 | TPB | M-4 | 35 | 35 | A | 81 |
| Example 15 | A | S-17 | TPB | M-1 | 35 | 40 | A | 85 |
| Example 16 | A | S-18 | TPB | M-1 | 30 | 35 | A | 78 |
| Example 17 | A | S-19 | TPB | M-1 | 35 | 35 | A | 83 |
| Example 18 | A | S-20 | TPB | M-1 | 35 | 35 | A | 80 |
| Example 19 | A | S-21 | TPB | M-1 | 30 | 35 | A | 81 |
| Example 20 | A | S-22 | TPB | M-1 | 30 | 35 | A | 79 |
| Example 21 | A | S-23 | TPB | M-1 | 35 | 40 | A | 83 |
| Example 22 | A | S-24 | TPB | M-1 | 35 | 35 | A | 82 |

(continued)

| | Method of preparing planographic printing plate precursor | Organic-inorganic hybrid particles S of the present invention or comparative particles R | Borate compound | Polymerizable monomer | On-press developability (number of sheets of paper) | On-press developability (60°C, after 3 days) (number of sheets of paper) | Development scum | Printing durability (number of points) |
|---|---|---|---|---|---|---|---|---|
| Example 23 | A | S-25 | TPB | M-1 | 30 | 35 | A | 78 |
| Example 24 | A | S-26 | TPB | M-1 | 30 | 30 | A | 78 |
| Example 25 | A | S-27 | TPB | M-1 | 30 | 30 | A | 79 |
| Example 26 | A | S-28 | TPB | M-1 | 30 | 30 | A | 81 |
| Example 27 | A | S-29 | TPB | M-1 | 30 | 30 | A | 78 |
| Example 28 | A | S-30 | TPB | M-1 | 30 | 30 | A | 75 |
| Example 29 | A | S-31 | TPB | M-1 | 35 | 40 | A | 85 |
| Example 30 | A | S-32 | TPB | M-1 | 35 | 35 | A | 89 |
| Example 31 | A | S-32 | TPB | M-2 | 35 | 35 | A | 94 |
| Example 32 | A | S-32 | TPB | M-3 | 35 | 35 | A | 92 |
| Example 33 | A | S-32 | TPB | M-4 | 35 | 35 | A | 90 |
| Example 34 | A | S-33 | TPB | M-1 | 35 | 35 | A | 86 |
| Example 35 | A | S-34 | TPB | M-1 | 30 | 35 | A | 83 |
| Example 36 | A | S-35 | TPB | M-1 | 30 | 30 | A | 90 |
| Example 37 | A | S-36 | TPB | M-1 | 35 | 35 | A | 82 |
| Example 38 | A | S-37 | TPB | M-1 | 35 | 40 | A | 79 |
| Example 39 | A | S-38 | TPB | M-1 | 35 | 40 | A | 82 |
| Example 40 | A | S-39 | TPB | M-1 | 35 | 35 | A | 87 |
| Example 41 | A | S-40 | TPB | M-1 | 35 | 35 | A | 87 |
| Example 42 | A | S-41 | TPB | M-1 | 35 | 35 | A | 88 |
| Example 43 | A | S-42 | TPB | M-1 | 35 | 35 | A | 86 |
| Example 44 | A | S-43 | TPB | M-1 | 30 | 35 | A | 76 |

(continued)

| | Method of preparing planographic printing plate precursor | Organic-inorganic hybrid particles S of the present invention or comparative particles R | Borate compound | Polymerizable monomer | On-press developability (number of sheets of paper) | On-press developability (60°C, after 3 days) (number of sheets of paper) | Development scum | Printing durability (number of points) |
|---|---|---|---|---|---|---|---|---|
| Example 45 | A | S-44 | TPB | M-1 | 35 | 35 | A | 79 |
| Comparative Example 1 | A | R-1 | TPB | M-1 | 45 | 50 | A | 65 |
| Comparative Example 2 | A | R-2 | TPB | M-1 | 35 | 40 | A | 70 |
| Comparative Example 3 | A | R-3 | TPB | M-1 | 40 | 45 | A | 71 |
| Comparative Example 4 | A | R-4 | TPB | M-1 | 35 | 40 | A | 65 |
| Comparative Example 5 | A | R-5 | TPB | M-1 | 35 | 40 | A | 68 |
| Comparative Example 6 | A | R-6 | TPB | M-1 | 40 | 45 | A | 69 |
| Comparative Example 7 | A | R-7 | TPB | M-1 | 35 | 40 | A | 63 |

[Table 6]

| | Method of preparing planographic printing plate precursor | Organic-inorganic hybrid particles S of the present invention or comparative particles R | Borate compound | Polymerizable monomer | On-press developability (number of sheets of paper) | On-press developability (60°C, after 3 days) (number of sheets of paper) | Development scum | Printing durability (number of points) |
|---|---|---|---|---|---|---|---|---|
| Example 46 | A | S-2 | None | M-1 | 35 | 40 | A | 62 |
| Example 47 | A | S-10 | None | M-1 | 35 | 40 | A | 66 |
| Example 48 | A | S-16 | None | M-1 | 30 | 35 | A | 68 |
| Example 49 | A | S-31 | None | M-1 | 35 | 40 | A | 70 |
| Example 50 | A | S-32 | None | M-1 | 30 | 35 | A | 74 |
| Example 51 | A | S-34 | None | M-1 | 30 | 30 | A | 66 |
| Example 52 | A | S-40 | None | M-1 | 35 | 35 | A | 71 |
| Comparative Example 8 | A | R-1 | None | M-1 | 45 | 50 | A | 53 |
| Comparative Example 9 | A | R-2 | None | M-1 | 35 | 40 | A | 55 |

[Table 7]

| | Method of preparing planographic printing plate precursor | Organic-inorganic hybrid particles S of the present invention or comparative particles R | Borate compound | Polymerizable monomer | On-press developability (number of sheets of paper) | On-press developability (60°C, after 3 days) (number of sheets of paper) | Development scum | Printing durability (number of points) |
|---|---|---|---|---|---|---|---|---|
| Example 53 | B | S-12 | TPB | M-1 | 30 | 35 | A | 63 |
| Example 54 | B | S-13 | TPB | M-1 | 30 | 35 | A | 66 |
| Example 55 | B | S-16 | TPB | M-1 | 30 | 35 | A | 68 |
| Example 56 | B | S-17 | TPB | M-1 | 35 | 35 | A | 70 |
| Example 57 | B | S-17 | TPB | M-2 | 35 | 35 | A | 73 |
| Example 58 | B | S-17 | TPB | M-3 | 35 | 35 | A | 72 |
| Example 59 | B | S-17 | TPB | M-4 | 35 | 35 | A | 70 |
| Example 60 | B | S-19 | TPB | M-1 | 35 | 35 | A | 69 |
| Example 61 | B | S-21 | TPB | M-1 | 30 | 35 | A | 66 |
| Example 62 | B | S-22 | TPB | M-1 | 30 | 30 | A | 64 |
| Example 63 | B | S-29 | TPB | M-1 | 30 | 30 | A | 63 |
| Example 64 | B | S-32 | TPB | M-1 | 30 | 35 | A | 74 |
| Example 65 | B | S-33 | TPB | M-1 | 35 | 35 | A | 72 |
| Comparative Example 10 | B | R-1 | TPB | M-1 | 45 | 50 | A | 53 |
| Comparative Example 11 | B | R-2 | TPB | M-1 | 35 | 40 | A | 55 |
| Comparative Example 12 | B | R-3 | TPB | M-1 | 40 | 45 | A | 56 |
| Comparative Example 13 | B | R-4 | TPB | M-1 | 35 | 40 | A | 50 |

[Table 8]

| | Method of preparing planographic printing plate precursor | Organic-inorganic hybrid particles S of the present invention or comparative particles R | Borate compound | Polymerizable monomer | On-press developability (number of sheets of paper) | On-press developability (60°C, after 3 days) (number of sheets of paper) | Development scum | Printing durability (number of points) |
|---|---|---|---|---|---|---|---|---|
| Example 66 | B | S-12 | None | M-1 | 30 | 35 | A | 58 |
| Example 67 | B | S-13 | None | M-1 | 30 | 35 | A | 61 |
| Example 68 | B | S-16 | None | M-1 | 30 | 35 | A | 60 |
| Example 69 | B | S-17 | None | M-1 | 35 | 35 | A | 65 |
| Example 70 | B | S-17 | None | M-2 | 35 | 35 | A | 69 |
| Example 71 | B | S-17 | None | M-3 | 35 | 35 | A | 67 |
| Example 72 | B | S-17 | None | M-4 | 35 | 35 | A | 64 |
| Example 73 | B | S-19 | None | M-1 | 35 | 35 | A | 65 |
| Example 74 | B | S-21 | None | M-1 | 30 | 35 | A | 61 |
| Example 75 | B | S-22 | None | M-1 | 30 | 30 | A | 60 |
| Example 76 | B | S-29 | None | M-1 | 30 | 30 | A | 59 |
| Example 77 | B | S-32 | None | M-1 | 30 | 35 | A | 68 |
| Example 78 | B | S-33 | None | M-1 | 35 | 35 | A | 67 |
| Comparative Example 14 | B | R-1 | None | M-1 | 45 | 50 | A | 48 |
| Comparative Example 15 | B | R-2 | None | M-1 | 35 | 40 | A | 49 |
| Comparative Example 16 | B | R-3 | None | M-1 | 40 | 45 | A | 51 |
| Comparative Example 17 | B | R-4 | None | M-1 | 35 | 40 | A | 45 |

As shown from the results listed in tables, it was understood that both of printing durability and developability were able to be achieved at high levels without degrading the performance of development scum in a case of the planographic printing plate precursors of the examples, in which the image recording layers contained the organic-inorganic hybrid particles of the present invention, compared to Comparative Examples 1, 8, 10, and 14 in which organic-inorganic hybrid particles which did not contain urethane bonds or urea bonds were used and Comparative Examples 2 to 7, 9, 11 to 13, and 15 to 17 in which organic particles which did not contain inorganic particles were used.

According to the present invention, it is possible to provide a planographic printing plate precursor which is capable of achieving printing durability and developability at high levels; a method of preparing a planographic printing plate using the planographic printing plate precursor; and an organic-inorganic hybrid particle used for the planographic printing plate precursor and the method of preparing a planographic printing plate.

The present invention has been described in detail with reference to specific embodiments, but various changes or modifications can be made without departing from the spirit and the scope of the present invention and this is apparent to those skilled in the art.

The present application is based on Japanese Patent Application (JP2015-151209) filed on July 30, 2015 and the contents of which are incorporated herein by reference.

## Claims

**1.** A planographic printing plate precursor comprising:

a hydrophilic support; and
an image recording layer which contains an organic-inorganic hybrid particle (A) and an infrared-ray absorbent (B) on the hydrophilic support,
wherein the organic-inorganic hybrid particle (A) is an organic-inorganic hybrid particle in which an inorganic particle (a) containing a hydroxyl group and an organic component (b) are linked to each other through a linking group (c) having a urethane bond or a urea bond.

**2.** The planographic printing plate precursor according to claim 1,
wherein the organic-inorganic hybrid particle (A) is a particle in which the organic component (b) is linked to only one of the inorganic particle (a).

**3.** The planographic printing plate precursor according to claim 1,
wherein the organic-inorganic hybrid particle (A) is a particle in which the organic component (b) is linked to at least two of the inorganic particles (a) and the inorganic particle (a) is linked to at least two of the organic components (b) so that the organic components (b) and the inorganic particles (a) form a network structure.

**4.** The planographic printing plate precursor according to claim 3,
wherein the organic component (b) is a reaction product between polyfunctional isocyanate (d) and a compound having an active hydrogen atom (e).

**5.** The planographic printing plate precursor according to claim 4,
wherein the polyfunctional isocyanate (d) is formed from an adduct of polyfunctional isocyanate and a compound having at least two active hydrogen atoms.

**6.** The planographic printing plate precursor according to any one of claims 1 to 5,
wherein the organic component (b) has a repeating unit represented by the following Formula (1),

$$(1)\quad \left( X-R_1 \right)_{n_1}$$

wherein, in the Formula (1), X represents an oxygen atom, a sulfur atom, -CO-, or -COO-, $R_1$ represents alkylene having 2 to 10 carbon atoms, and $n_1$ represents an integer of 1 to 90.

**7.** The planographic printing plate precursor according to any one of claims 1 to 6,
wherein the organic-inorganic hybrid particle (A) contains a radical polymerizable group.

**8.** The planographic printing plate precursor according to any one of claims 1 to 7, wherein the inorganic particle (a) is at least one particle selected from the group consisting of silica, alumina, titania, zirconia, magnesium oxide, zinc oxide, talc, clay, wollastonite, xonotlite, aluminum hydroxide, and magnesium hydroxide.

**9.** The planographic printing plate precursor according to any one of claims 1 to 8, wherein a particle diameter of the inorganic particle (a) is in a range of 0.005 to 5 μm.

**10.** The planographic printing plate precursor according to any one of claims 1 to 9, wherein a particle diameter of the organic-inorganic hybrid particle (A) is in a range of 0.01 to 20 μm.

**11.** The planographic printing plate precursor according to any one of claims 1 to 10, wherein the image recording layer further contains a radical polymerizable compound (C) and a radical polymerization initiator (D).

**12.** The planographic printing plate precursor according to any one of claims 1 to 11, wherein an unexposed portion in the image recording layer is removed by a developer having a pH of 2 to 12 after exposure.

**13.** The planographic printing plate precursor according to any one of claims 1 to 11, wherein an unexposed portion in the image recording layer is removed by at least one of printing ink or dampening water on a printing press after exposure.

**14.** A method of preparing a planographic printing plate, comprising:

exposing the planographic printing plate precursor according to any one of claims 1 to 12; and
removing an unexposed portion using a developer having a pH of 2 to 12.

**15.** A method of preparing a planographic printing plate, comprising:

exposing the planographic printing plate precursor according to any one of claims 1 to 11 and 13; and
removing an unexposed portion using at least one of printing ink or dampening water on a printing press.

**16.** An organic-inorganic hybrid particle comprising:

an inorganic particle (a) containing a hydroxyl group and an organic component (b) which are linked to each other through a linking group (c) having a urethane bond or a urea bond,
wherein the organic component (b) is linked to at least two of the inorganic particles (a) and the inorganic particle (a) is linked to at least two of the organic components (b) so that the organic components and the inorganic particles form a network structure.

**17.** The organic-inorganic hybrid particle according to claim 16, wherein the organic component (b) is a reaction product between polyfunctional isocyanate (d) and a compound having an active hydrogen atom (e).

**18.** The organic-inorganic hybrid particle according to claim 16 or 17, wherein the organic component has a repeating unit represented by the following Formula (1),

$$(1)\quad \left( X - R_1 \right)_{n_1}$$

wherein, in the Formula (1), X represents an oxygen atom, a sulfur atom, -CO-, or -COO-, $R_1$ represents alkylene having 2 to 10 carbon atoms, and $n_1$ represents an integer of 1 to 90.

**19.** The organic-inorganic hybrid particle according to any one of claims 16 to 18, further comprising:

a radical polymerizable group.

**20.** The organic-inorganic hybrid particle according to any one of claims 16 to 19, wherein a particle diameter of the organic-inorganic hybrid particle is in a range of 0.01 to 20 $\mu$m.

## INTERNATIONAL SEARCH REPORT

International application No. PCT/JP2016/071067

A. CLASSIFICATION OF SUBJECT MATTER
*B41N1/14*(2006.01)i, *C08K9/04*(2006.01)i, *C08L55/00*(2006.01)i, *G03F7/00*(2006.01)i, *G03F7/004*(2006.01)i, *G03F7/028*(2006.01)i, *G03F7/035*(2006.01)i, *G03F7/32*(2006.01)i

According to International Patent Classification (IPC) or to both national classification and IPC

B. FIELDS SEARCHED

Minimum documentation searched (classification system followed by classification symbols)
B41N1/14, C08K9/04, C08L55/00, G03F7/00, G03F7/004, G03F7/028, G03F7/035, G03F7/32

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2006-317716 A (Eastman Kodak Co.), 24 November 2006 (24.11.2006), entire text; all drawings & US 2009/0092923 A1 entire text; all drawings & WO 2006/121172 A1 & EP 1880978 A1 | 1-20 |
| A | JP 2010-102322 A (Fujifilm Corp.), 06 May 2010 (06.05.2010), entire text & EP 2168766 A1 entire text | 1-20 |
| A | JP 2008-230208 A (Fujifilm Corp.), 02 October 2008 (02.10.2008), entire text (Family: none) | 1-20 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 September 2016 (21.09.16) | 04 October 2016 (04.10.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/071067

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-276768 A (Kodak Polychrome Graphics Japan Ltd.),<br>12 October 2006 (12.10.2006),<br>entire text<br>& US 2008/0280228 A1<br>entire text<br>& WO 2006/109454 A1 & EP 1865378 A1 | 1-20 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010102322 A
- JP 2012206495 A
- JP 6297856 A
- JP H06297856 A
- JP 2001133969 A
- JP 2002023360 A
- JP 2002040638 A
- JP 2002278057 A
- JP 2008195018 A
- JP 2007090850 A
- JP 5005005 A
- JP H055005 A
- JP 2001222101 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S4841708 B
- JP 51037193 A
- JP S5137193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP S6239418 B
- JP 2000250211 A
- JP 2007094138 A
- US 7153632 B
- JP 8505958 A
- JP H08505958 A
- JP 2007293221 A
- JP 2007293223 A
- EP 24629 B
- EP 107792 B
- US 4410621 A
- JP 5158230 A
- JP H05158230 A
- US 4069055 A
- JP 4365049 A
- JP H04365049 A
- US 4069056 A
- EP 104143 B
- US 20080311520 A
- JP 2150848 A
- JP H02150848 A
- EP 370693 B
- EP 233567 B
- EP 297443 B
- EP 297442 B
- US 4933377 A
- US 4760013 A
- US 4734444 A
- US 2833827 A
- GE 2904626 B
- GE 3604580 B
- GE 3604581 B
- JP 2007206217 A
- JP 2007187836 A
- JP 2008276155 A
- JP 2005250438 A
- JP 2005250158 A
- JP 2001075279 A
- JP 2007276454 A
- JP 2009154525 A
- JP 2006297907 A
- JP 2007050660 A
- JP 2008284858 A
- JP 2009090645 A
- JP 2009208458 A
- JP 9123387 A
- JP H09123387 A
- JP 9131850 A
- JP H09131850 A
- JP 9171249 A
- JP H09171249 A

- JP 9171250 A
- JP H09171250 A
- EP 931647 B
- JP 2001277740 A
- JP 2001277742 A
- JP 62143044 A
- JP S62143044 A
- JP 62150242 A
- JP S62150242 A
- JP 9188685 A
- JP H09188685 A
- JP 9188686 A
- JP H09188686 A
- JP 9188710 A
- JP H09188710 A
- JP 2000131837 A
- JP 2002107916 A
- JP 2764769 B
- JP 2002116539 A
- JP 2005509192 A
- JP 2004310000 A
- JP 10282679 A
- JP H10282679 A
- JP 2304441 A
- JP H02304441 A
- JP 2005250216 A
- JP 2006259137 A
- JP 2005119273 A
- JP 5045885 A
- JP H0545885 A
- JP 6035174 A
- JP H0635174 A
- JP 2008203359 A
- JP 2008276166 A
- JP 2009047927 A
- JP 2015151209 A

**Non-patent literature cited in the description**


- **ICHIRO NISHI et al.** Surfactant Handbook. Sangyo Tosho Publishing Co., Ltd, 1980
- **ASAJI KONDO.** Microcapsules. NIKKAN KOGYO SHIMBUN, LTD, 1970
- **TAMOTSU KONDO et al.** Microcapsules. SANKYO SHUPPAN Co., Ltd, 1977
- Polyurethane Resin Handbook. NIKKAN KOGYO SHIMBUN, LTD, 1987
- Dye Handbook. 1970
- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478
- **KUNZ ; MARTIN.** *Rad Tech' 98. Proceeding April 19 to 22, 1998,* 19 April 1998
- Polymer Dictionary. 2005, 683, , 684